(19) Europäisches Patentamt
European Patent Office
Office européen des brevets

(11) EP 3 005 433 B1

(12) **EUROPÄISCHE PATENTSCHRIFT**

(45) Veröffentlichungstag und Bekanntmachung des Hinweises auf die Patenterteilung:
**22.02.2023 Patentblatt 2023/08**

(21) Anmeldenummer: **14711447.4**

(22) Anmeldetag: **18.03.2014**

(51) Internationale Patentklassifikation (IPC):
***H01L 51/52*** *(2006.01)* ***H01L 51/54*** *(2006.01)*
***C09K 11/06*** *(2006.01)*

(52) Gemeinsame Patentklassifikation (CPC):
**H01L 51/0072; C09K 11/02; C09K 11/06; H01L 51/0064; H01L 51/5012;** C09K 2211/1011; C09K 2211/1029; C09K 2211/1044; H01L 2251/552

(86) Internationale Anmeldenummer:
**PCT/EP2014/000740**

(87) Internationale Veröffentlichungsnummer:
**WO 2014/194971 (11.12.2014 Gazette 2014/50)**

(54) **ORGANISCHE ELEKTROLUMINESZENZVORRICHTUNG**
ORGANIC ELECTROLUMINESCENT DEVICE
DISPOSITIF ORGANIQUE ÉLÉCTROLUMINESCENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.06.2013 EP 13002927**

(43) Veröffentlichungstag der Anmeldung:
**13.04.2016 Patentblatt 2016/15**

(73) Patentinhaber: **Merck Patent GmbH**
**64293 Darmstadt (DE)**

(72) Erfinder:
- **STOESSEL, Philipp**
  **60487 Frankfurt am Main (DE)**
- **PARHAM, Amir Hossain**
  **60486 Frankfurt am Main (DE)**
- **PFLUMM, Christof**
  **64291 Darmstadt (DE)**
- **JATSCH, Anja**
  **60489 Frankfurt am Main (DE)**
- **KAISER, Joachim**
  **64289 Darmstadt (DE)**

(56) Entgegenhaltungen:
**EP-A1- 2 511 360** **EP-A1- 2 808 323**
**EP-A1- 2 851 408** **EP-B1- 2 984 151**
**WO-A1-2014/166584** **DE-A1-102010 025 547**

- **JOSEPH C. DEATON ET AL: "E-Type Delayed Fluorescence of a Phosphine-Supported Cu 2 ([mu]-NAr 2 ) 2 Diamond Core: Harvesting Singlet and Triplet Excitons in OLEDs ||", JOURNAL OF THE AMERICAN CHEMICAL SOCIETY, Bd. 132, Nr. 27, 17. Juni 2010 (2010-06-17), Seiten 9499-9508, XP055031756, ISSN: 0002-7863, DOI: 10.1021/ja1004575**
- **QISHENG ZHANG ET AL: "Design of Efficient Thermally Activated Delayed Fluorescence Materials for Pure Blue Organic Light Emitting Diodes", JOURNAL OF THE AMERICAN CHEMICAL SOCIETY, Bd. 134, Nr. 36, 12. September 2012 (2012-09-12), Seiten 14706-14709, XP055122849, ISSN: 0002-7863, DOI: 10.1021/ja306538w & Qisheng Zhang ET AL: "Supporting Information: Design of Efficient Thermally Activated Delayed Fluorescence Materials for Pure Blue Organic Light Emitting Diodes", Journal of the American Chemical Society, 29. August 2012 (2012-08-29), Seiten 1-21, XP055122850, DOI: http://pubs.acs.org/doi/suppl/10.1021/ja306538w/suppl_file/ja306538w_si_001.pdf Gefunden im Internet: URL:http://pubs.acs.org/doi/suppl/10.1021/ja306538w/suppl_file/ja306538w_si_001.pdf [gefunden am 2014-06-11]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- HIROKI UOYAMA ET AL: "Highly efficient organic light-emitting diodes from delayed fluorescence", NATURE, Bd. 492, Nr. 7428, 12. Dezember 2012 (2012-12-12), Seiten 234-238, XP55048388, ISSN: 0028-0836, DOI: 10.1038/nature11687 in der Anmeldung erwähnt

## Beschreibung

Die vorliegende Erfindung betrifft organische Elektrolumineszenzvorrichtungen, welche in der emittierenden Schicht eine Mischung aus einem lumineszenten Material mit einem geringen Singulett-Triplett-Abstand und einem Matrixmaterial enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei insbesondere auch metallorganische Iridium- und Platinkomplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich.

Trotz der guten Ergebnisse, die mit metallorganischen Iridum- und Platinkomplexen erzielt werden, weisen diese jedoch auch eine Reihe von Nachteilen auf: So handelt es sich bei Iridium und Platin um seltene und teure Metalle. Es wäre daher zur Ressourcenschonung wünschenswert, die Verwendung dieser Metalle vermeiden zu können. Weiterhin weisen derartige Metallkomplexe teilweise eine geringere thermische Stabilität auf als rein organische Verbindungen bzw. sind aufgrund des hohen Molekulargewichts nur eingeschränkt sublimierbar, so dass auch aus diesem Grund die Verwendung rein organischer Verbindungen vorteilhaft wäre, sofern diese zu vergleichbar guten Effizienzen führen. Weiterhin sind blau, insbesondere tiefblau phosphoreszierende Iridium- bzw. Platinemitter mit hoher Effizienz und Lebensdauer technisch nur schwierig zu verwirklichen, so dass es auch hier Verbesserungsbedarf gibt. Weiterhin gibt es insbesondere bei der Lebensdauer phosphoreszierender OLEDs, welche Ir- oder Pt-Emitter enthalten, Verbesserungsbedarf, wenn es beim Betreiben der OLED zu höheren Temperaturen kommt, wie dies bei einigen Anwendungen der Fall ist.

Eine alternative Entwicklung ist die Verwendung von Emittern, die thermisch aktivierte verzögerte Fluoreszenz (thermally activated delayed fluorescence, TADF) zeigen (z. B. H. Uoyama et al., Nature 2012, Vol. 492, 234). Hier handelt es sich um organische Materialien, bei denen der energetische Abstand zwischen dem niedrigsten Triplettzustand $T_1$ und dem ersten angeregten Singulettzustand $S_1$ so klein ist, dass dieser Energieabstand kleiner oder im Bereich der thermischen Energie liegt. Aus quantenstatistischen Gründen entstehen bei elektronischer Anregung in der OLED die angeregten Zustände zu 75 % im Triplettzustand und zu 25 % im Singulettzustand. Da rein organische Moleküle üblicherweise nicht aus dem Triplettzustand emittieren können, können 75 % der angeregten Zustände nicht für die Emission genutzt werden, wodurch prinzipiell nur 25 % der Anregungsenergie in Licht umgewandelt werden können. Ist nun jedoch der energetische Abstand zwischen dem niedrigsten Triplettzustand und dem niedrigsten angeregten Singulettzustand nicht oder nicht wesentlich größer als die thermische Energie, die durch kT beschrieben wird, so ist aus dem Triplettzustand durch thermische Anregung der erste angeregte Singulettzustand des Moleküls zugänglich und kann thermisch besetzt werden. Da dieser Singulettzustand ein emissiver Zustand ist, aus dem Fluoreszenz möglich ist, kann dieser Zustand zur Erzeugung von Licht verwendet werden. Somit ist prinzipiell die Umwandlung von bis zu 100 % der elektrischen Energie in Licht bei der Verwendung rein organischer Materialien als Emitter möglich. So wird im Stand der Technik eine externe Quanteneffizienz von mehr als 19 % beschrieben, was in derselben Größenordnung wie für phosphoreszierende OLEDs liegt. Somit ist es mit derartigen rein organischen Materialien möglich, sehr gute Effizienzen zu erreichen und gleichzeitig die Verwendung seltener Metalle wie Iridium oder Platin zu vermeiden. Weiterhin ist es mit solchen Materialien prinzipiell auch möglich, hocheffiziente blau emittierende OLEDs zu erzielen

Im Stand der Technik wird die Verwendung verschiedener Matrixmaterialien in Verbindung mit Emittern, die thermisch aktivierte verzögerte Fluoreszenz zeigen (im Folgenden TADF-Verbindung genannt), beschrieben, beispielsweise Carbazolderivate (EP2511360, H. Uoyama et al., Nature 2012, 492, 234; Endo et al., Appl. Phys. Lett. 2011, 98, 083302; Nakagawa et al. Chem. Commun. 2012, 48, 9580; Lee et al. Appl. Phys. Lett. 2012, 101, 093306/1), Phosphinoxid-Dibenzothiophenderivate (H. Uoyama et al., Nature 2012, 492, 234) oder Silanderivate (Mehes et al., Angew. Chem. Int. Ed. 2012, 51, 11311; Lee et al., Appl. Phys. Lett. 2012, 101, 093306/1).

Den im Stand der Technik beschriebenen Elektrolumineszenzvorrichtungen ist gemeinsam, dass die TADF-Verbindung in der emittierenden Schicht in geringen Dotierkonzentrationen von ca. 5-6 Gew.-% eingesetzt wird. Dies entspricht näherungsweise der Konzentration in Vol.-%.

Generell gibt es bei organischen Elektrolumineszenzvorrichtungen, die Emission nach dem TADF-Mechanismus zeigen, noch weiteren Verbesserungsbedarf, insbesondere im Hinblick auf Lebensdauer, Effizienz, Spannung und/oder Roll-off-Verhalten. Die der vorliegenden Erfindung zugrunde liegende technische Aufgabe ist somit die Bereitstellung von OLEDs, deren Emission auf TADF basiert und die verbesserte Eigenschaften aufweisen, insbesondere in Bezug auf eine oder mehrere der oben genannten Eigenschaften.

Überraschend wurde gefunden, dass organische Elektrolumineszenzvorrichtungen, die in der emittierenden Schicht eine organische TADF-Verbindung und ein Matrixmaterial aufweisen, wobei die TADF-Verbindung in einer Dotierkonzentration gemäß der Ansprüche eingesetzt wird, diese Aufgabe lösen und zu Verbesserungen der organischen Elektrolumineszenzvorrichtung führen im Vergleich zu Elektrolumineszenzvorrichtungen, die ansonsten denselben Aufbau aufweisen, aber dieselbe TADF-Verbindung in einer geringeren Konzentration enthalten. Derartige organische Elektrolumineszenzvorrichtungen sind daher der Gegenstand der vorliegenden Erfindung.

Gegenstand der vorliegenden Erfindung ist eine organische Elektrolumineszenzvorrichtung, enthaltend Kathode, Anode und eine emittierende Schicht, die die folgenden Verbindungen enthält:

(A) eine Matrixverbindung; und
(B) eine lumineszente organische Verbindung, die einen Abstand zwischen dem niedrigsten Triplettzustand $T_1$ und dem ersten angeregten Singulettzustand $S_1$ von $\leq$ 0.15 eV aufweist (TADF-Verbindung),

dadurch gekennzeichnet, dass die TADF-Verbindung in einer Dotierkonzentration von 10 bis 15 Vol.-% in der emittierenden Schicht vorliegt und, dass die Matrixverbindung eine elektronentransportierende Verbindung ausgewählt aus den Stoffklassen der Triazine, der Pyrimidine, der Lactame, und der Chinoxaline ist;

wobei eine Dotierkonzentration der TADF-Verbindung von 10 Vol.-% in der emittierenden Schicht ausgeschlossen ist.

Eine Matrixverbindung im Sinne der vorliegenden Erfindung ist jede Verbindung, die in der emittierenden Schicht vorliegt und die keine TADF-Verbindung ist.

Im Folgenden wird die lumineszente organische Verbindung, die einen Abstand zwischen dem niedrigsten Triplettzustand $T_1$ und dem ersten angeregten Singulettzustand $S_1$ von $\leq$ 0.15 eV aufweist, näher beschrieben. Hierbei handelt es sich um eine Verbindung, die TADF (thermally activated delayed fluorescence) zeigt. Diese Verbindung wird in der folgenden Beschreibung mit "TADF-Verbindung" abgekürzt.

Eine organische Verbindung im Sinne der vorliegenden Erfindung ist eine kohlenstoffhaltige Verbindung, die keine Metalle enthält. Insbesondere ist die organische Verbindung aus den Elementen C, H, D, B, Si, N, P, O, S, F, Cl, Br und I aufgebaut.

Eine lumineszente Verbindung im Sinne der vorliegenden Erfindung ist eine Verbindung, die in der Lage ist, unter optischer Anregung in einer Umgebung, wie sie in der organischen Elektrolumineszenzvorrichtung vorliegt, bei Raumtemperatur Licht zu emittieren. Dabei weist die Verbindung bevorzugt eine Lumineszenzquanteneffizienz von mindestens 40 % auf, besonders bevorzugt von mindestens 50 %, ganz besonders bevorzugt von mindestens 60 % und insbesondere bevorzugt von mindestens 70 %. Dabei wird die Lumineszenzquanteneffizienz bestimmt in einer Schicht in Mischung mit dem Matrixmaterial, wie sie in der organischen Elektrolumineszenzvorrichtung verwendet werden soll. Wie die Bestimmung der Lumineszenzquantenausbeute im Sinne der vorliegenden Erfindung durchgeführt wird, ist im Beispielteil ausführlich allgemein beschrieben.

Weiterhin ist es bevorzugt, wenn die TADF-Verbindung eine kurze Abklingzeit aufweist. Dabei ist die Abklingzeit bevorzugt $\leq$ 50 $\mu$s. Wie die Bestimmung der Abklingzeit im Sinne der vorliegenden Erfindung durchgeführt wird, ist im Beispielteil ausführlich allgemein beschrieben.

Die Energie des niedrigsten angeregten Singulettzustands ($S_1$) und des niedrigsten Triplettzustands ($T_1$) werden durch quantenchemische Rechnung bestimmt. Wie diese Bestimmung im Sinne der vorliegenden Erfindung durchgeführt wird, ist im Beispielteil ausführlich allgemein beschrieben.

Wie oben beschrieben, darf der Abstand zwischen $S_1$ und $T_1$ maximal 0.15 eV betragen, damit es sich bei der Verbindung um eine TADF-Verbindung im Sinne der vorliegenden Erfindung handelt, wobei es umso besser ist, je kleiner der Abstand ist. Bevorzugt ist der Abstand zwischen $S_1$ und $T_1 \leq$ 0.10 eV, besonders bevorzugt $\leq$ 0.08 eV, ganz besonders bevorzugt $\leq$ 0.05 eV.

Bei der TADF-Verbindung handelt es sich bevorzugt um eine aromatische Verbindung, die sowohl Donor- wie auch Akzeptorsubstituenten aufweist, wobei das LUMO und das HOMO der Verbindung räumlich nur schwach überlappen. Was unter Donor- bzw. Akzeptorsubstituenten verstanden wird, ist dem Fachmann prinzipiell bekannt. Geeignete Donorsubstituenten sind insbesondere Diaryl- bzw. -heteroarylaminogruppen sowie Carbazolgruppen bzw. Carbazolderivate, die jeweils bevorzugt über N an die aromatische Verbindung gebunden sind. Dabei können diese Gruppen auch weiter substituiert sein. Geeignete Akzeptorsubstituenten sind insbesondere Cyanogruppen, aber auch beispielsweise elektronenarme Heteroarylgruppen, die auch weiter substituiert sein können.

Um Exziplexbildung in der emittierenden Schicht zu vermeiden, ist es bevorzugt, wenn für LUMO(TADF), also das LUMO der TADF-Verbindung, und das HOMO(Matrix), also das HOMO der Matrixverbindung, gilt:

$$\text{LUMO(TADF)} - \text{HOMO(Matrix)} > S_1\text{(TADF)} - 0.4\ \text{eV};$$

besonders bevorzugt:

$$LUMO(TADF) - HOMO(Matrix) > S_1(TADF) - 0.3\ eV;$$

und ganz besonders bevorzugt:

$$LUMO(TADF) - HOMO(Matrix) > S_1(TADF) - 0.2\ eV.$$

Dabei ist $S_1$(TADF) der erste angeregte Singulettzustand $S_1$ der TADF-Verbindung.

Beispiele für geeignete Moleküle, die TADF zeigen, sind die in der folgenden Tabelle aufgeführten Strukturen.

| | | |
|---|---|---|
| 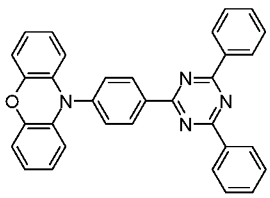 | 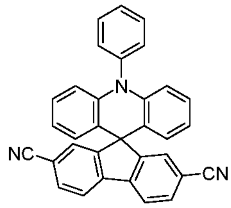 | 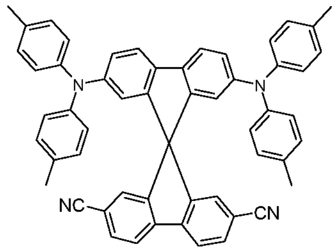 |
| 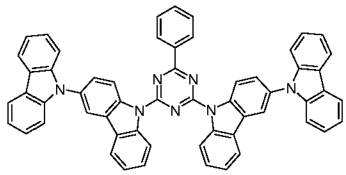 | 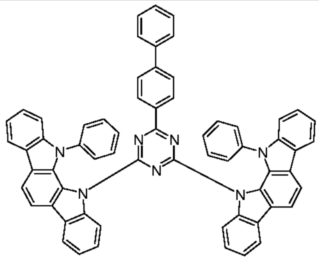 | 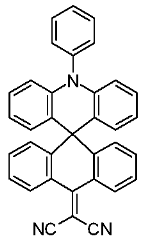 |
| 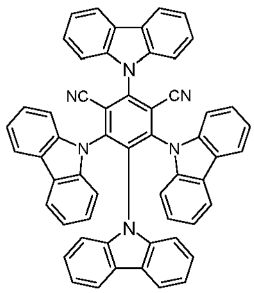 | 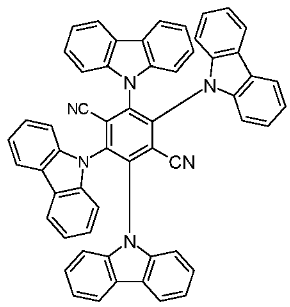 | 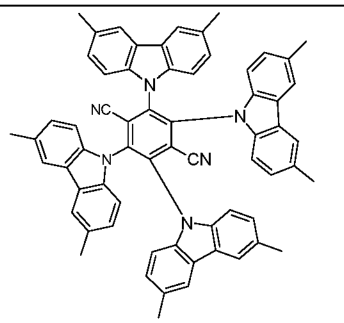 |

| | | |
|---|---|---|
| 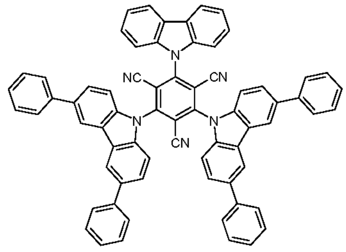 | 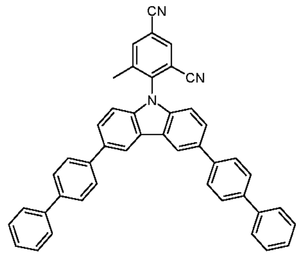 | 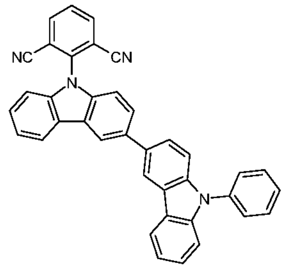 |
| 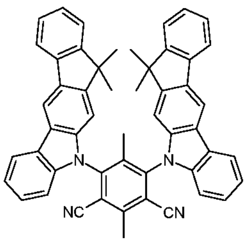 | 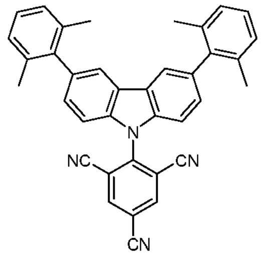 | 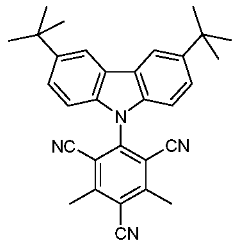 |
| 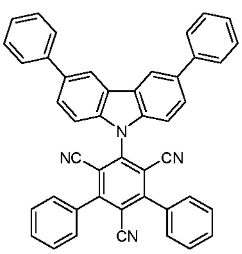 | 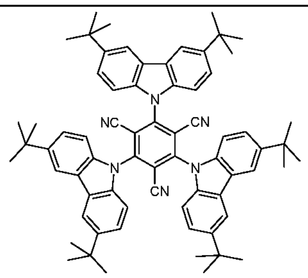 | 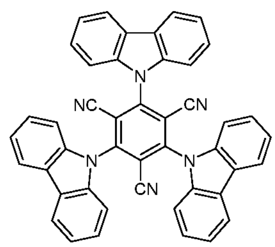 |

Erfindungsgemäß liegt die TADF-Verbindung in einer Dotierkonzentration von 10 bis 15 Vol.-%, wobei eine Dotierkonzentration der TADF-Verbindung von 10 Vol.-% in der emittierenden Schicht ausgeschlossen ist.

Entsprechend beträgt der Anteil der Matrixverbindung bevorzugt 80 bis 93 Vol.-%, besonders bevorzugt 82 bis 91 Vol.-% und ganz besonders bevorzugt 85 bis 90 Vol.-%.

In einer bevorzuaten Ausführunasform der Erfinduna träot die Matrixverbindung nicht oder nicht wesentlich zur Emission der Mischung bei, und die TADF-Verbindung ist die emittierende Verbindung, d. h. die Verbindung, deren Emission aus der emittierenden Schicht beobachtet wird.

In einer bevorzuaten Ausführunasform der Erfinduna besteht die emittierende Schicht nur aus genau einer Matrixverbindung und der TADF-Verbindung.

Damit die TADF-Verbindung die emittierende Verbindung in der Mischung der emittierenden Schicht ist, ist es bevorzugt, dass die niedrigste Triplettenergie der Matrixverbindung maximal 0.1 eV niedriger ist als die Triplettenergie der TADF-Verbindung. Insbesondere bevozugt ist $T_1$(Matrix) $\geq$ $T_1$(TADF).

Besonders bevorzugt gilt: $T_1$(Matrix) - $T_1$(TADF) $\geq$ 0.1 eV;
ganz besonders bevorzugt: $T_1$(Matrix) - $T_1$(TADF) $\geq$ 0.2 eV.

Dabei steht $T_1$(Matrix) für die niedrigste Triplettenergie der Matrixverbindung und $T_1$(TADF) für die niedrigste Triplettenergie der TADF-Verbindung. Dabei wird die Triplettenergie der Matrixverbindung $T_1$(Matrix) durch quantenchemische Rechnung bestimmt, wie hinten im Beispielteil allgemein beschrieben.

Beispiele für Matrixverbindungen, die in einer emittierenden Schicht verwendet werden können, sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Pyrimidinderivate, Chinoxalinderivate, Zn-, Al- oder Be-Komplexe, z. B. gemäß EP 652273 oder WO 2009/062578, oder verbrückte Carbazolderivate, z. B. gemäß US 2009/0136779, WO 2010/050778,

WO 2011/042107 oder WO 2011/088877.

Bevorzugt weist die Matrixverbindung eine Glasübergangstemperatur Tc von größer als 70 °C auf, besonders bevorzugt größer als 90 °C, ganz besonders bevorzugt größer als 110 °C.

Matrixverbindungen können ladungstransportierende, also elektronentransportierende oder lochtransportierende oder bipolare Verbindungen sein. Als Matrixverbindungen können weiterhin auch Verbindungen dienen, die weder loch- noch elektronentransportierend im Sinne der vorliegenden Anmeldung sind. Eine erfindungsgemäße Matrixverbindung transportiert Elektronen.

Eine elektronentransportierende Verbindung im Sinne der vorliegenden Erfindung ist eine Verbindung, die ein LUMO $\leq$ -2.50 eV aufweist. Bevorzugt ist das LUMO $\leq$ -2.60 eV, besonders bevorzugt $\leq$ -2.65 eV, ganz besonders bevorzugt $\leq$ -2.70 eV. Dabei ist das LUMO das niedrigste unbesetzte Molekülorbital (lowest unoccupied molecular orbital). Der Wert des LUMO der Verbindung wird durch quantenchemische Rechnung bestimmt, wie hinten im Beispielteil allgemein beschrieben.

Eine lochtransportierende Verbindung ist eine Verbindung, die ein HOMO $\geq$ -5.5 eV aufweist. Bevorzugt ist das HOMO $\geq$ -5.4 eV, besonders bevorzugt $\geq$ -5.3 eV. Dabei ist das HOMO das höchste besetzte Molekülorbital (highest occupied molecular orbital). Der Wert des HOMO der Verbindung wird durch quantenchemische Rechnung bestimmt, wie hinten im Beispielteil allgemein beschrieben.

Eine bipolare Verbindung ist eine Verbindung, die sowohl loch- wie auch elektronentransportierend ist.

Im Folgenden werden Verbindungsklassen beschrieben, die sich bevorzugt als elektronenleitende Matrixverbindung in organischen Elektrolumineszenzvorrichtung eignen.

Elektronenleitende Matrixverbindungen sind ausgewählt aus den Stoffklassen der Triazine, der Pyrimidine, der Lactame, der Metallkomplexe, insbesondere der Be-, Zn- bzw. Al-Komplexe, der aromatischen Ketone, der aromatischen Phosphinoxide, der Azaphosphole, derAzaborole. welche mit mindestens einem elektronenleitenden Substituenten substituiert sind, und der Chinoxaline.

Erfindungsgemäß enthält die emittierende Schicht eine Matrixverbindung, die eine elektronentransportierende Verbindung ausgewählt aus den Stoffklassen der Triazine, der Pyrimidine, der Lactame, und der Chinoxaline ist

Wenn die erfindungsgemäße elektronenleitende Verbindung eine Triazin- oder Pyrimidinverbindung ist, dann ist diese Verbindung bevorzugt ausgewählt aus den Verbindungen der folgenden Formeln (1) bzw. (2),

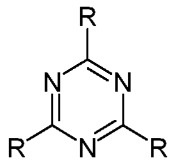

Formel (1)

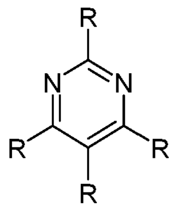

Formel (2)

wobei für die verwendeten Symbole gilt:

R ist bei jedem Auftreten gleich oder verschieden ausgewählt aus der Gruppe bestehend aus H, D, F, Cl, Br, I, CN, $NO_2$, $N(Ar)_2$, $N(R^1)_2$, C(=O)Ar, C(=O)$R^1$, P(=O)$(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, C≡C, $Si(R^1)_2$, C=O, C=S, C=N$R^1$, P(=O)($R^1$), SO, $SO_2$, N$R^1$, O, S oder CON$R^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, C(=O)$R^2$, P(=O)$(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, $C\equiv C$, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;

Ar ist bei jedem Auftreten gleich oder verschieden ein aromatisches oder heteroaromatisches Ringsystem mit 5-60 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;

$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können.

Benachbarte Substituenten im Sinne der vorliegenden Anmeldung sind Substituenten, die entweder an dasselbe Kohlenstoffatom gebunden sind oder die an Kohlenstoffatome gebunden sind, die wiederum direkt aneinander gebunden sind.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder $CH_2$-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nicht-benachbarte $CH_2$-Gruppen durch die oben genannten Gruppen ersetzt sein können; weiterhin können auch ein oder mehrere H-Atome durch D, F, Cl, Br, I, CN oder $NO_2$, bevorzugt F, Cl oder CN, weiter bevorzugt F oder CN, besonders bevorzugt CN ersetzt sein.

Unter einem aromatischen oder heteroaromatischen Ringsystem mit 5 - 30 bzw. 5 - 60 aromatischen Ringatomen, welches noch jeweils mit den oben genannten Resten R, $R^1$ oder $R^2$ substituiert sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombination dieser Systeme.

In einer bevorzugten Ausführungsform der Verbindungen gemäß Formel (1) bzw. Formel (2) steht mindestens einer der Substituenten R für ein aromatisches oder heteroaromatisches Ringsystem. In Formel (1) stehen besonders bevorzugt alle drei Substituenten R für ein aromatisches oder heteroaromatisches Ringsystem, das jeweils durch einen oder mehrere Reste $R^1$ substituiert sein kann. In Formel (2) stehen besonders bevorzugt ein, zwei oder drei Substituenten R für ein aromatisches oder heteroaromatisches Ringsystem, das jeweils durch einen oder mehrere Reste $R^1$ substituiert sein kann, und die anderen Substituenten R stehen für H. Erfindungsgemäße bevorzugte Ausführungsformen sind somit die Verbindungen der folgenden Formeln (1a) bzw. (2a) bis (2d),

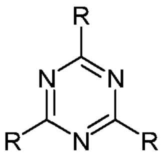
Formel (1a)

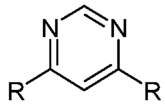
Formel (2a)

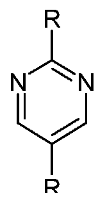
Formel (2b)

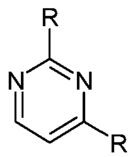
Formel (2c)

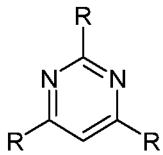
Formel (2d)

wobei R gleich oder verschieden für ein aromatisches oder heteroaromatisches Ringsystem mit 5 bis 60 aromatischen Ringatomen steht, das jeweils mit einem oder mehreren Resten $R^1$ substituiert sein kann, und $R^1$ die oben genannte Bedeutung aufweist.

Dabei sind bei den Pyrimidinverbindungen die Verbindungen der Formeln (2a) und (2d) bevorzugt, insbesondere Verbindungen der Formel (2d). Bevorzugte aromatische oder heteroaromatische Ringsysteme enthalten 5 bis 30 aromatische Ringatome, insbesondere 6 bis 24 aromatische Ringatome, und können durch einen oder mehrere Reste $R^1$ substituiert sein. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Diese Bevorzugung ist mit der höheren Triplettenergie derartiger Substituenten zu begründen. So ist es besonders bevorzugt, wenn R beispielsweise keine Naphthylgruppen oder höhere kondensierte Arylgruppen aufweist und ebenso keine Chinolingruppen, Acridingruppen, etc.. Dagegen ist es möglich, dass R beispielsweise Carbazolgruppen, Dibenzofurangruppen, Fluorengruppen, etc. aufweist, weil in diesen Strukturen keine 6-Ring-Aromaten bzw. -Heteroaromaten direkt aneinander ankondensiert sind.

Bevorzugte Substituenten R sind gleich oder verschieden bei jedem Auftreten ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzothiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren oder Kombinationen aus zwei oder drei dieser Gruppen, welche jeweils mit einem oder mehreren

Resten $R^1$ substituiert sein können. Dabei können in den oben genannten aromatischen Ringsystemen auch ein oder mehrere C-Atome durch N ersetzt sein.

Bevorzugte Biphenyl-, Terphenyl- und Quaterphenylgruppen sind die Gruppen der folgenden Formeln (Bi-1) bis (Bi-3), (Ter-1) bis (Ter-3) und (Quater-1) bis (Quater-4),

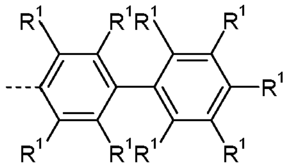
Bi-1

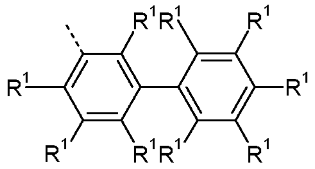
Bi-2

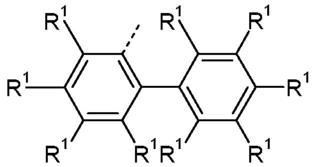
Bi-3

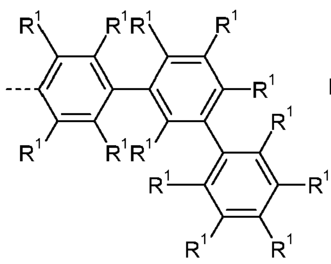
Ter-1

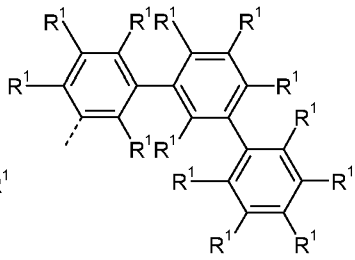
Ter-2

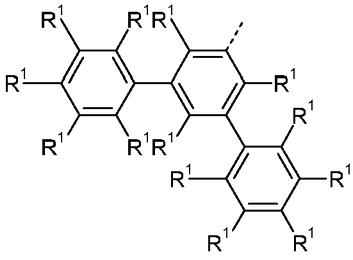
Ter-3

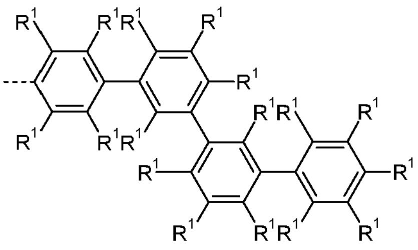
Quater-1

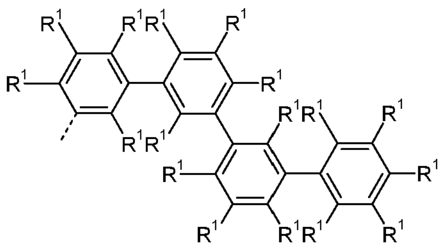
Quater-2

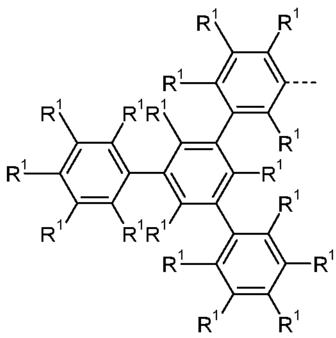
Quater-3

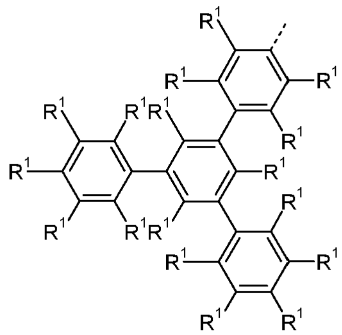
Quater-4

wobei $R^1$ die oben genannten Bedeutungen aufweist und die gestrichelte Bindung die Bindung an das Triazin bzw. Pyrimidin andeutet.

Insbesondere bevorzugt ist es, wenn mindestens eine Gruppe R ausgewählt ist aus den Strukturen der folgenden Formeln (3) bis (44),

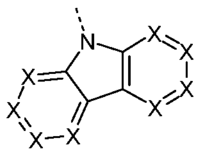
Formel (3)

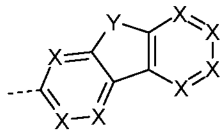
Formel (4)

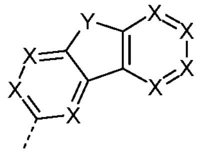
Formel (5)

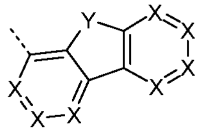
Formel (6)

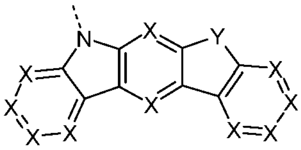
Formel (7)

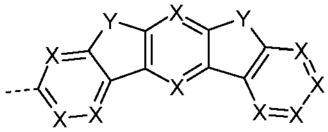
Formel (8)

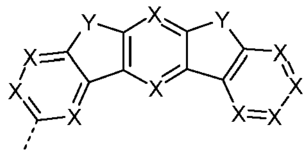
Formel (9)

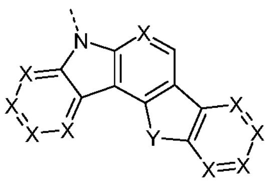
Formel (10)

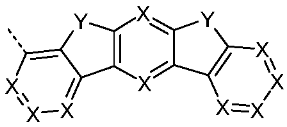
Formel (11)

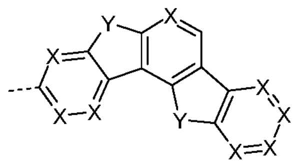
Formel (12)

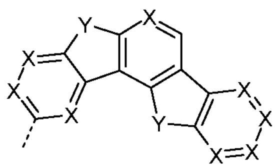
Formel (13)

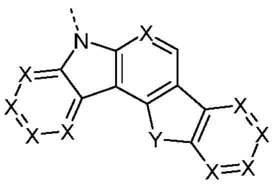
Formel (14)

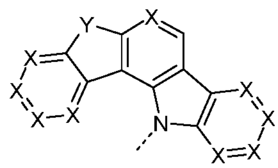
Formel (15)

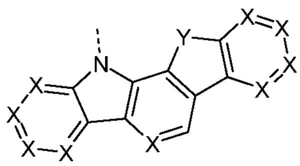
Formel (16)

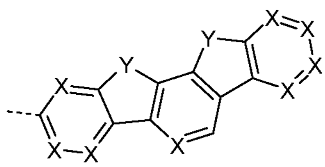
Formel (17)

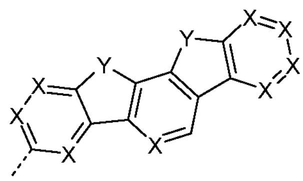
Formel (18)

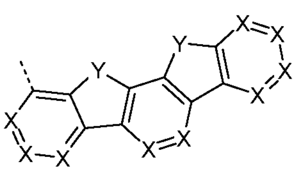
Formel (19)

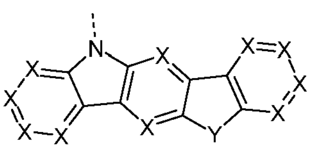
Formel (20)

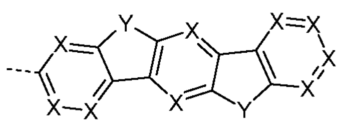
Formel (21)

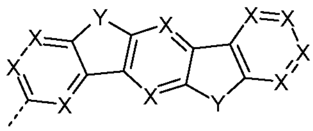

Formel (22)

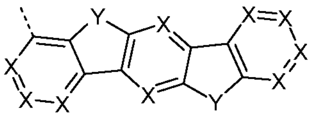

Formel (23)

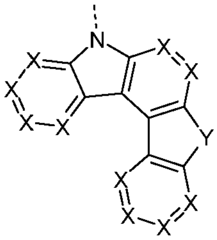

Formel (24)

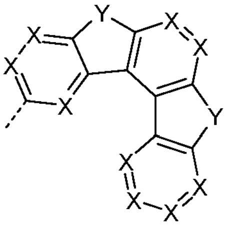

Formel (25)

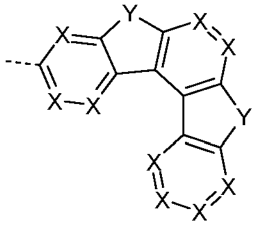

Formel (26)

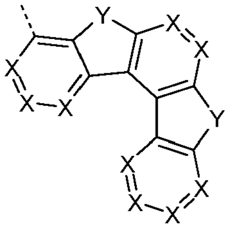

Formel (27)

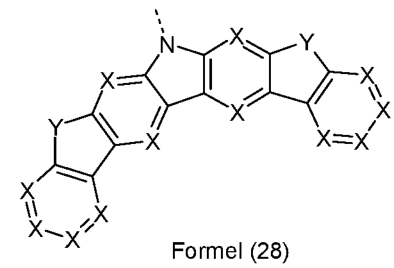

Formel (28)

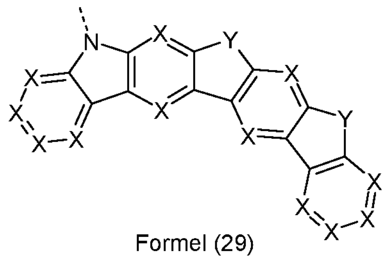

Formel (29)

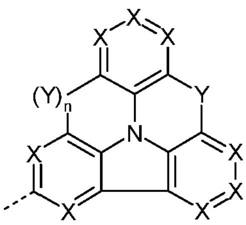

Formel (30)

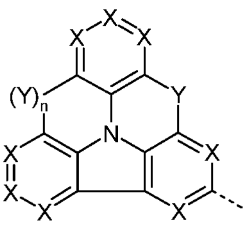

Formel (31)

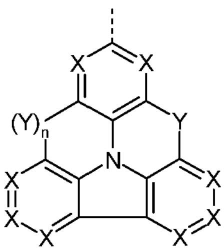

Formel (32)

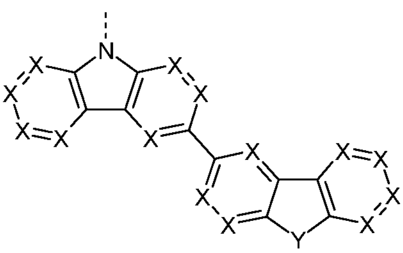

Formel (33)

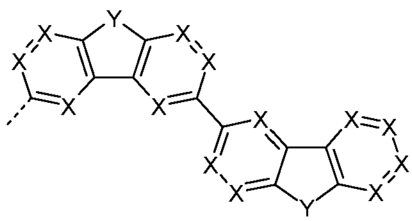

Formel (34)

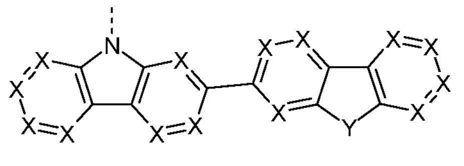

Formel (35)

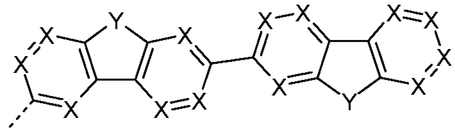

Formel (36)

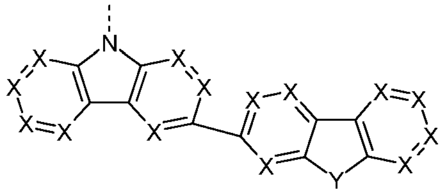

Formel (37)

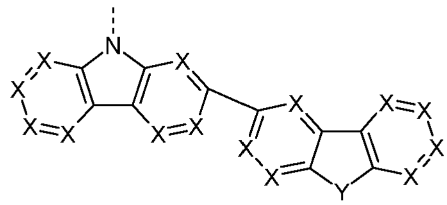

Formel (38)

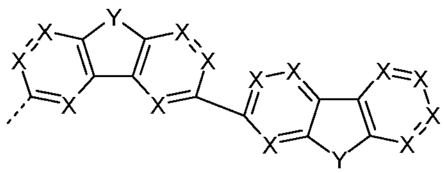

Formel (39)

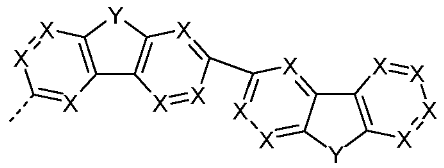

Formel (40)

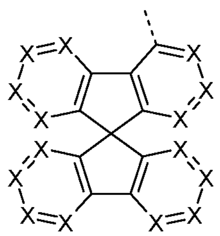

Formel (41)

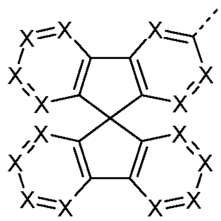

Formel (42)

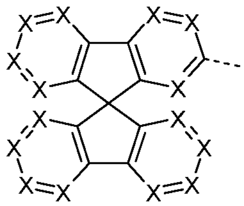

Formel (43)

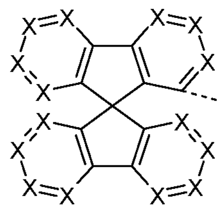

Formel (44)

wobei $R^1$ und $R^2$ die oben genannten Bedeutungen aufweisen, die gestrichelte Bindung die Bindung an die Gruppe der Formel (1) bzw. (2) darstellt und weiterhin gilt:

X ist bei jedem Auftreten gleich oder verschieden $CR^1$ oder N, wobei bevorzugt maximal 2 Symbole X pro Cyclus für N stehen;

Y ist bei jedem Auftreten gleich oder verschieden $C(R^1)_2$, $NR^1$, O oder S;

n ist 0 oder 1, wobei n gleich 0 bedeutet, dass an dieser Position keine Gruppe Y gebunden ist und an den entsprechenden Kohlenstoffatomen statt dessen Reste $R^1$ gebunden sind.

Der oben genannte und auch im Folgenden verwendete Begriff "pro Cyclus" bezieht sich im Sinne der vorliegenden Anmeldung auf jeden einzelnen in der Verbindung enthaltenen Ring, also auf jeden einzelnen 5-bzw. 6-Ring.

In bevorzugten Gruppen der oben genannten Formeln (3) bis (44) steht maximal ein Symbol X pro Cyclus für N. Besonders bevorzugt steht das Symbol X gleich oder verschieden bei jedem Auftreten für $CR^1$, insbesondere für CH.

Wenn die Gruppen der Formeln (3) bis (44) mehrere Gruppen Y aufweisen, so kommen hierfür alle Kombinationen aus der Definition von Y in Frage. Bevorzugt sind Gruppen der Formeln (3) bis (44), in denen eine Gruppe Y für $NR^1$ und die andere Gruppe Y für $C(R^1)_2$ steht oder in denen beide Gruppen Y für $NR^1$ stehen oder in denen beide Gruppen Y für O stehen.

In einer weiteren bevorzugten Ausführungsform der Erfindung steht mindestens eine Gruppe Y in den Formeln (3) bis (44) gleich oder verschieden bei jedem Auftreten für $C(R^1)_2$ oder für $NR^1$.

Wenn Y für $NR^1$ steht, steht der Substituent $R^1$, der an das Stickstoffatom gebunden ist, bevorzugt für ein aromatisches oder heteroaromatisches Ringsystem mit 5 bis 24 aromatischen Ringatomen, welches auch durch einen oder mehrere Reste $R^2$ substituiert sein kann. In einer besonders bevorzugten Ausführungsform steht dieser Substituent $R^1$ gleich oder verschieden bei jedem Auftreten für ein aromatisches oder heteroaromatisches Ringsystem mit 6 bis 24 aromatischen Ringatomen, welches keine kondensierten Arylgruppen aufweist und welches keine kondensierten Heteroarylgruppen, in welchen zwei oder mehr aromatische bzw. heteroaromatische 6-Ring-Gruppen direkt aneinander ankondensiert sind, aufweist und welches jeweils auch durch einen oder mehrere Reste $R^2$ substituiert sein kann. Besonders bevorzugt sind die vorne aufgeführten Strukturen Bi-1 bis Bi-3, Ter-1 bis Ter-3 und Quater-1 bis Quater-4.

Wenn Y für $C(R^1)_2$ steht, steht $R^1$ bevorzugt gleich oder verschieden bei jedem Auftreten für eine lineare Alkylgruppe mit 1 bis 10 C-Atomen oder für eine verzweigte oder cyclische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste $R^2$ substituiert sein kann. Ganz besonders bevorzugt steht $R^1$ für eine Methylgruppe oder für eine Phenylgruppe. Dabei können die Reste $R^1$ auch miteinander ein Ringsystem bilden, was zu einem Spirosystem führt.

Weiterhin kann es bevorzugt sein, wenn die Gruppe der oben genannten Formeln (3) bis (44) nicht direkt an das Triazin in Formel (1) bzw. das Pyrimidin in Formel (2) binden, sondern über eine verbrückende Gruppe.

Diese verbrückende Gruppe ist dann bevorzugt ausgewählt aus einem aromatischen oder heteroaromatischen Ringsystem mit 5 bis 24 aromatischen Ringatomen, insbesondere mit 6 bis 12 aromatischen Ringatomen, welches jeweils mit einem oder mehreren Resten $R^1$ substituiert sein kann. Bevorzugte aromatische Ringsysteme sind ortho-, meta- oder para-Phenylen oder eine Biphenylgruppe, die jeweils durch einen oder mehrere Reste $R^1$ substituiert sein können, bevorzugt aber unsubstituiert sind.

Beispiele für bevorzugte erfindungsgemäße Verbindungen gemäß Formel (1) bzw. (2) sind die folgenden Verbindungen.

| | | |
|---|---|---|
| 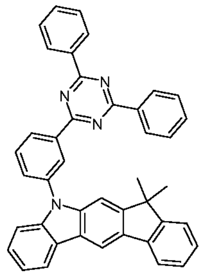 | 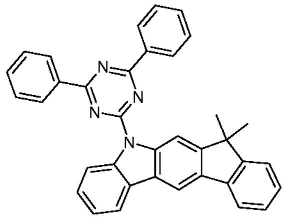 | 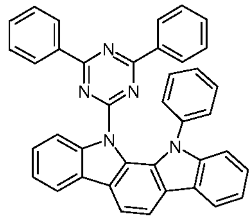 |
| 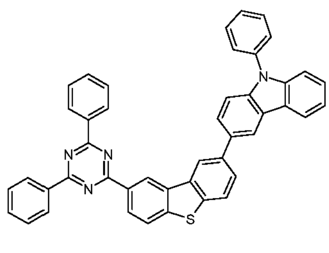 | 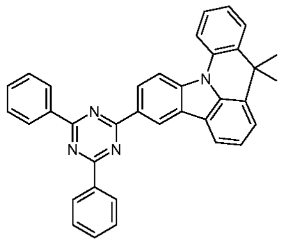 | 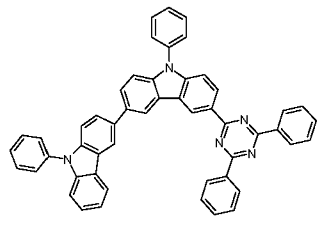 |
| 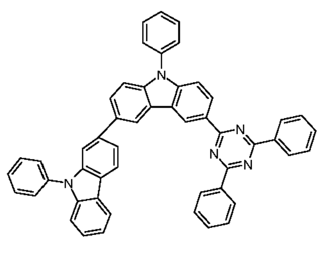 | 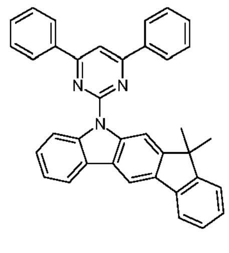 | 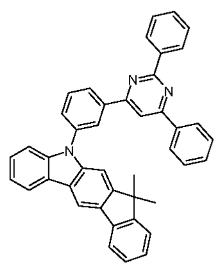 |

| | | |
|---|---|---|
| 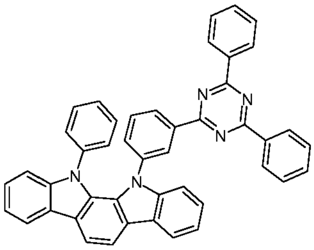 | 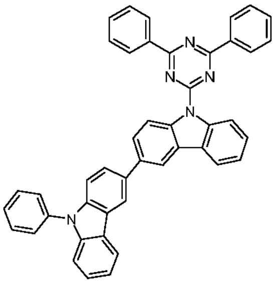 | 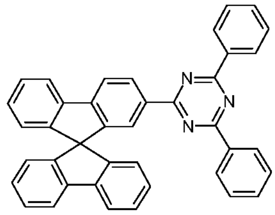 |
| 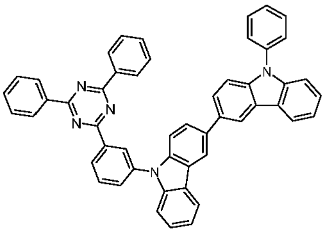 | 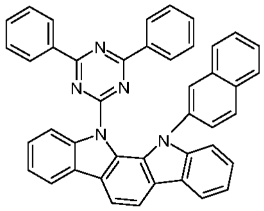 | 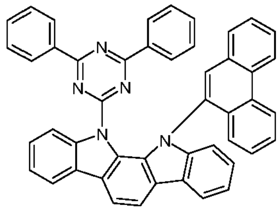 |
| 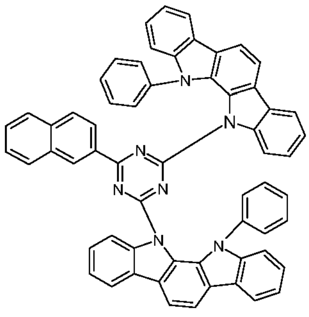 | 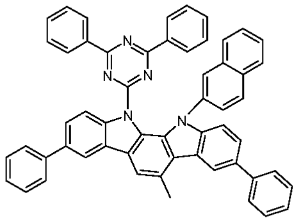 | 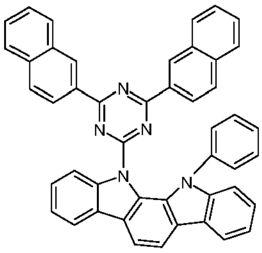 |
| 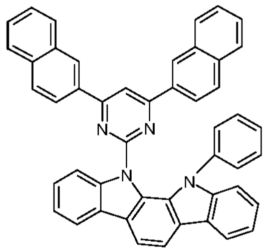 | 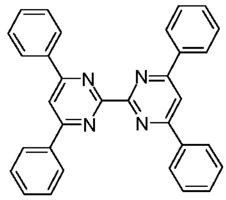 | 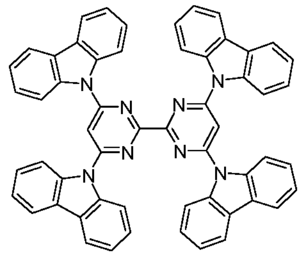 |
| 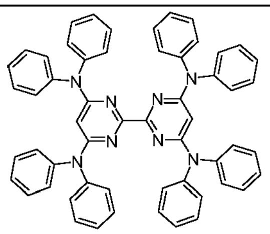 | 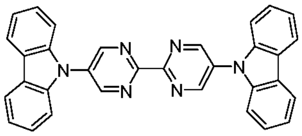 | 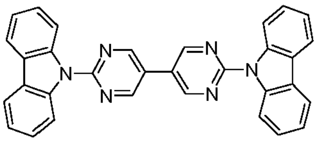 |
| 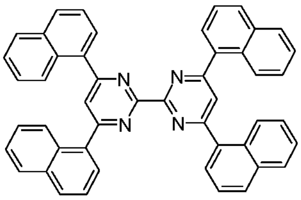 | 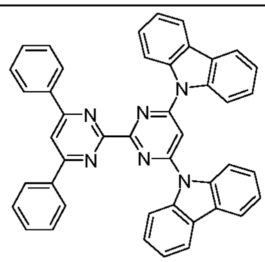 | 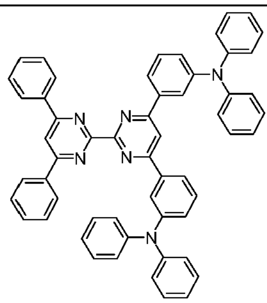 |

| | | |
|---|---|---|
| 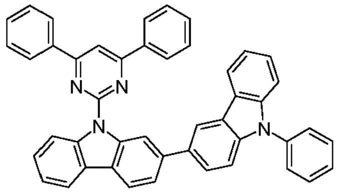 | 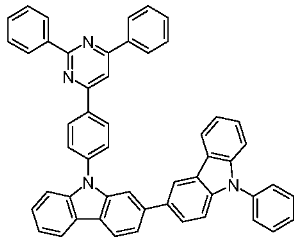 | 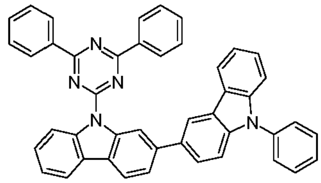 |
| 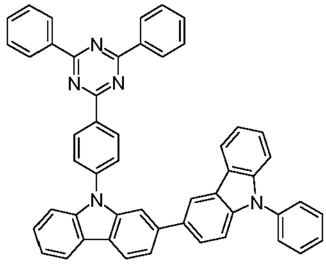 | 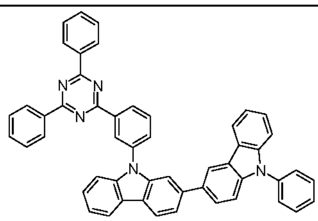 | 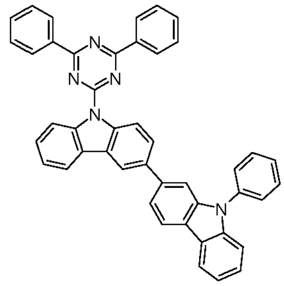 |
| 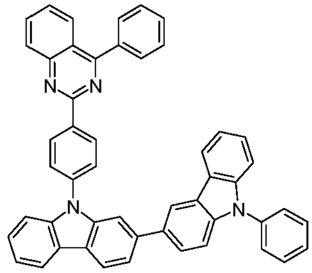 | 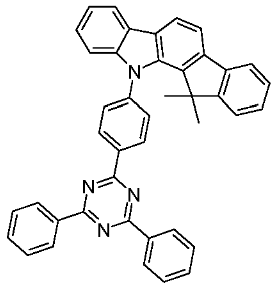 | 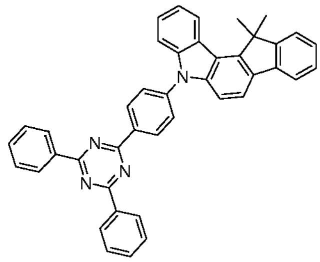 |
| 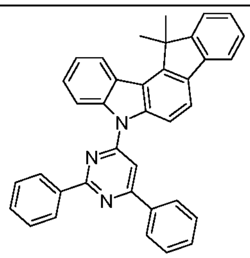 | 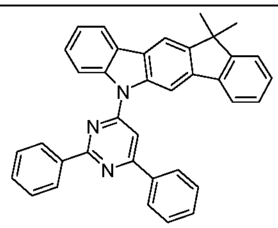 | 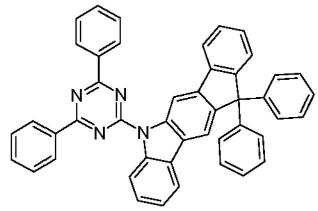 |
| 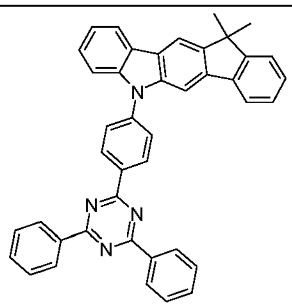 | 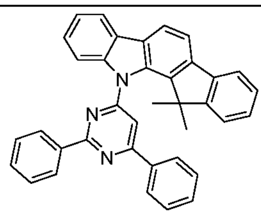 | 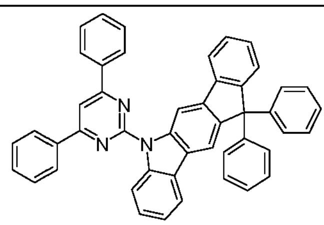 |
| 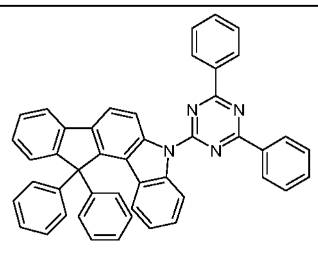 | 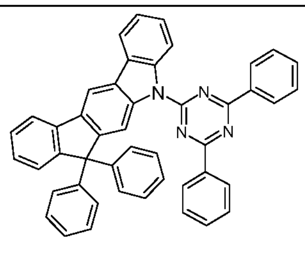 | 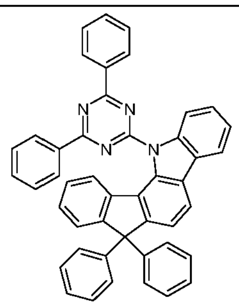 |

| | | |
|---|---|---|
| 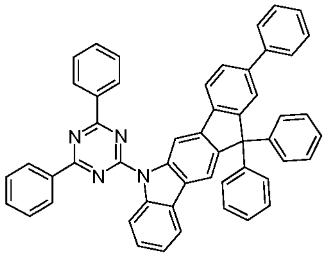 | 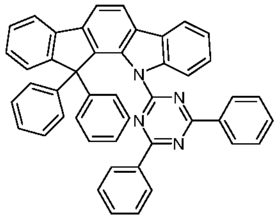 | 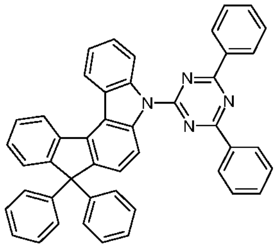 |
| 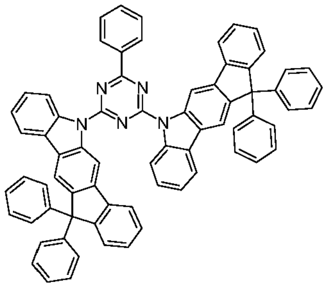 | 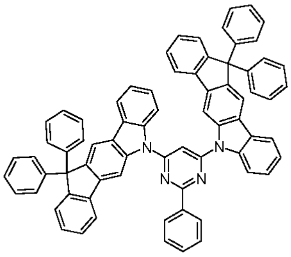 | 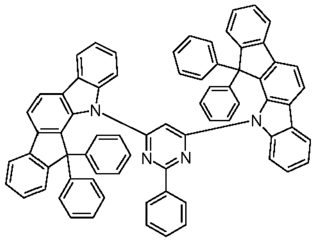 |
| 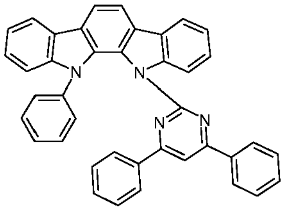 | 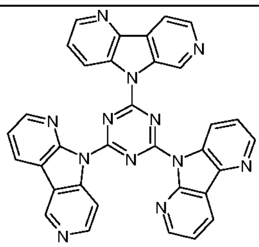 | 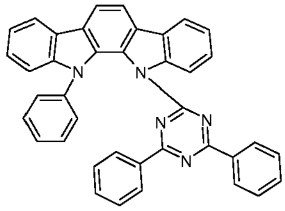 |
| 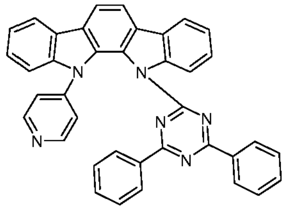 | 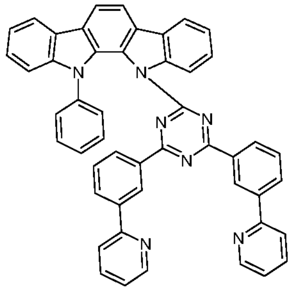 | 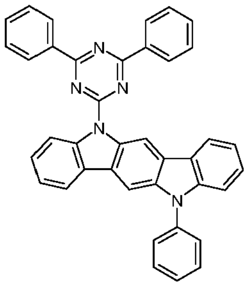 |
| 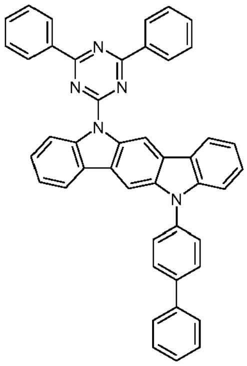 | 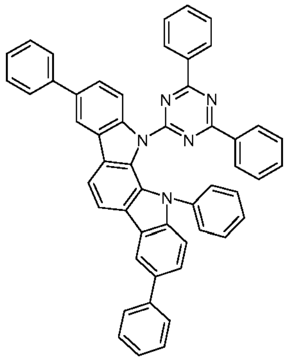 | 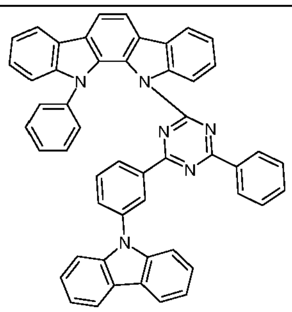 |

| | | |
|---|---|---|
| 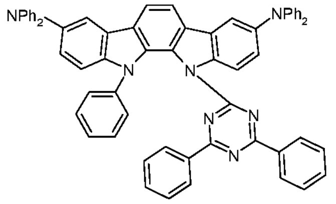 | 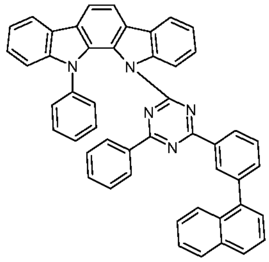 | 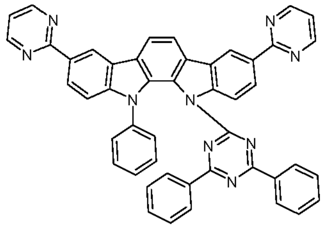 |
| 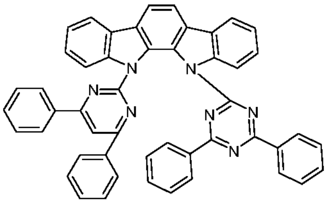 | 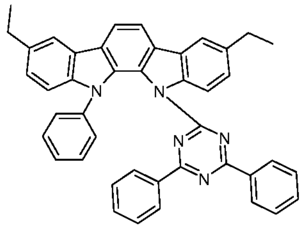 | 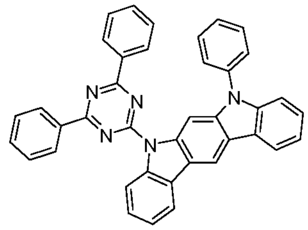 |
| 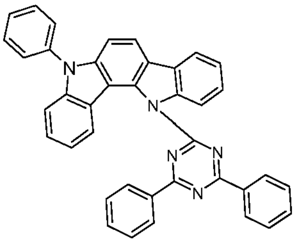 | 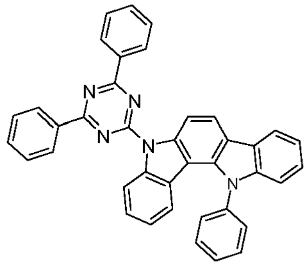 | 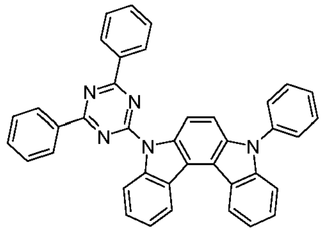 |
| 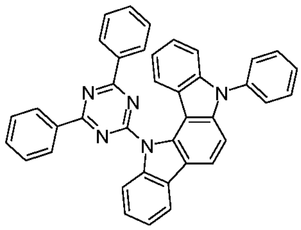 | 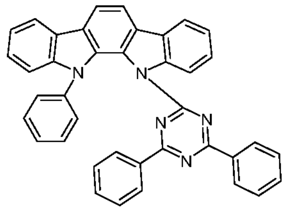 | 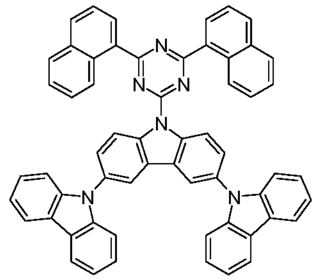 |
| 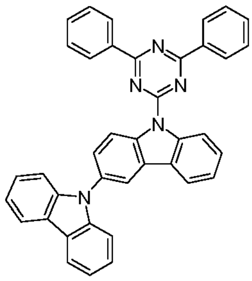 | 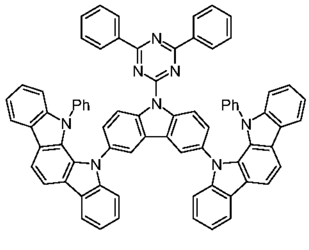 | 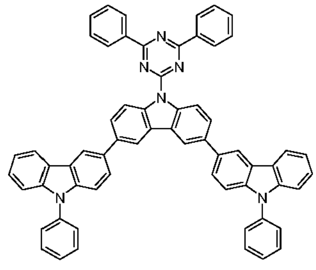 |
| 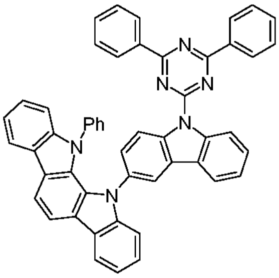 | 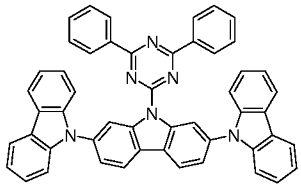 | 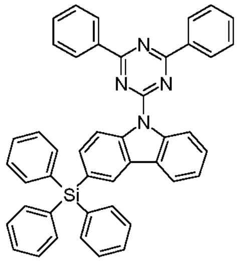 |

| | | |
|---|---|---|
| 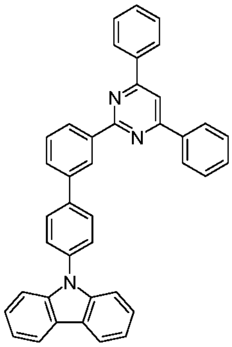 | 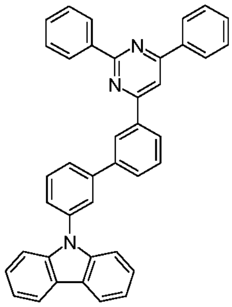 | 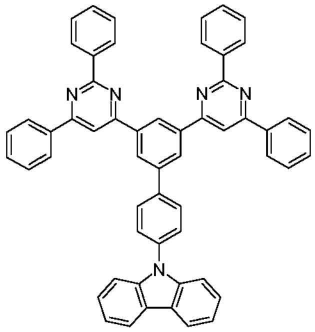 |
| 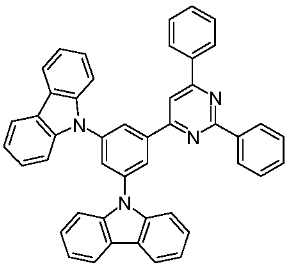 | 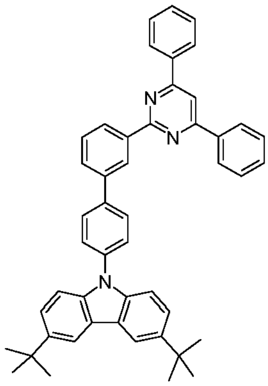 | 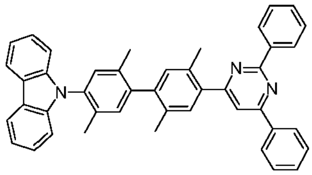 |
| 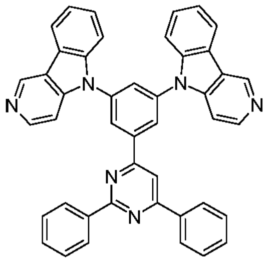 | 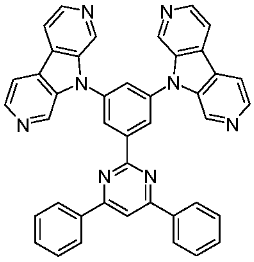 | 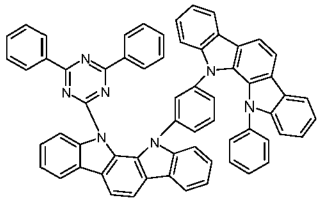 |
| 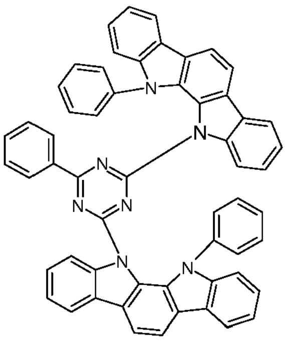 | 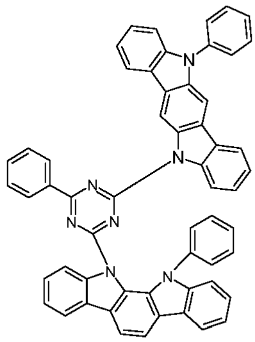 | 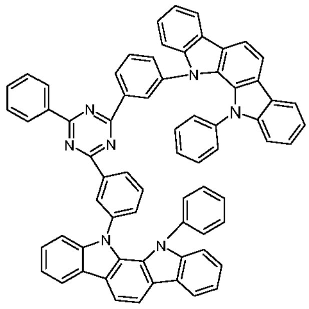 |
| 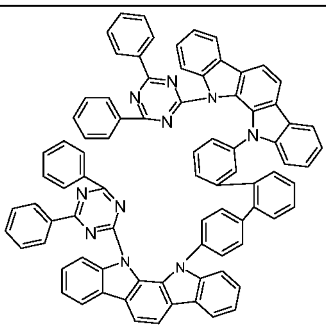 | 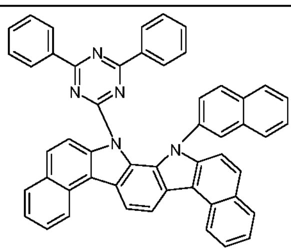 | 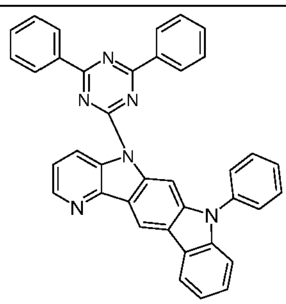 |

| | | |
|---|---|---|
| 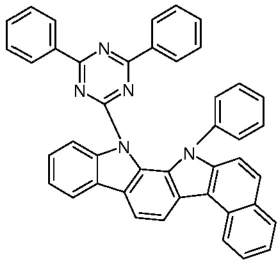 | 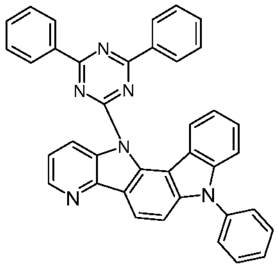 | 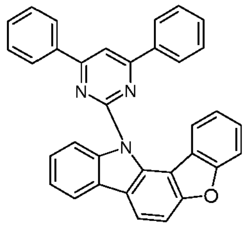 |
| 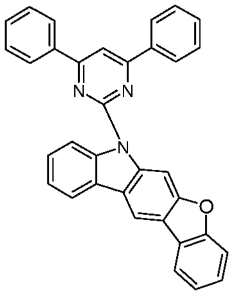 | 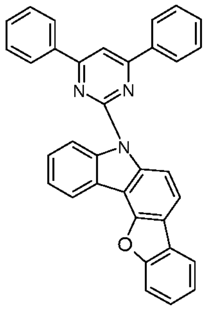 | 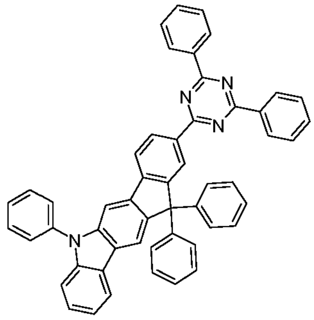 |
| 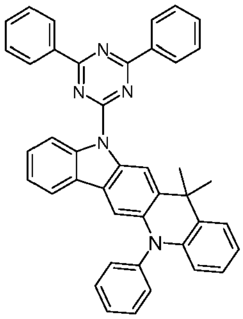 | 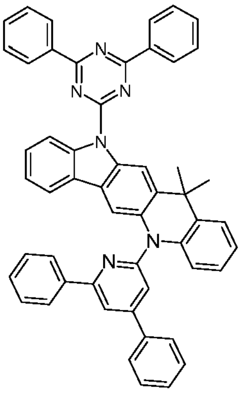 | 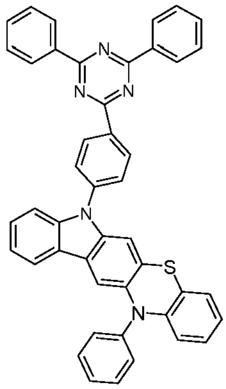 |
| 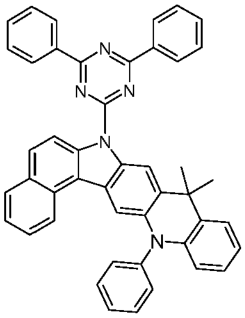 | 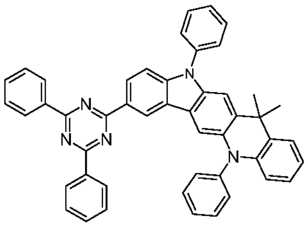 | 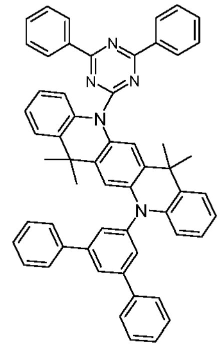 |
| 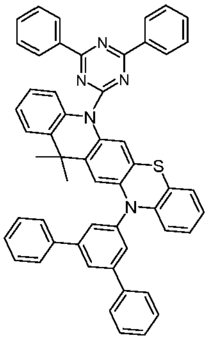 | 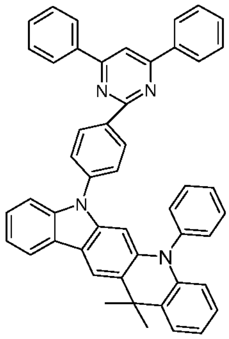 | 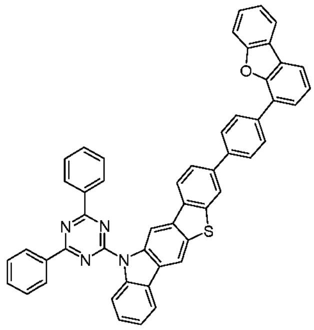 |

| | | |
|---|---|---|
| 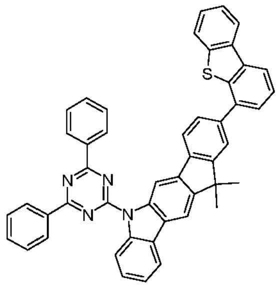 | 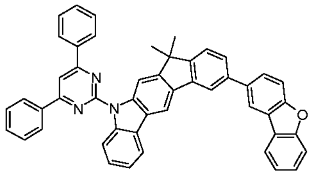 | 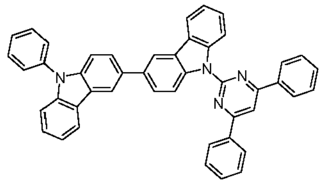 |
| 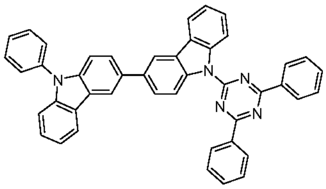 | 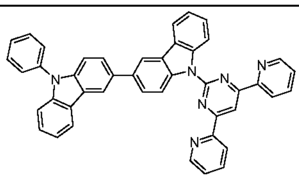 | 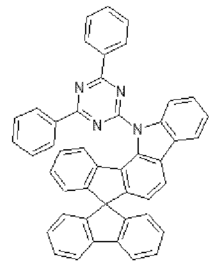 |
| 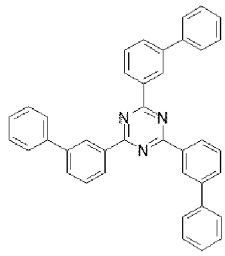 | | |

| | |
|---|---|
| 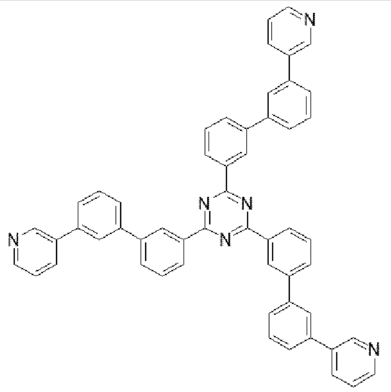 | 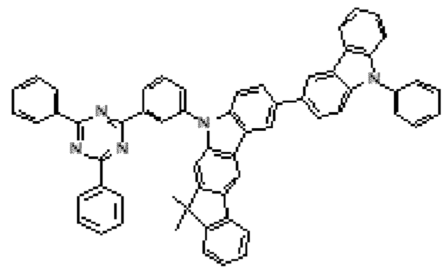 |
| 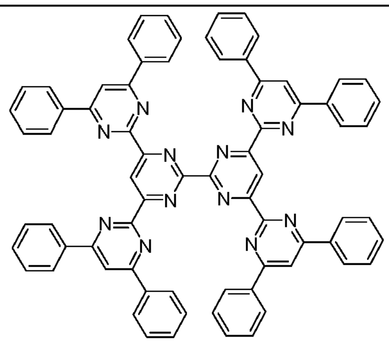 | 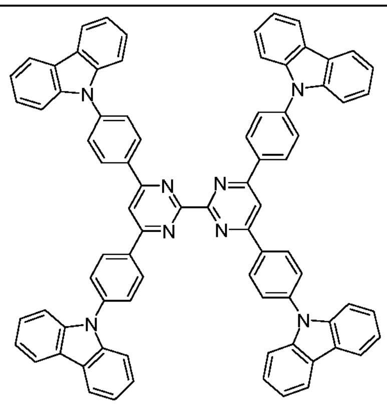 |

| | |
|---|---|
| 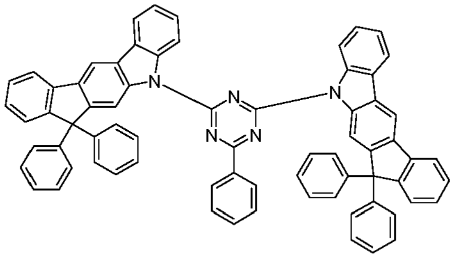 | 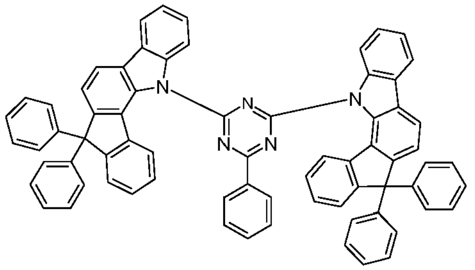 |
| 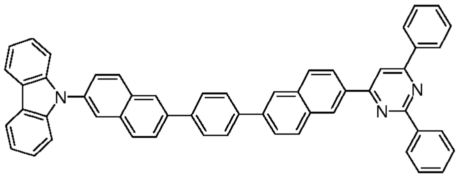 | 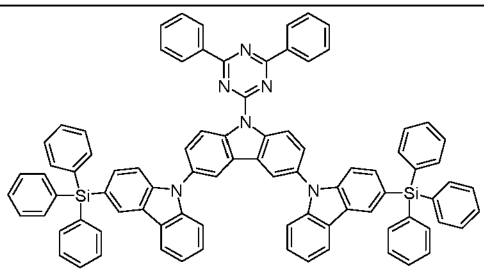 |
| 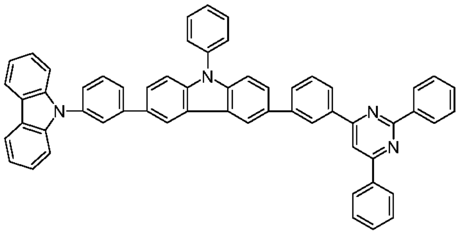 | 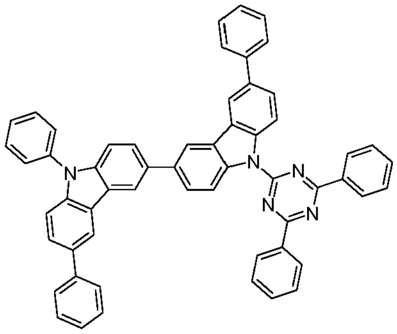 |
| 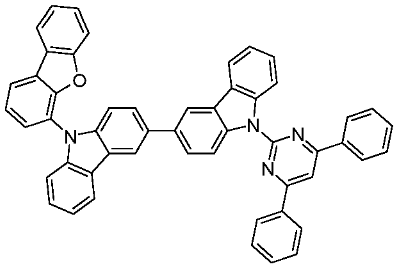 | 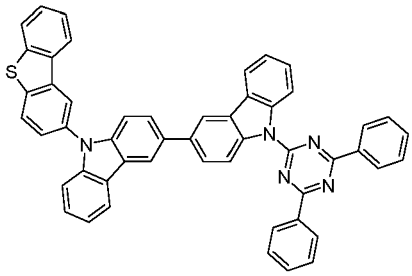 |
| 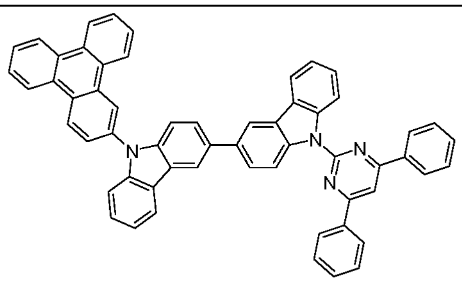 | 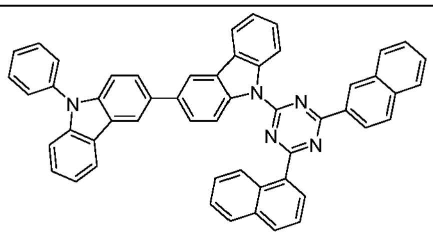 |

Wenn die erfindungsgemäße elektronenleitende Verbindung ein Lactam ist, dann ist diese Verbindung bevorzugt ausgewählt aus den Verbindungen der folgenden Formeln (45) bzw. (46),

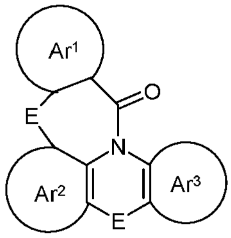
Formel (45)

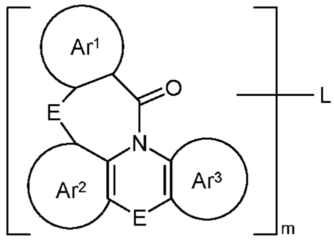
Formel (46)

wobei R, $R^1$, $R^2$ und Ar die oben genannten Bedeutungen aufweisen und für die weiteren verwendeten Symbole und Indizes gilt:

E ist gleich oder verschieden bei jedem Auftreten eine Einfachbindung, NR, $CR_2$, O, S, $SiR_2$, BR, PR und P(=O)R;

$Ar^1$, $Ar^2$, $Ar^3$ ist gleich oder verschieden bei jedem Auftreten zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann;

L ist für m = 2 eine Einfachbindung oder eine bivalente Gruppe, bzw. für m = 3 eine trivalente Gruppe bzw. für m = 4 eine tetravalente Gruppe, welche jeweils an eine beliebige Position an $Ar^1$, $Ar^2$ oder $Ar^3$ oder statt einem Rest R an E gebunden ist;

m ist 2, 3 oder 4.

In einer bevorzugten Ausführungsform der Verbindung gemäß Formel (45) bzw. (46) steht die Gruppe $Ar^1$ für eine Gruppe der folgenden Formel (47), (48), (49) oder (50),

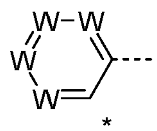
Formel (47)

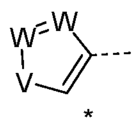
Formel (48)

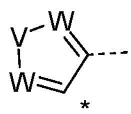
Formel (49)

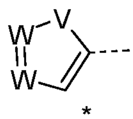
Formel (50)

wobei die gestrichelte Bindung die Verknüpfung mit der Carbonylgruppe andeutet, * die Position der Verknüpfung mit E bzw. $Ar^2$ andeutet und weiterhin gilt:

W ist gleich oder verschieden bei jedem Auftreten CR oder N; oder zwei benachbarte Gruppen W stehen für eine Gruppe der folgenden Formel (51) oder (52),

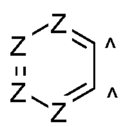
Formel (51)

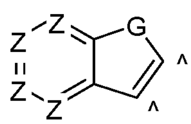
Formel (52)

wobei G für $CR_2$, NR, O oder S steht, Z gleich oder verschieden bei jedem Auftreten für CR oder N steht und ^ die entsprechenden benachbarten Gruppen W in der Formel (47) bis (50) andeuten;

V ist NR, O oder S.

In einer weiteren bevorzugten Ausführungsform der Erfindung steht die Gruppe $Ar^2$ für eine Gruppe gemäß einer der folgenden Formeln (53), (54) oder (55),

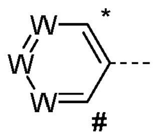

Formel (53)

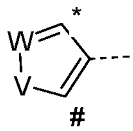

Formel (54)

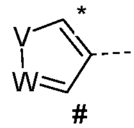

Formel (55)

wobei die gestrichelte Bindung die Verknüpfung mit N andeutet, # die Position der Verknüpfung mit E bzw. $Ar^3$ andeutet, * die Verknüpfung mit E bzw. $Ar^1$ andeutet und W und V die oben genannten Bedeutungen aufweisen.

In einer weiteren bevorzugten Ausführungsform der Erfindung steht die Gruppe $Ar^3$ für eine Gruppe gemäß einer der folgenden Formeln (56), (57), (58) oder (59),

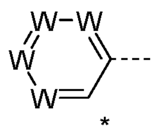

Formel (56)

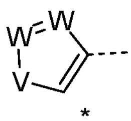

Formel (57)

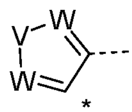

Formel (58)

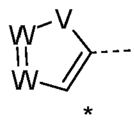

Formel (59)

wobei die gestrichelte Bindung die Verknüpfung mit N andeutet, * die Verknüpfung mit E bzw. $Ar^2$ andeutet und W und V die oben genannten Bedeutungen aufweisen.

Dabei können die oben genannten bevorzugten Gruppen $Ar^1$, $Ar^2$ und $Ar^3$ beliebig miteinander kombiniert werden.

In einer weiteren bevorzugten Ausführungsform der Erfindung steht mindestens eine Gruppe E für eine Einfachbindung.

In einer bevorzugten Ausführungsform der Erfindung treten die oben genannten Bevorzugungen gleichzeitig auf. Besonders bevorzugt sind daher Verbindungen gemäß Formel (45) bzw. (46), für die gilt:

$Ar^1$ ist ausgewählt aus den Gruppen der oben genannten Formeln (47), (48), (49) oder (50);
$Ar^2$ ist ausgewählt aus den Gruppen der oben genannten Formeln (53), (54) oder (55);
$Ar^3$ ist ausgewählt aus den Gruppen der oben genannten Formeln (56), (57), (58) oder (59).

Besonders bevorzugt stehen mindestens zwei der Gruppen $Ar^1$, $Ar^2$ und $Ar^3$ für eine 6-Ring-Aryl- oder eine 6-Ring-Heteroarylgruppe. Besonders bevorzugt steht also $Ar^1$ für eine Gruppe der Formel (47) und gleichzeitig steht $Ar^2$ für eine Gruppe der Formel (53), oder $Ar^1$ steht für eine Gruppe der Formel (47) und gleichzeitig steht $Ar^3$ für eine Gruppe der Formel (56), oder $Ar^2$ steht für eine Gruppe der Formel (53) und gleichzeitig steht $Ar^3$ für eine Gruppe der Formel (59).

Besonders bevorzugte Ausführungsformen der Formel (45) sind daher die Verbindungen der folgenden Formeln (60) bis (69),

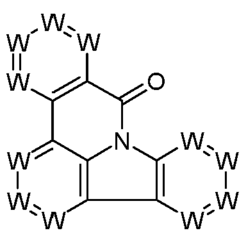

Formel (60)

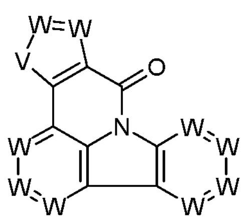

Formel (61)

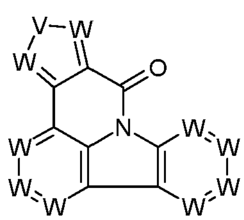

Formel (62)

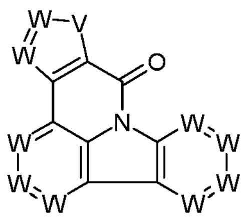
Formel (63)

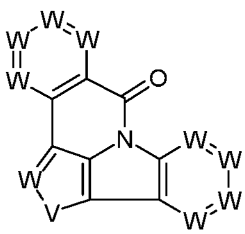
Formel (64)

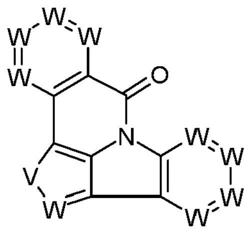
Formel (65)

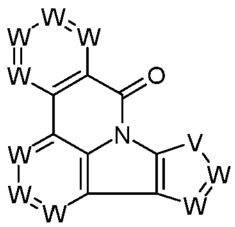
Formel (66)

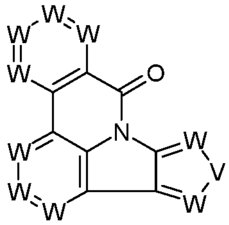
Formel (67)

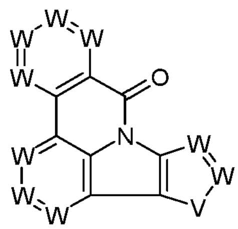
Formel (68)

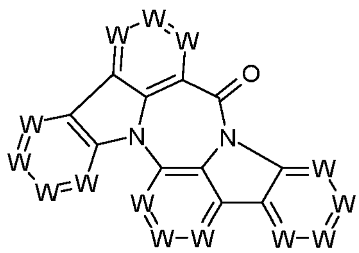
Formel (69)

wobei die verwendeten Symbole die oben genannten Bedeutungen aufweisen.

Es ist weiterhin bevorzugt, wenn W für CR oder N steht und nicht für eine Gruppe der Formel (51) oder (52). In einer bevorzugten Ausführungsform der Verbindungen gemäß Formel (60) bis (69) steht pro Cyclus insgesamt maximal ein Symbol W für N, und die verbleibenden Symbole W stehen für CR. In einer besonders bevorzugten Ausführungsform der Erfindung stehen alle Symbole W für CR. Besonders bevorzugt sind daher die Verbindungen gemäß den folgenden Formeln (60a) bis (69a),

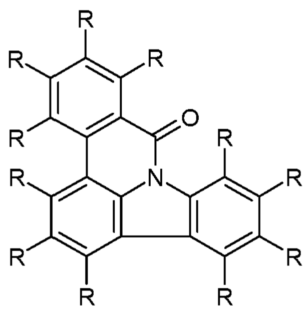
Formel (60a)

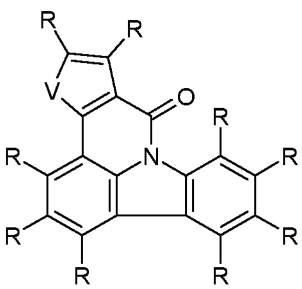
Formel (61a)

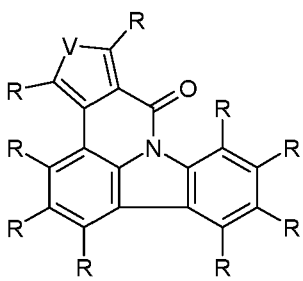
Formel (62a)

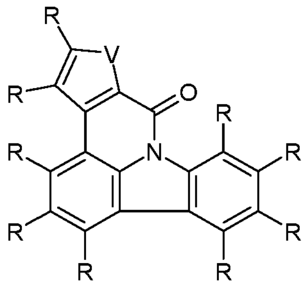
Formel (63a)

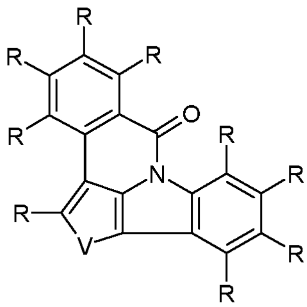
Formel (64a)

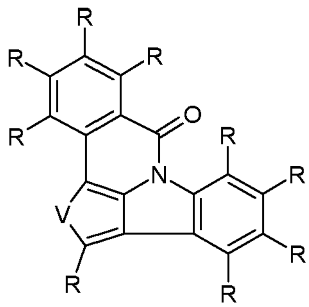
Formel (65a)

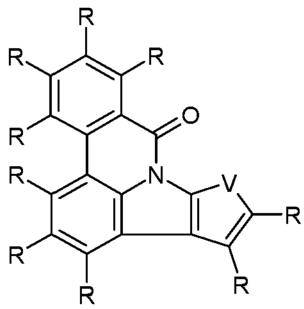
Formel (66a)

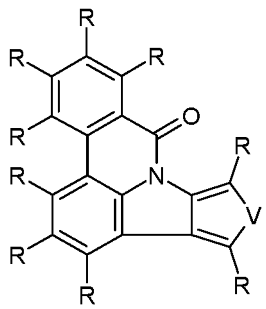
Formel (67a)

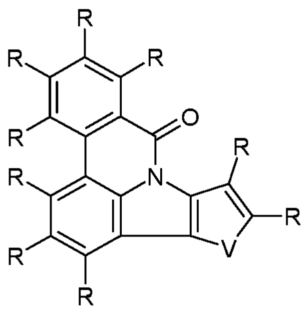
Formel (68a)

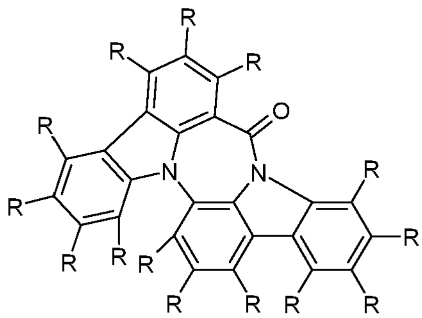
Formel (69a)

wobei die verwendeten Symbole die oben genannten Bedeutungen aufweisen.

Ganz besonders bevorzugt sind die Strukturen der Formeln (60b) bis (69b),

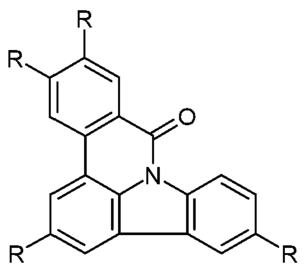
Formel (60b)

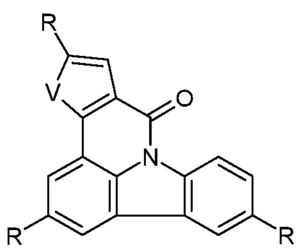
Formel (61b)

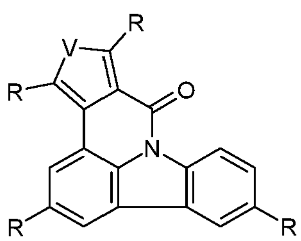
Formel (62b)

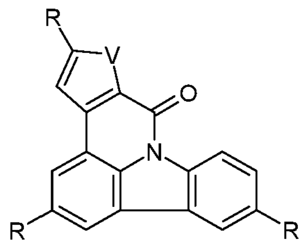

Formel (63b)

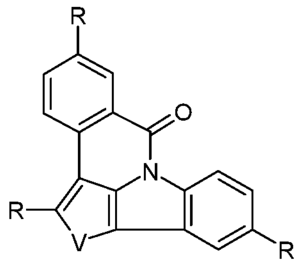

Formel (64b)

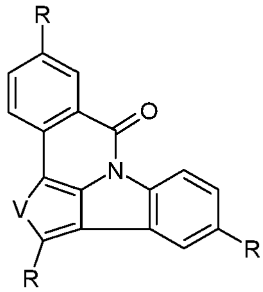

Formel (65b)

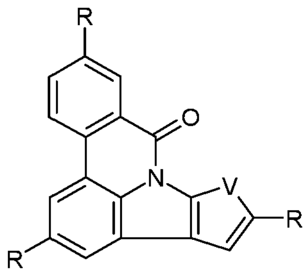

Formel (66b)

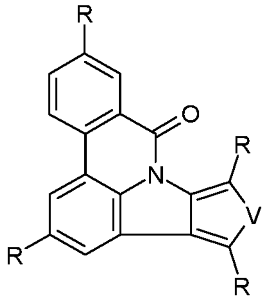

Formel (67b)

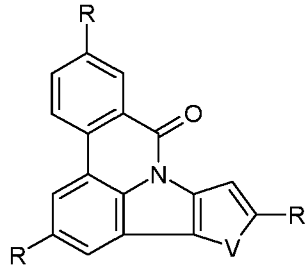

Formel (68b)

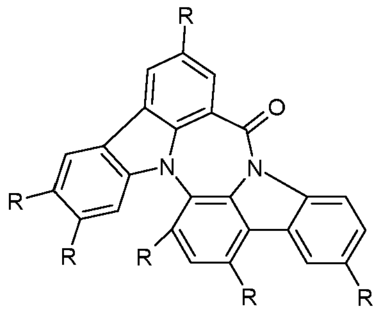

Formel (69b)

wobei die verwendeten Symbole die oben genannten Bedeutungen aufweisen.

Ganz besonders bevorzugt sind die Verbindungen der Formel (60) bzw. (60a) bzw. (60b).

Die verbrückende Gruppe L in den Verbindungen der Formeln (46a) ist bevorzugt ausgewählt aus einer Einfachbindung oder einem aromatischen oder heteroaromatischen Ringsystem mit 5 bis 30 aromatischen Ringatomen, welches durch einen oder mehrere Reste R substituiert sein kann. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind.

In einer weiteren bevorzugten Ausführungsform der Erfindung ist der Index m in Verbindungen der Formel (46) = 2 oder 3, insbesondere gleich 2. Ganz besonders bevorzugt werden Verbindungen der Formel (1) eingesetzt.

In einer bevorzugten Ausführungsform der Erfindung ist R in den Formeln (45) und (46) sowie den bevorzugten Ausführungsformen gleich oder verschieden bei jedem Auftreten ausgewählt aus der Gruppe bestehend aus H, D, F, Cl, Br, CN, $N(Ar)_2$, C(=O)Ar, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenylgruppe mit 2 bis 10 C-Atomen, die jeweils mit einem oder mehreren Resten $R^1$ substituiert sein kann, wobei eine oder mehrere nicht-benachbarte $CH_2$-Gruppen durch O ersetzt sein können und wobei ein oder mehrere H-Atome durch D oder F ersetzt sein können, einem aromatischen oder heteroaromatischen Ringsystem mit 5 bis 30 aromatischen Ringatomen, das jeweils mit einem oder mehreren Resten $R^1$ substituiert sein kann, einer Aryloxy- oder Heteroaryloxygruppe mit 5 bis 30 aromatischen Ringatomen, die mit einem oder mehreren Resten $R^1$ substituiert sein kann, oder einer Kombination dieser Systeme.

In einer besonders bevorzugten Ausführungsform der Erfindung ist R in den oben genannten Formeln gleich oder verschieden bei jedem Auftreten ausgewählt aus der Gruppe bestehend aus H, D, F, Cl, Br, CN, einer geradkettigen

Alkylgruppe mit 1 bis 10 C-Atomen oder einer verzweigten oder cyclischen Alkylgruppe mit 3 bis 10 C-Atomen, die jeweils mit einem oder mehreren Resten $R^1$ substituiert sein kann, wobei ein oder mehrere H-Atome durch D oder F ersetzt sein können, einem aromatischen oder heteroaromatischen Ringsystem mit 5 bis 18 aromatischen Ringatomen, das jeweils mit einem oder mehreren Resten $R^1$ substituiert sein kann, oder einer Kombination dieser Systeme.

Dabei enthalten die Reste R, wenn diese aromatische oder heteroaromatischen Ringsysteme enthalten, bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Insbesondere bevorzugt sind hier Phenyl, Biphenyl, Terphenyl, Quaterphenyl, Carbazol, Dibenzothiophen, Dibenzofuran, Indenocarbazol, Indolocarbazol, Triazin oder Pyrimidin, welches jeweils auch durch einen oder mehrere Reste $R^1$ substituiert sein kann.

Dabei haben für Verbindungen, die durch Vakuumverdampfung verarbeitet werden, die Alkylgruppen bevorzugt nicht mehr als fünf C-Atome, besonders bevorzugt nicht mehr als 4 C-Atome, ganz besonders bevorzugt nicht mehr als 1 C-Atom.

Die Verbindungen der Formeln (45) und (46) sind prinzipiell bekannt. Die Synthese dieser Verbindungen kann gemäß den in der WO 2011/116865 und WO 2011/137951 beschriebenen Verfahren erfolgen.

Beispiele für erfindungsgemäß bevorzugte Verbindungen gemäß den oben aufgeführten Ausführungsformen sind die in der folgenden Tabelle aufgeführten Verbindungen.

| | | |
|---|---|---|
| 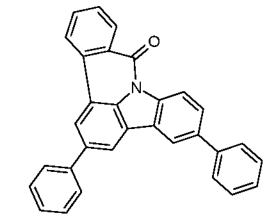 | 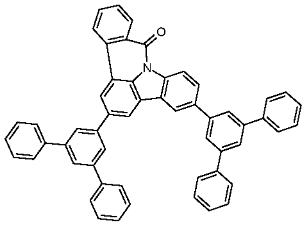 | 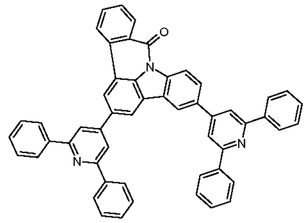 |
| 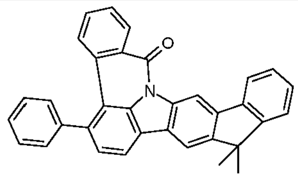 | 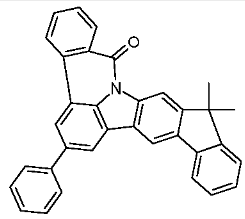 | 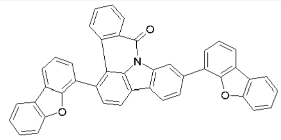 |
| 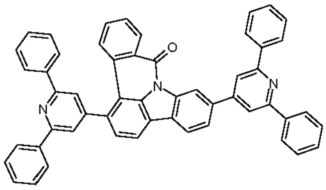 | 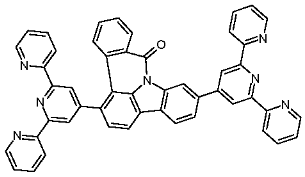 | 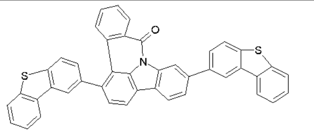 |
| 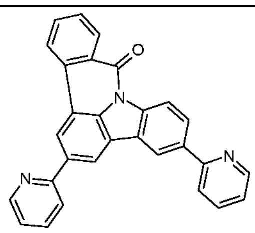 | 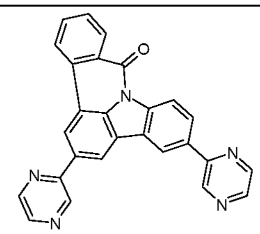 | 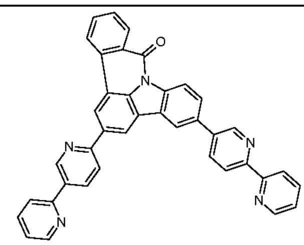 |
| 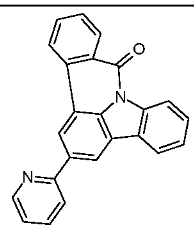 | 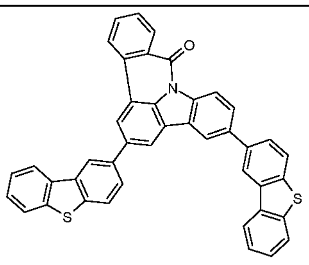 | 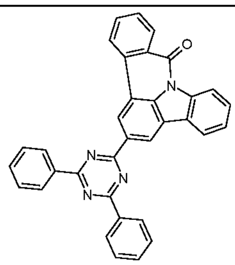 |

| | | |
|---|---|---|
| 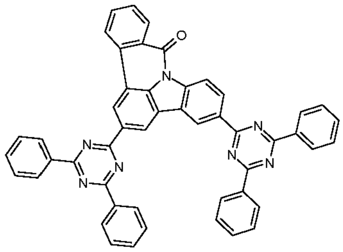 | 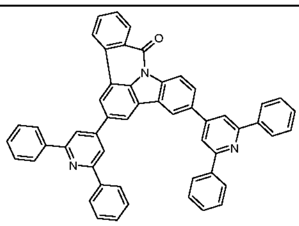 | 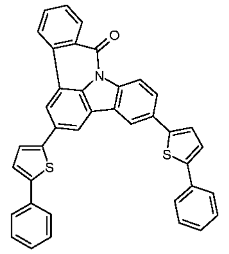 |
| 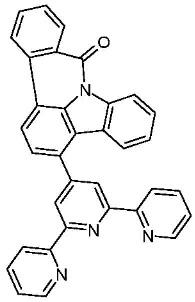 | 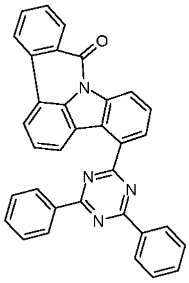 | 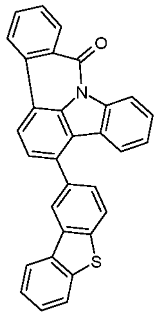 |
| 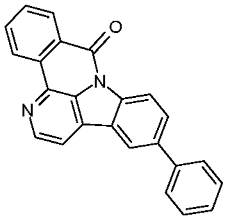 | 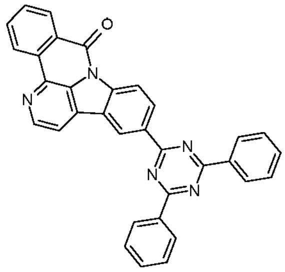 | 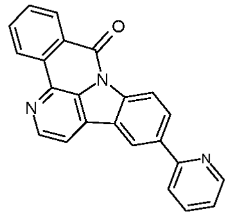 |
| 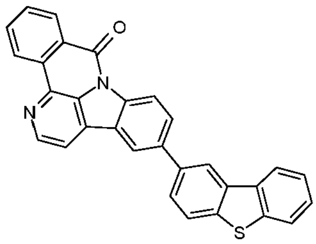 | 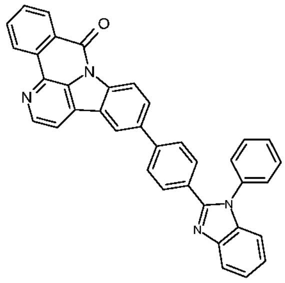 | 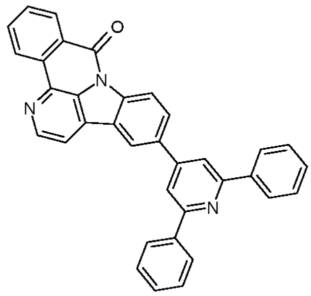 |
| 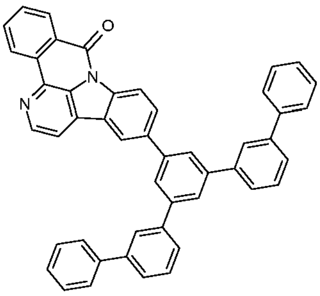 | 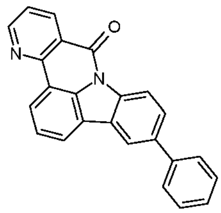 | 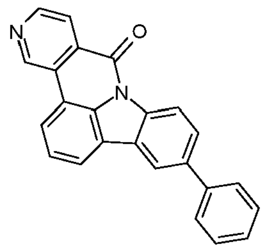 |

| | | |
|---|---|---|
| 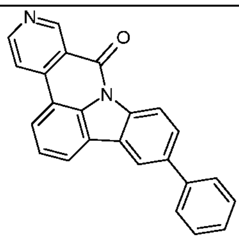 | 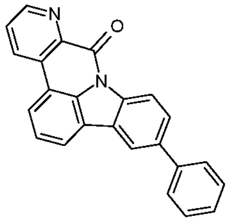 | 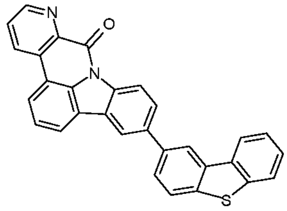 |
| 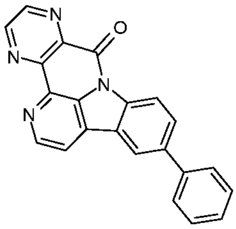 | 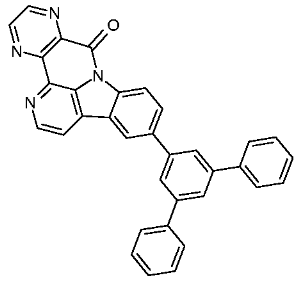 | 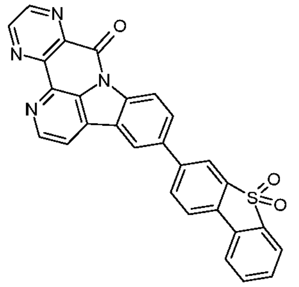 |
| 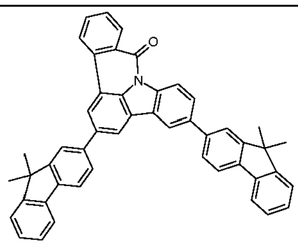 | 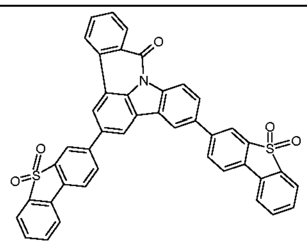 | 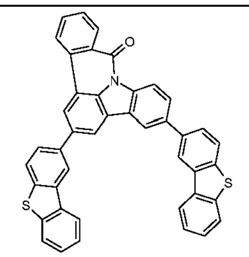 |
| 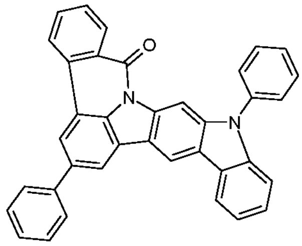 | 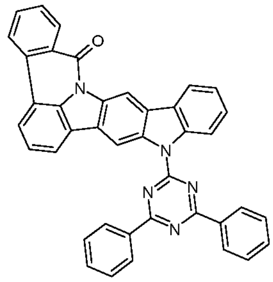 | 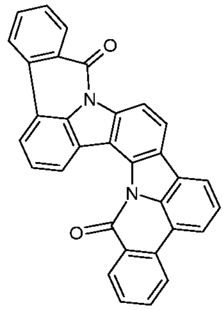 |
| 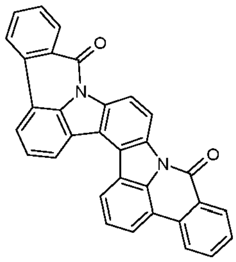 | 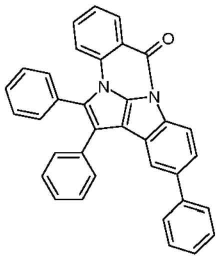 | 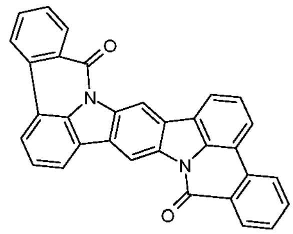 |
| 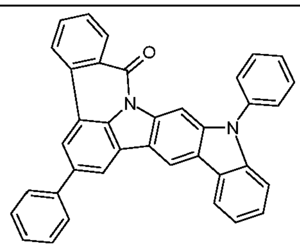 | 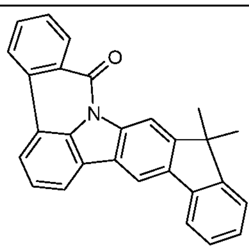 | 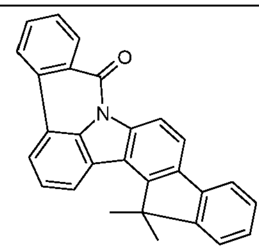 |

| | | |
|---|---|---|
| 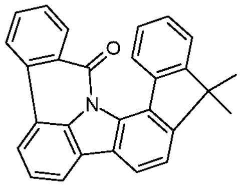 | 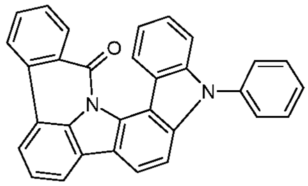 | 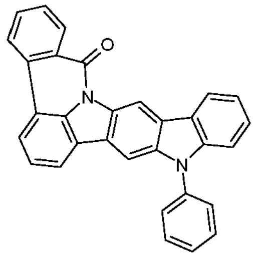 |
| 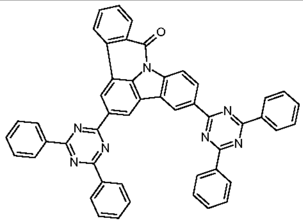 | 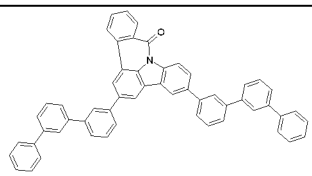 | 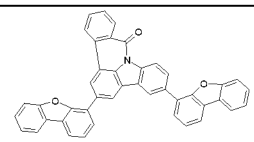 |
| 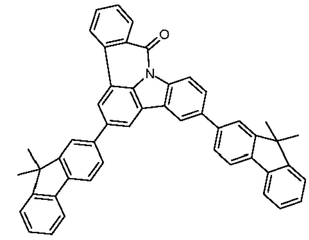 | 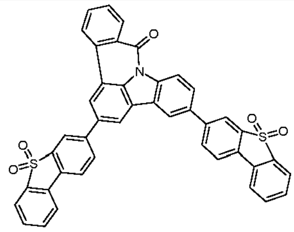 | 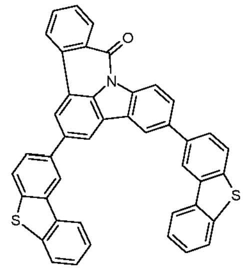 |
| 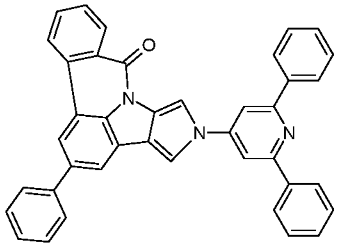 | 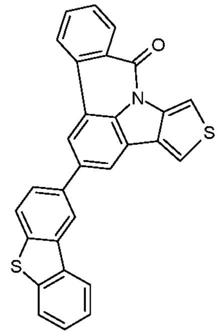 | 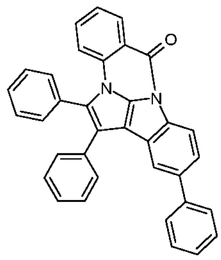 |
| 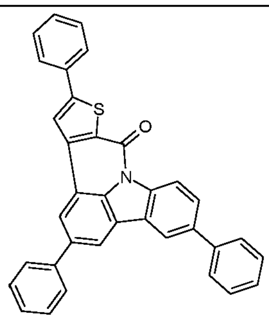 | 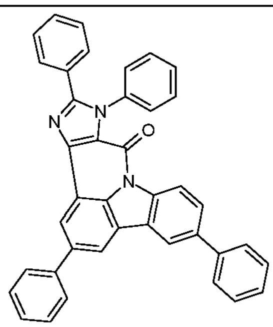 | 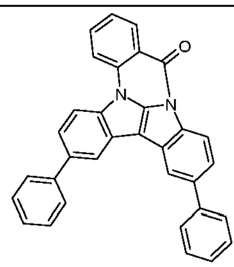 |

| | | |
|---|---|---|
| 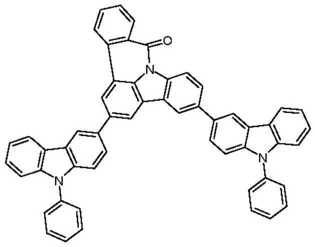 | 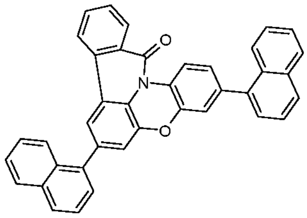 | 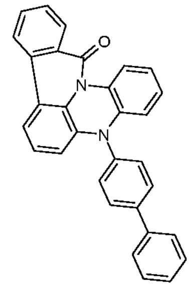 |
| 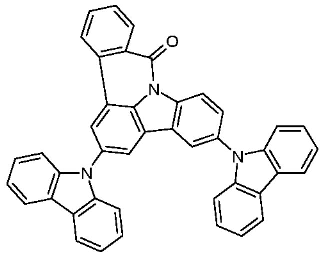 | 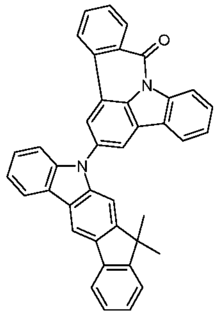 | 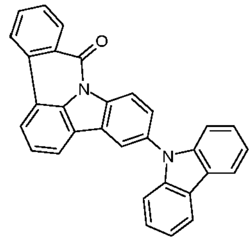 |
| 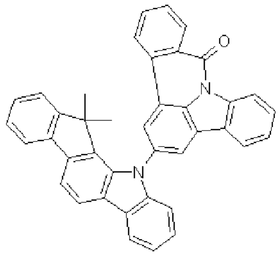 | 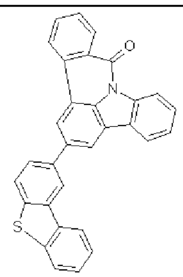 | 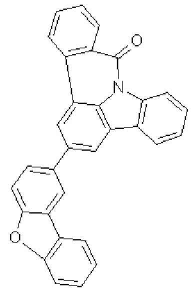 |
| 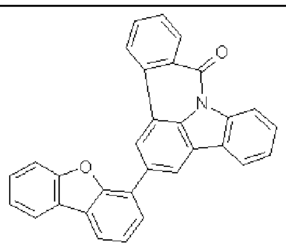 | 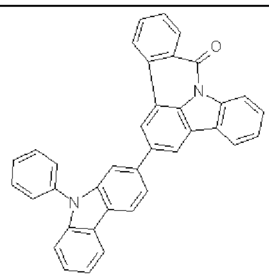 | 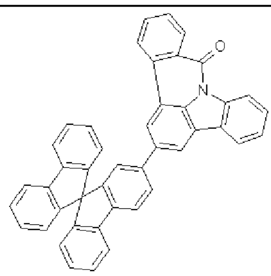 |
| 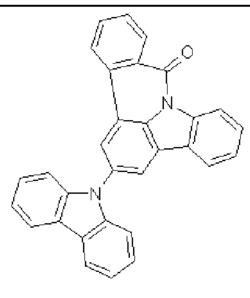 | 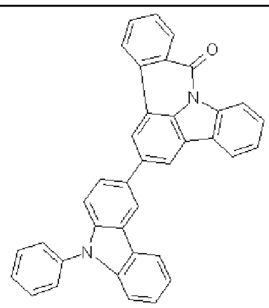 | 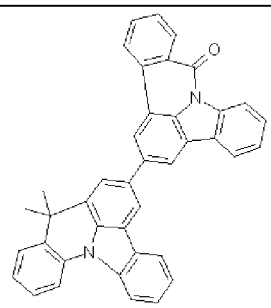 |

| | | |
|---|---|---|
| 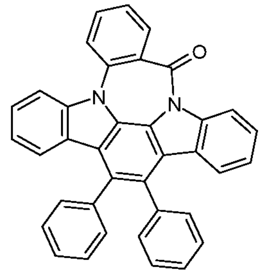 | 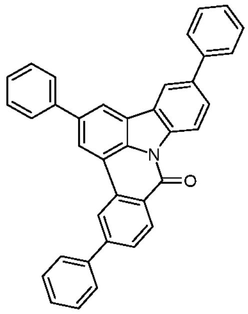 | 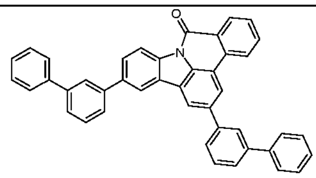 |
| 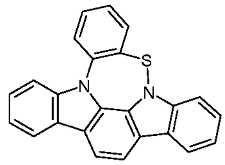 | 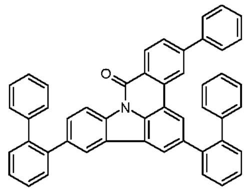 | 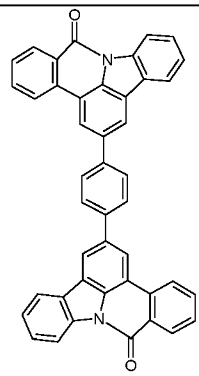 |
| 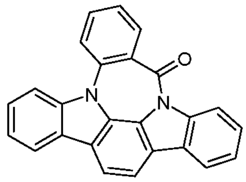 | 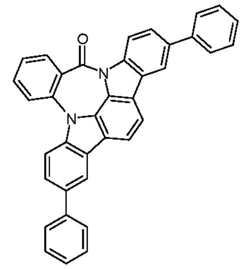 | 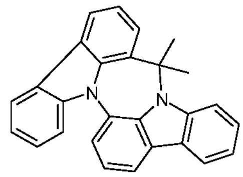 |
| 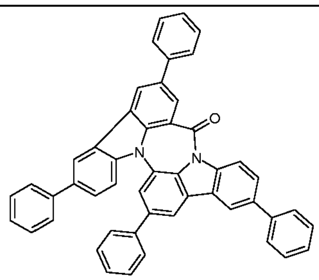 | 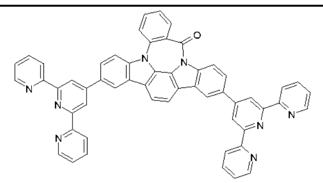 | 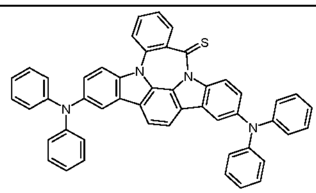 |
| 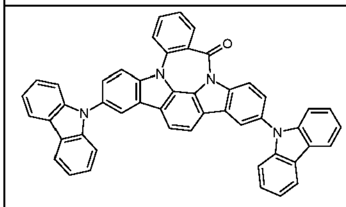 | 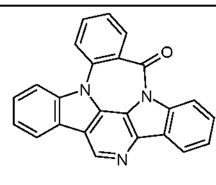 | 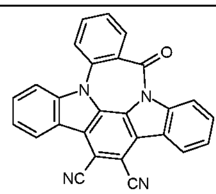 |
| 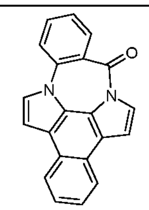 | 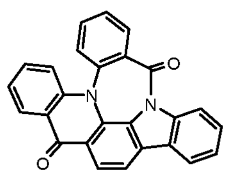 | 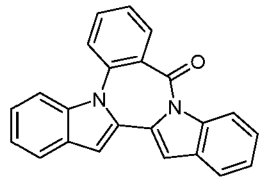 |

| | | |
|---|---|---|
| 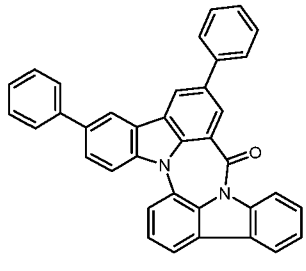 | 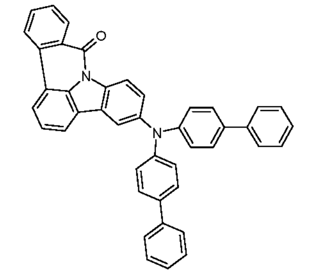 | 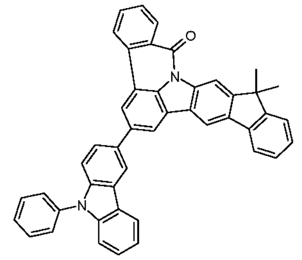 |
| 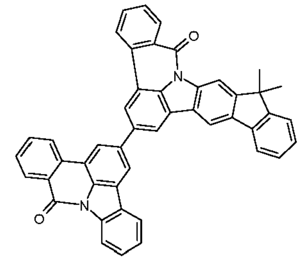 | 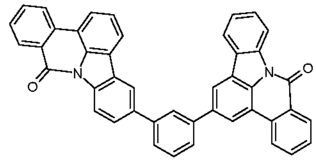 | 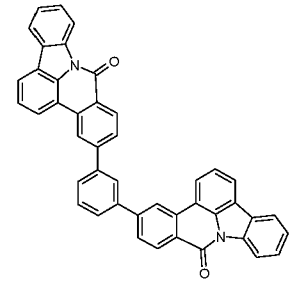 |
| 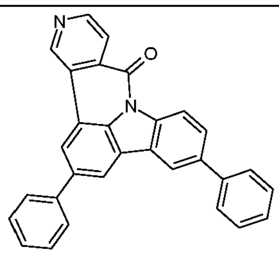 | | |

Weiterhin sind aromatische Ketone oder aromatische Phosphinoxide als elektronenleitende Verbindung bekannt. Unter einem aromatischen Keton wird eine Carbonylgruppe verstanden, an die zwei aromatische oder heteroaromatische Gruppen bzw. aromatische oder heteroaromatische Ringsysteme direkt gebunden sind. Unter einem aromatischen Phosphinoxid im Sinne dieser Anmeldung wird eine P=O Gruppe verstanden, an die drei aromatische oder heteroaromatische Gruppen bzw. aromatische oder heteroaromatische Ringsysteme direkt gebunden sind

Wenn eine elektronenleitende Verbindung ein aromatisches Keton oder ein aromatisches Phosphinoxid ist, dann kann diese Verbindung ausgewählt werden aus den Verbindungen der folgenden Formeln (70) bzw. (71)

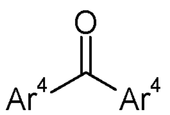

Formel (70)

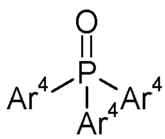

Formel (71)

wobei R, $R^1$, $R^2$ und Ar die oben aufgeführten Bedeutungen hat und für die weiteren verwendeten Symbole gilt:

$Ar^4$ ist bei jedem Auftreten gleich oder verschieden ein aromatisches oder heteroaromatisches Ringsystem mit 5 bis 80 aromatischen Ringatomen, bevorzugt bis 60 aromatischen Ringatomen, welches jeweils mit einer oder mehreren Gruppen R substituiert sein kann.

Geeignete Verbindungen gemäß Formel (70) und (71) sind insbesondere die in WO 2004/093207 und WO 2010/006680 offenbarten Ketone und die in WO 2005/003253 offenbarten Phosphinoxide.

Aus der Definition der Verbindung gemäß Formel (70) und (70) geht hervor, dass diese nicht nur eine Carbonylgruppe bzw. Phosphinoxidgruppe enthalten muss, sondern auch mehrere dieser Gruppen enthalten kann.

Bevorzugt ist die Gruppe $Ar^4$ in Verbindungen gemäß Formel (70) bzw. (71) ein aromatisches Ringsystem mit 6 bis 40 aromatischen Ringatomen, d. h. sie enthält keine Heteroarvlaruppen. Wie oben definiert, muss das aromatische Ringsystem nicht notwendigerweise nur aromatische Gruppen aufweisen, sondern es können auch zwei Arylgruppen

durch eine nicht-aromatische Gruppe, beispielsweise durch eine weitere Carbonylgruppe bzw. Phosphinoxidgruppe unterbrochen sein.

In einer weiteren Ausführungsform weist die Gruppe $Ar^4$ nicht mehr als zwei kondensierte Ringe auf. Sie ist also bevorzugt nur aus Phenyl- und/oder Naphthylgruppen, besonders bevorzugt nur aus Phenylgruppen, aufgebaut, enthält aber keine größeren kondensierten Aromaten, wie beispielsweise Anthracen.

Bevorzugte Gruppen $Ar^4$, die an die Carbonylgruppe gebunden sind, sind gleich oder verschieden bei jedem Auftreten Phenyl, 2-, 3- oder 4-Tolyl, 3- oder 4-o-Xylyl, 2- oder 4-m-Xylyl, 2-p-Xylyl, o-, m- oder p-tert-Butylphenyl, o-, m- oder p-Fluorphenyl, Benzophenon, 1-, 2- oder 3-Phenylmethanon, 2-, 3- oder 4-Biphenyl, 2-, 3- oder 4-o-Terphenyl, 2-, 3- oder 4-m-Terphenyl, 2-, 3- oder 4-p-Terphenyl, 2'-p-Terphenyl, 2'-, 4'- oder 5'-m-Terphenyl, 3'- oder 4'-o-Terphenyl, p-, m,p-, o,p-, m,m-, o,m- oder o,o-Quaterphenyl, Quinquephenyl, Sexiphenyl, 1-, 2-, 3- oder 4-Fluorenyl, 2-, 3- oder 4-Spiro-9,9'-bifluorenyl, 1-, 2-, 3- oder 4-(9,10-Dihydro)phenanthrenyl, 1- oder 2-Naphthyl, 2-, 3-, 4-, 5-, 6-, 7- oder 8-Chinolinyl, 1-, 3-, 4-, 5-, 6-, 7- oder 8-iso-Chinolinyl, 1- oder 2-(4-Methylnaphthyl), 1- oder 2-(4-Phenylnaphthyl), 1- oder 2-(4-Naphthyl-naphthyl), 1-, 2- oder 3-(4-naphthyl-phenyl), 2-, 3- oder 4-Pyridyl, 2-, 4- oder 5-Pyrimidinyl, 2- oder 3-Pyrazinyl, 3- oder 4-Pyridanzinyl, 2-(1,3,5-Triazin)yl-, 2-, 3- oder 4-(Phenylpyridyl), 3-, 4-, 5- oder 6-(2,2'-Bipyridyl), 2-, 4-, 5- oder 6-(3,3'-Bipyridyl), 2- oder 3-(4,4'-Bipyridyl) und Kombinationen eines oder mehrerer dieser Reste.

Die Gruppen $Ar^4$ können durch einen oder mehrere Reste R substituiert sein. Diese Reste R sind bevorzugt gleich oder verschieden bei jedem Auftreten qewählt aus der Gruppe bestehend aus H, D, F, C(=O)Ar, $P(=O)(Ar)_2$, S(=O)Ar, $S(=O)_2Ar$, einer geradkettigen Alkylgruppe mit 1 bis 4 C-Atomen oder einer verzweigten oder cyclischen Alkylgruppe mit 3 bis 5 C-Atomen, die jeweils mit einem oder mehreren Resten $R^1$ substituiert sein kann, wobei ein oder mehrere H-Atome durch F ersetzt sein können, oder einem aromatischen Ringsystem mit 6 bis 24 aromatischen Ringatomen, das durch einen oder mehrere Reste $R^1$ substituiert sein kann, oder eine Kombination dieser Systeme; dabei können zwei oder mehrere benachbarte Substituenten R auch miteinander ein mono- oder polycyclisches, aliphatisches oder aromatisches Ringsystem bilden. Wenn die organische Elektrolumineszenzvorrichtung aus Lösung aufgebracht wird, sind auch geradkettige, verzweigte oder cyclische Alkylgruppen mit bis zu 10 C-Atomen als Substituenten R bevorzugt. Die Reste R sind besonders bevorzugt gleich oder verschieden bei jedem Auftreten gewählt aus der Gruppe bestehend aus H, C(=O)Ar oder einem aromatischen Ringsystem mit 6 bis 24 aromatischen Ringatomen, das durch einen oder mehrere Reste $R^1$ substituiert sein kann, bevorzugt aber unsubstituiert ist.

In einer Ausführungsform ist die Gruppe Ar gleich oder verschieden bei jedem Auftreten ein aromatisches Ringsystem mit 6 bis 24 aromatischen Ringatomen, das mit einem oder mehreren Resten $R^1$ substituiert sein kann. Besonders bevorzugt ist Ar gleich oder verschieden bei jedem Auftreten ein aromatisches Ringsystem mit 6 bis 12 aromatischen Ringatomen.

Bevorzugt sind weiterhin Benzophenon-Derivate, die jeweils an den 3.5.3'.5'-Positionen durch ein aromatisches oder heteroaromatisches Ringsystem mit 5 bis 30 aromatischen Ringatomen substituiert sind, welche wiederum durch einen oder mehrere Reste R gemäß der obigen Definition substituiert sein kann. Weiterhin bevorzugt sind Ketone, welche mit mindestens einer Spirobifluorengruppe substituiert sind.

Bevorzugte nicht erfinderische aromatische Ketone und Phosphinoxide sind daher die Verbindungen der folgenden Formel (72) bis (75),

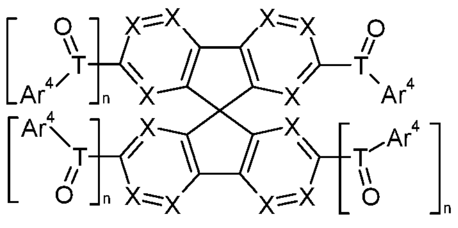

Formel (72)

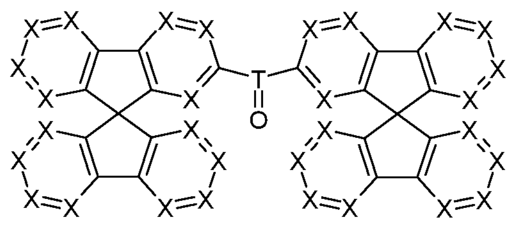

Formel (73)

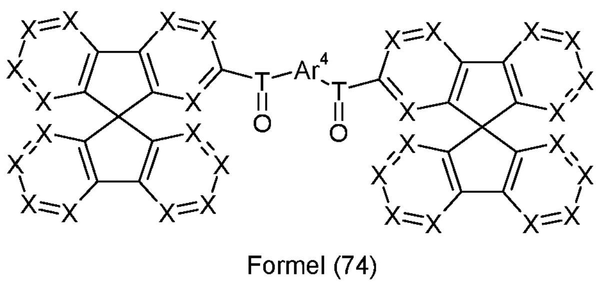

Formel (74)

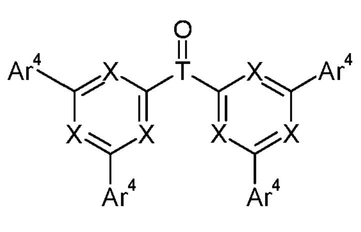

Formel (75)

wobei X, $Ar^4$, R, $R^1$ und $R^2$ dieselbe Bedeutung haben, wie oben beschrieben, und weiterhin gilt:

T ist gleich oder verschieden bei jedem Auftreten C oder $P(Ar^4)$;
n ist gleich oder verschieden bei jedem Auftreten 0 oder 1.

Bevorzugt steht $Ar^4$ in der oben genannten Formel (72) und (75) für ein aromatisches oder heteroaromatisches Ringsystem mit 5 bis 30 aromatischen Ringatomen, welches mit einem oder mehreren Resten $R^1$ substituiert sein kann. Besonders bevorzugt sind die oben genannten Gruppen $Ar^4$.

Beispiele für Verbindungen gemäß Formel (70) und (71) sind die in der folgenden Tabelle abgebildeten Verbindungen.

| | |
|---|---|
| 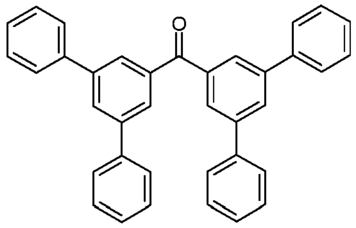 | 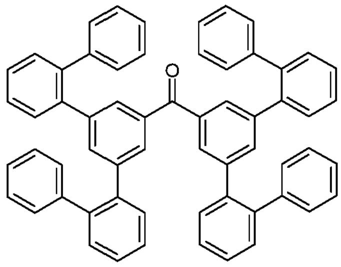 |
| 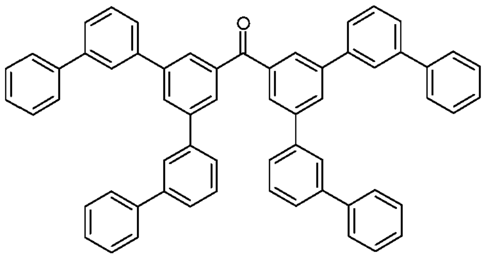 | 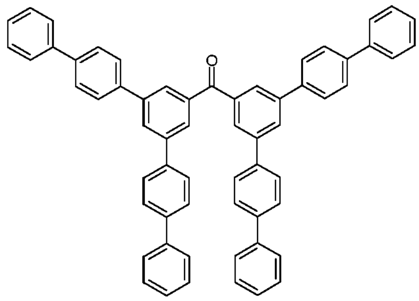 |
| 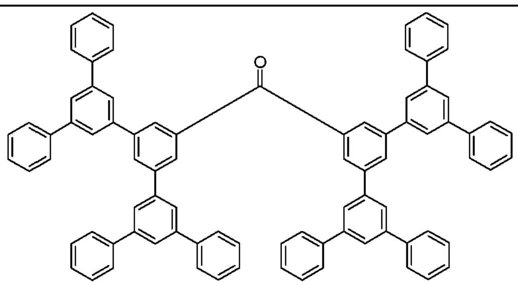 | 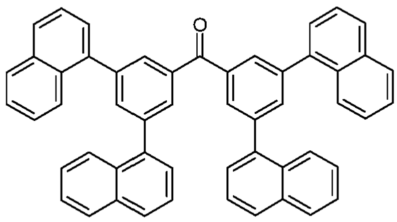 |
| 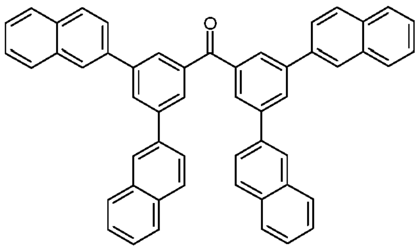 | 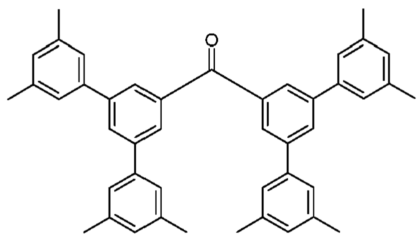 |

| | |
|---|---|
| 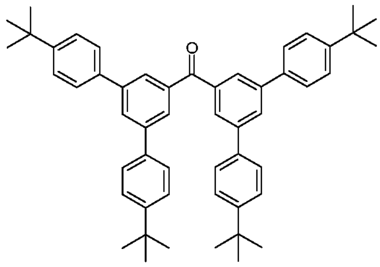 | 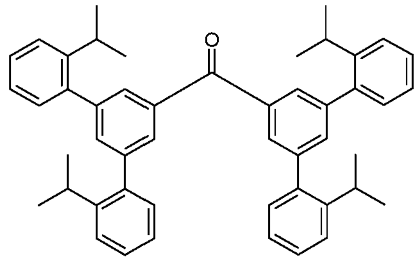 |
| 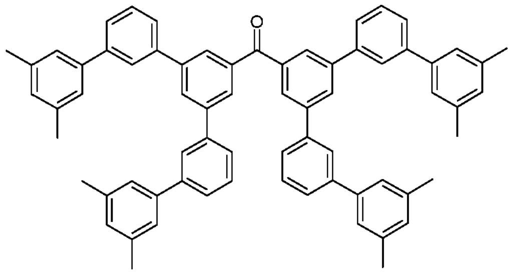 | 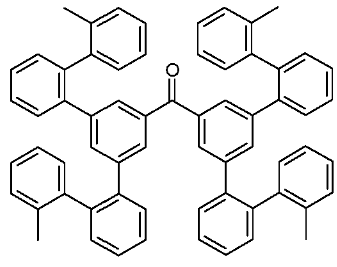 |
| 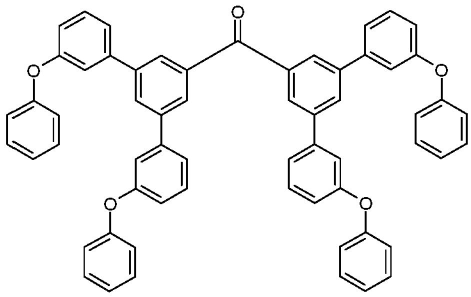 | 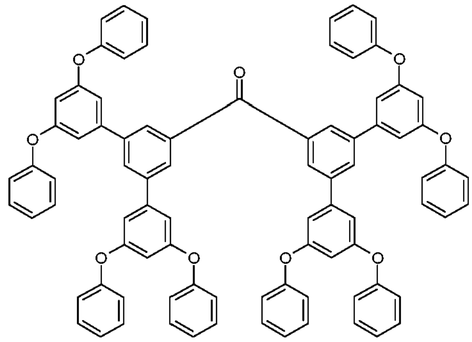 |
| 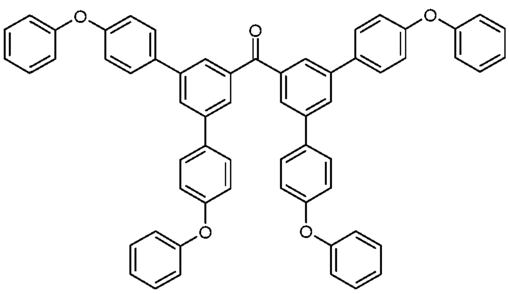 | 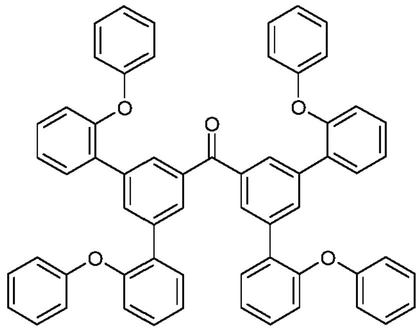 |
| 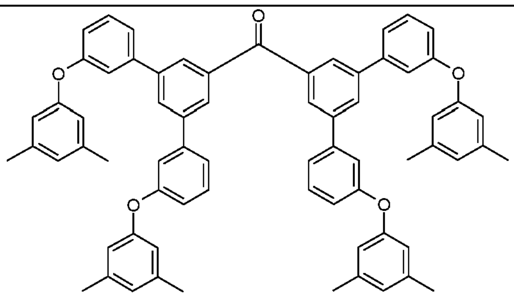 | 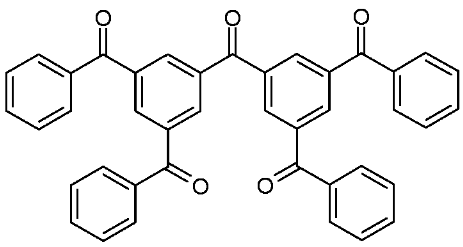 |

| | |
|---|---|
| 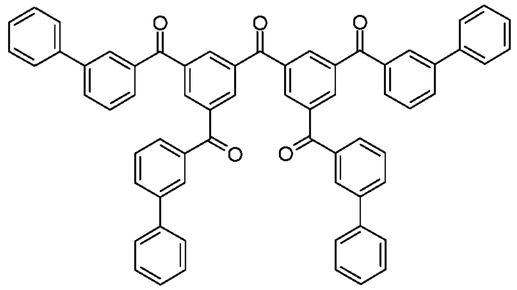 | 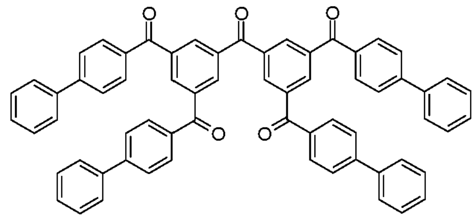 |
| 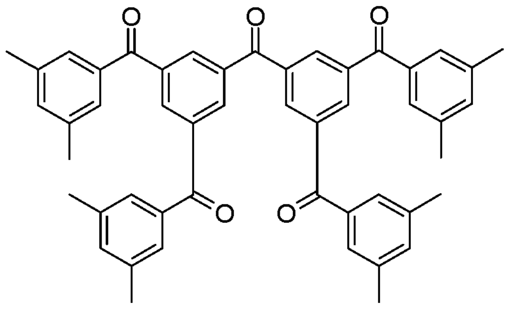 | 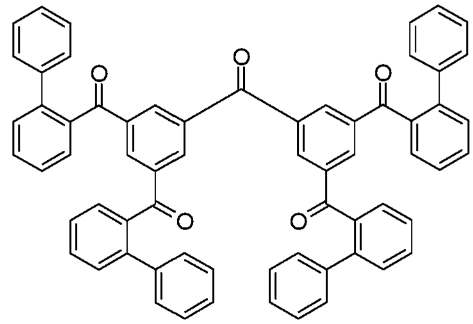 |
| 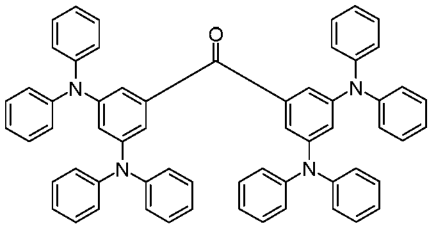 | 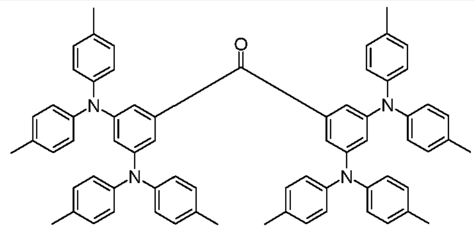 |
| 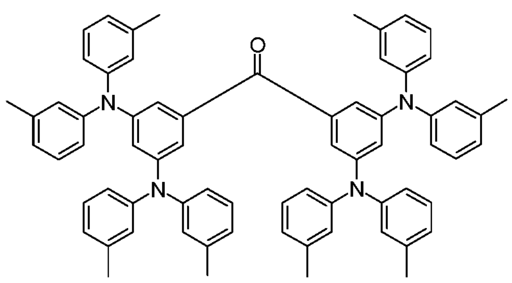 | 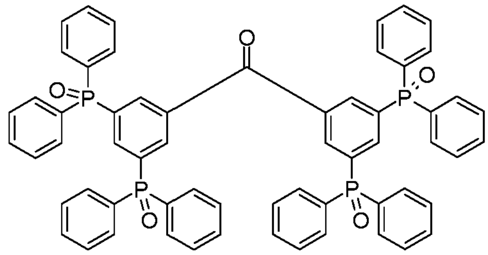 |
| 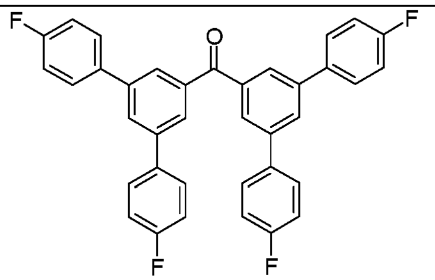 | 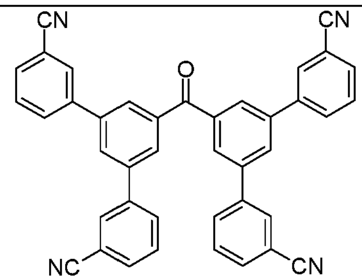 |
| 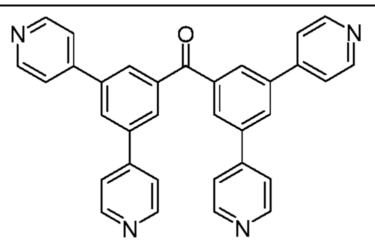 | 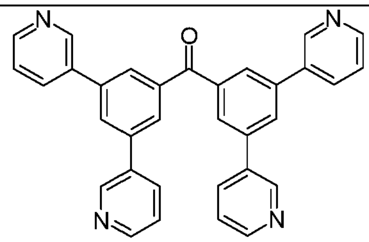 |

| | |
|---|---|
| 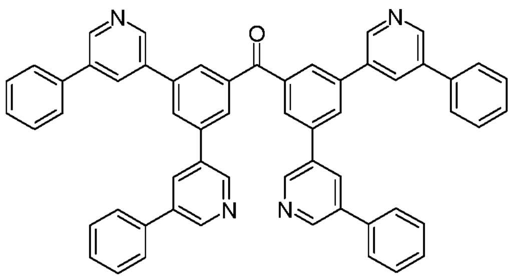 | 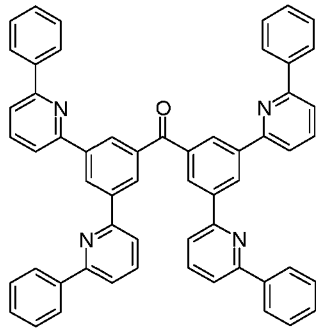 |
| 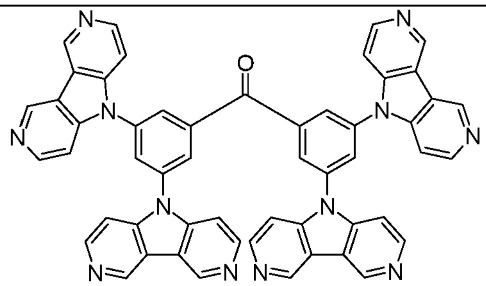 | 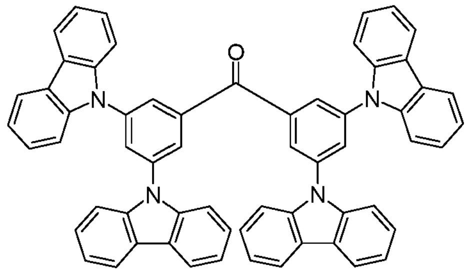 |
| 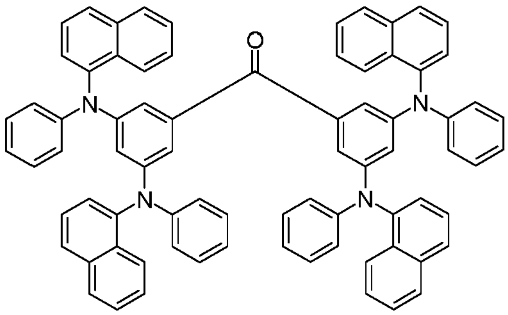 | 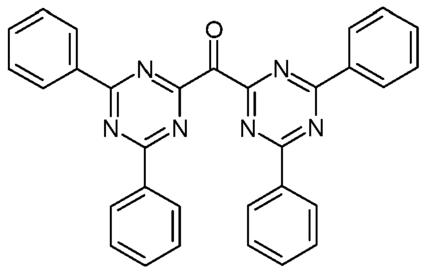 |
| 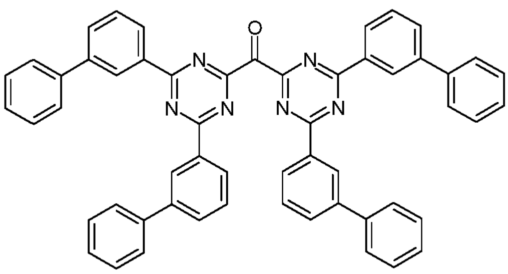 | 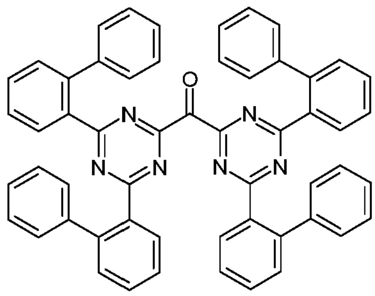 |
| 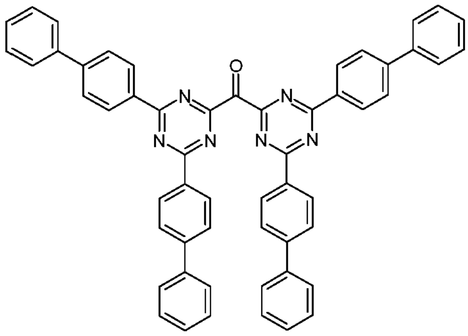 | 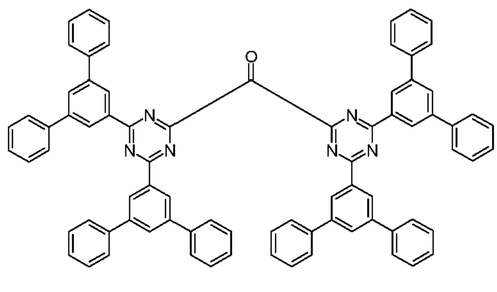 |

| | |
|---|---|
| 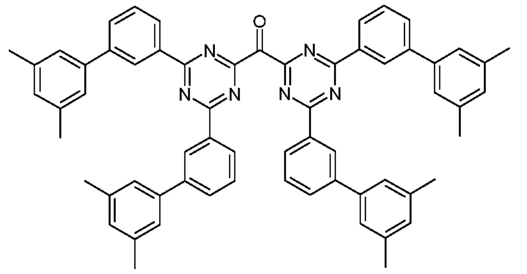 | 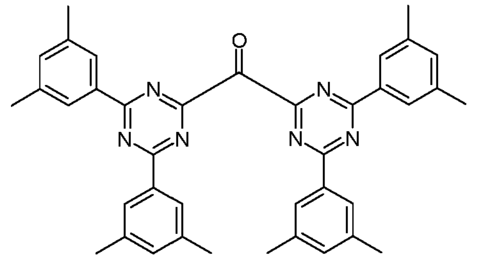 |
| 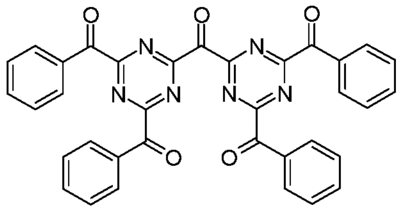 | 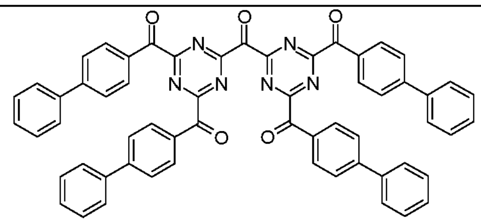 |
| 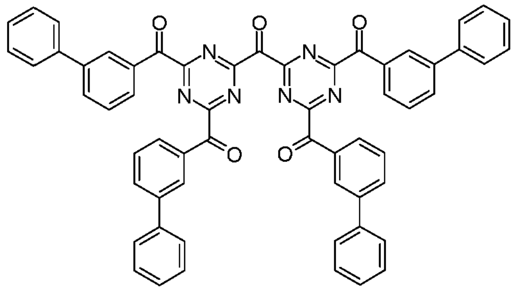 | 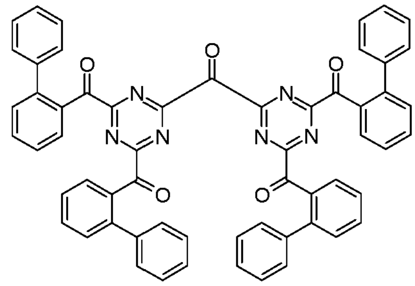 |
| 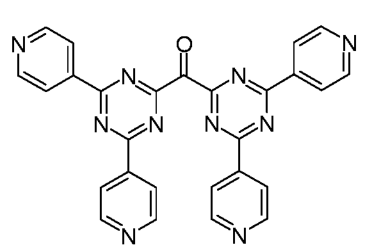 | 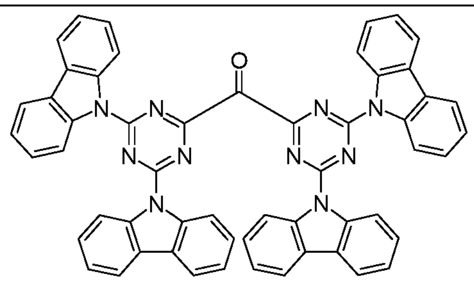 |
| 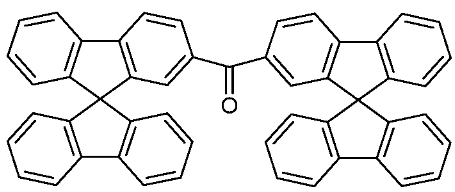 | 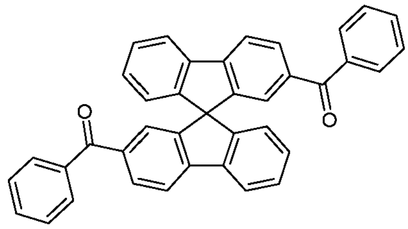 |
| 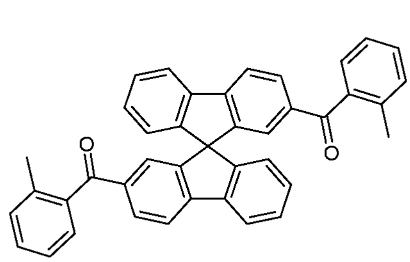 | 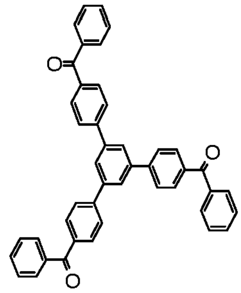 |

| | |
|---|---|
| 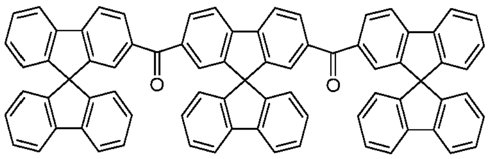 | 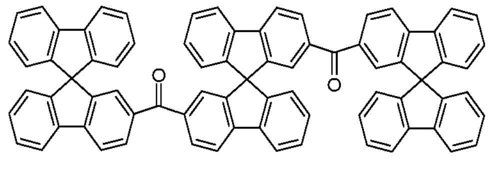 |
| 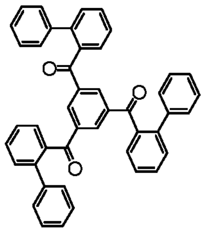 | 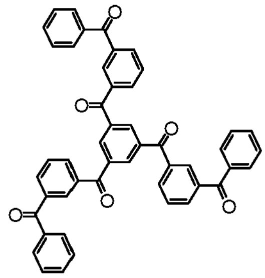 |
| 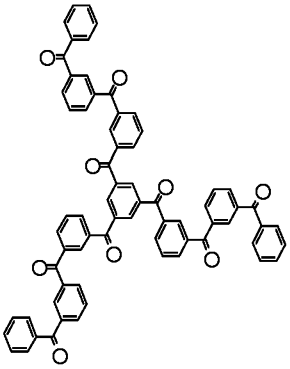 | 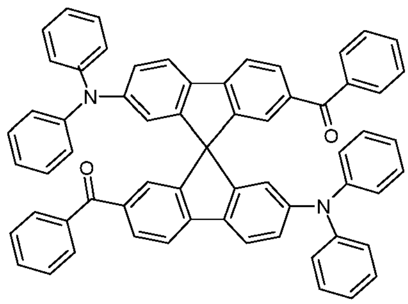 |
| 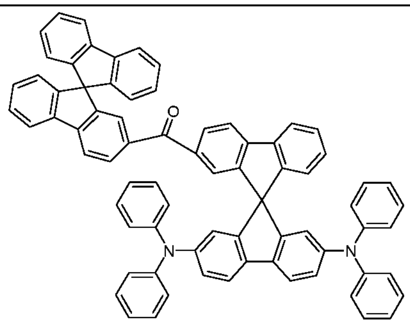 | |

Beispiele für aromatische Phosphinoxidderivate sind die im Folgenden abgebildeten Verbindungen.

| | |
|---|---|
| 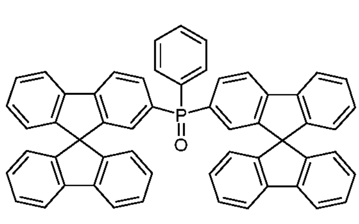 | 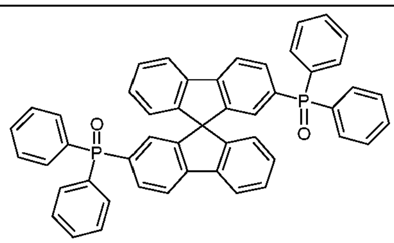 |

| | |
|---|---|
| 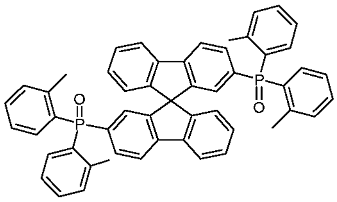 | 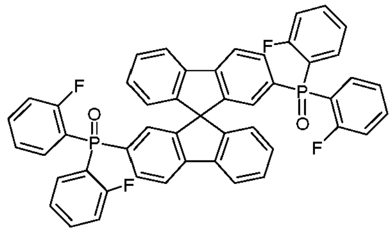 |
| 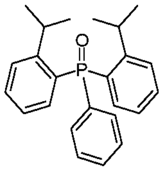 | 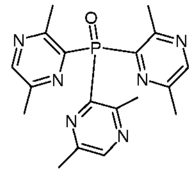 |
| 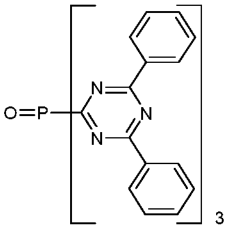 | 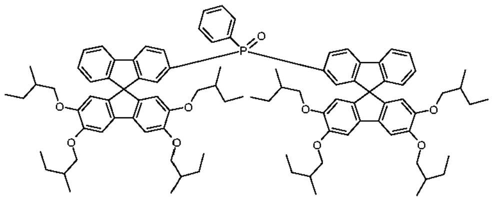 |
| 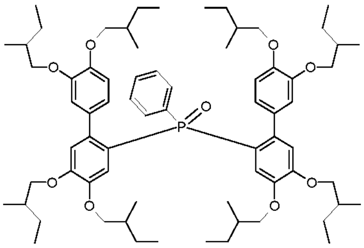 | 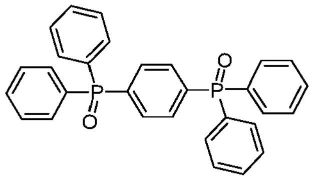 |
| 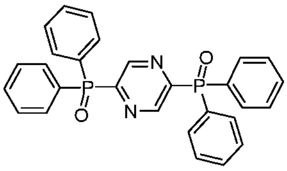 | 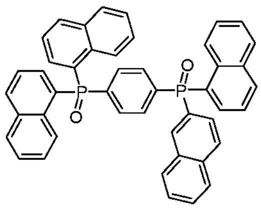 |
| 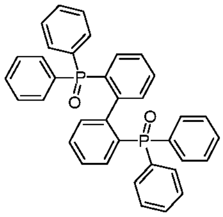 | 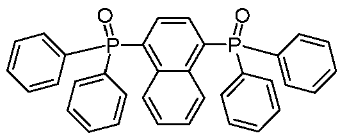 |
| 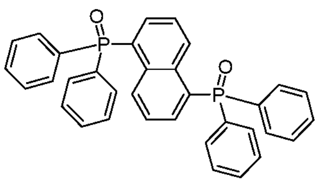 | 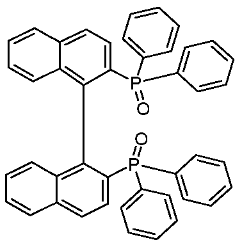 |

| | |
|---|---|
| 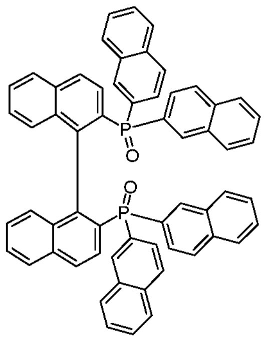 | |

Metallkomplexe, die als Matrixmaterial in organischen Elektrolumineszenzvorrichtung eingesetzt werden können, sind Be-, Zn- bzw. Al-Komplexe. Geeignet sind beispielsweise die in WO 2009/062578 offenbarten Zn-Komplexe.

Beispiele für nicht erfinderische sind die in der folgenden Tabelle aufgeführten Komplexe.

| | | |
|---|---|---|
| 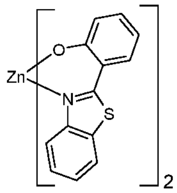 | 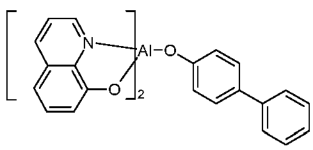 | 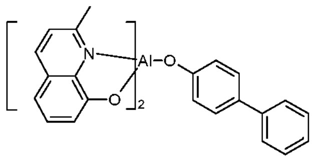 |
| 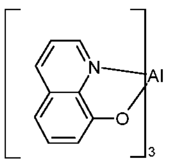 | 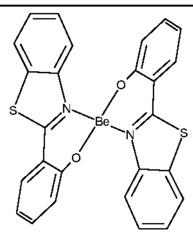 | 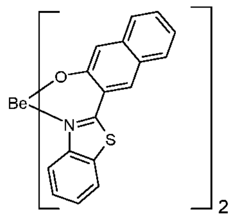 |
| 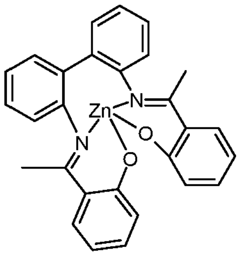 | 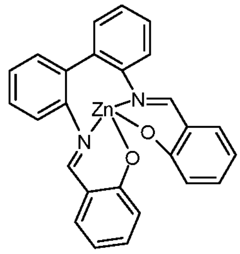 | 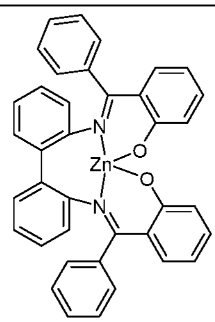 |

| | | |
|---|---|---|
| 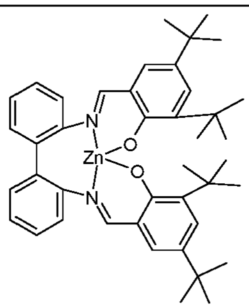 | | |

Azaphosphole, die als nicht erfinderisches Matrixmaterial in organischen Elektrolumineszenzvorrichtung eingesetzt werden können, sind solche Verbindungen, wie sie in WO 2010/054730 offenbart sind.

Azaborole, die als nicht erfinderisches Matrixmaterial in organischen Elektrolumineszenzvorrichtung eingesetzt

werden können, sind insbesondere Azaborolderivate, welche mit mindestens einem elektronenleitenden Substituenten substituiert sind. Solche Verbindungen sind in der noch nicht offen gelegten Anmeldung EP 11010103.7 offenbart.

Matrixverbindungen sind weiterhin die Verbindungen der folgenden Formel (76),

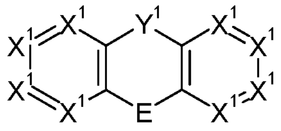

Formel (76)

wobei R, Z und E wie oben definiert sind und für die weiteren verwendeten Symbole gilt:

$X^1$ ist bei jedem Auftreten gleich oder verschieden CR oder N oder eine Gruppe $X^1$-$X^1$ steht für eine Gruppe der folgenden Formel (77), mit der Maßgabe, dass in der Verbindung der Formel (76) mindestens eine Gruppe $X^1$-$X^1$ für eine Gruppe der Formel (77) steht und dass pro Cyclus maximal eine Gruppe $X^1$-$X^1$ für eine Gruppe der Formel (77) steht,

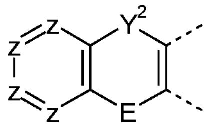

Formel (77)

wobei die C-Atome mit den gestrichelten Bindungen die Bindung der Gruppe andeuten;

$Y^1$, $Y^2$ ist bei jedem Auftreten gleich oder verschieden ausgewählt aus der Gruppe bestehend aus $CR_2$, NR, O, S, $SiR_2$, BR, PR und P(=O)R.

Diese Verbindungen können, je nach genauer Struktur und Substitution, lochtransportierend, elektronentransportierend, bipolar oder weder lochnoch elektronentransportierend sein.

Die Gruppe $X^1$-$X^1$ ist hier mit einer Einfachbindung angedeutet. Da die Gruppe $X^1$-$X^1$ in der Verbindung der Formel (77) jedoch in einer aromatischen Gruppe gebunden ist, ist offensichtlich, dass hiermit eine aromatische Bindung gemeint ist, d. h. der Bindungsgrad der Bindung zwischen den beiden Atomen $X^1$ liegt zwischen 1 und 2. Dabei ist die Gruppe der Formel (77) in beliebigen Positionen gebunden, und die Gruppen $Y^1$ und $Y^2$ können entweder in cis- oder in trans-Konfiguration zueinander stehen. Die Gruppen $X^1$, die nicht für eine Gruppe der Formel (77) stehen, stehen gleich oder verschieden bei jedem Auftreten für CR oder N.

In einer nicht erfinderischen Ausführungsform ist E bei jedem Auftreten gleich oder verschieden ausgewählt aus der Gruppe bestehend aus einer Einfachbindung, $CR_2$, NR, O oder S. Besonders bevorzugt steht E für eine Einfachbindung.

Verbindungen der Formel (76) sind die Verbindungen der folgenden Formeln (78) bis (84),

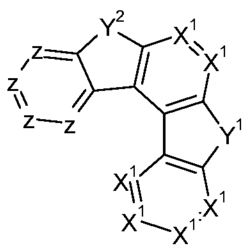

Formel (78)

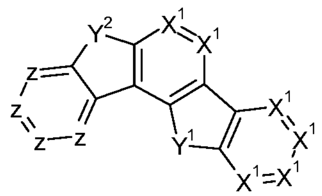

Formel (79)

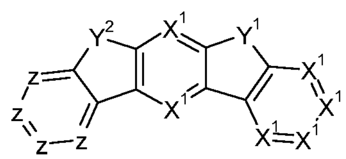

Formel (80)

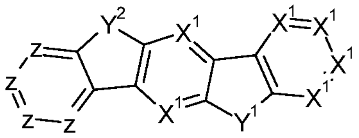
Formel (81)

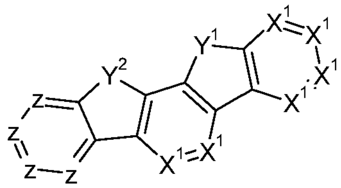
Formel (82)

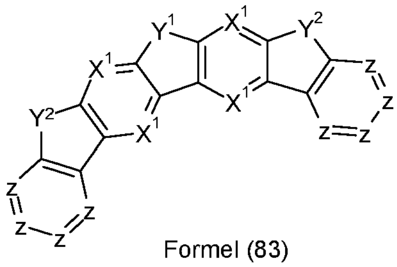
Formel (83)

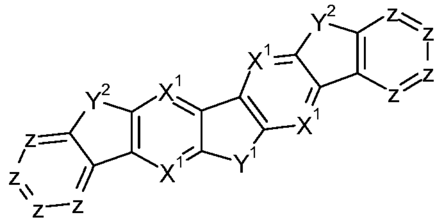
Formel (84)

wobei Z, $Y^1$, $Y^2$, R, $R^1$ und $R^2$ die oben Genannten Bedeutungen aufweisen und weiterhin gilt:
$X^1$ ist bei jedem Auftreten gleich oder verschieden CR oder N.

In Gruppen der oben genannten Formeln (76) und (78) bis (84) stehen maximal zwei Symbole $X^1$ pro Cyclus für N, besonders bevorzugt steht maximal ein Symbol $X^1$ pro Cyclus für N. Ganz besonders bevorzugt steht das Symbol $X^1$ gleich oder verschieden bei jedem Auftreten für CR.

In Gruppen der oben genannten Formeln (77) bis (84) stehen maximal zwei Symbole Z pro Cyclus für N, besonders bevorzugt steht maximal ein Symbol Z pro Cyclus für N. Ganz besonders bevorzugt steht das Symbol Z gleich oder verschieden bei jedem Auftreten für CR. Insbesondere stehen in den Formeln (78) bis (84) alle Symbole $X^1$ und alle Symbole Z gleich oder verschieden für CR.

Nicht erfinderische Ausführungsformen der Formeln (78) bis (84) sind die Verbindungen der folgenden Formeln (78a) bis (84a),

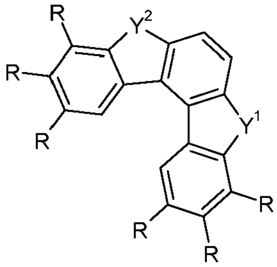
Formel (78a)

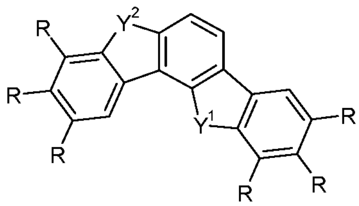
Formel (79a)

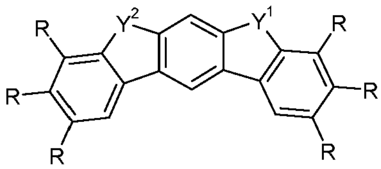
Formel (80a)

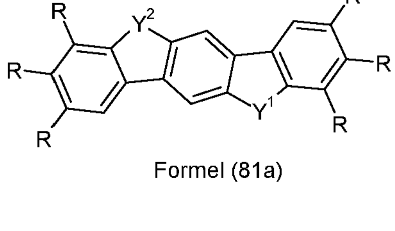
Formel (81a)

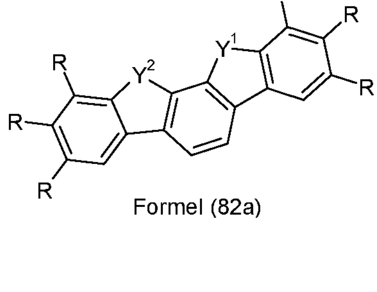
Formel (82a)

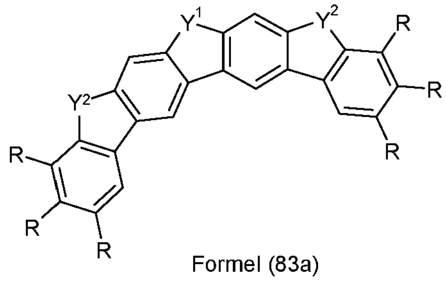

Formel (83a)

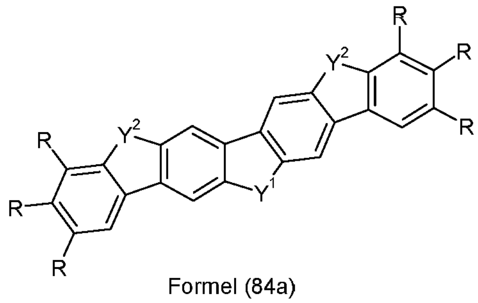

Formel (84a)

wobei die verwendeten Symbole die oben genannten Bedeutungen aufweisen.

In einer weiteren Ausführungsform sind $Y^1$ und $Y^2$ gleich oder verschieden bei jedem Auftreten ausgewählt aus der Gruppe bestehend aus $CR_2$, NR, O oder S.

In den Gruppen der Formel (76) bzw. (78) bis (84) bzw. (78a) bis (84a) kommen für die Gruppen $Y^1$ und $Y^2$ alle Kombinationen in Frage. Bevorzugt steht mindestens eine Gruppe $Y^1$ und/oder $Y^2$ für ein Heteroatom, d. h. bevorzugt ist mindestens eine der Gruppen $Y^1$ und/oder $Y^2$ von $CR_2$ verschieden.

Geeignete Kombinationen aus $Y^1$ und $Y^2$ sind die in der folgenden Tabelle aufgeführten Kombinationen.

| $Y^1$ | $Y^2$ |
|---|---|
| $CR_2$ | $CR_2$ |
| $CR_2$ | NR |
| $CR_2$ | O |
| $CR_2$ | S |
| NR | $CR_2$ |
| NR | NR |
| NR | O |
| NR | S |
| O | $CR_2$ |
| O | NR |
| O | O |
| O | S |
| S | $CR_2$ |
| S | NR |
| S | O |
| S | S |

Bevorzugt sind Verbindungen der Formel (76) bzw. (78) bis (84) bzw. (78a) bis (84a), in denen eine der Gruppen $Y^1$ bzw. $Y^2$ für $CR_2$ steht und die andere der Gruppen $Y^1$ bzw. $Y^2$ für NR steht oder in denen beide Gruppen $Y^1$ und $Y^2$ für NR stehen oder in denen beide Gruppen $Y^1$ und $Y^2$ für O stehen.

Wenn $Y^1$ bzw. $Y^2$ für NR steht, steht der Substituent R, der an dieses Stickstoffatom gebunden ist, bevorzugt für ein aromatisches oder heteroaromatisches Ringsystem mit 5 bis 24 aromatischen Ringatomen, welches auch durch einen oder mehrere Reste $R^1$ substituiert sein kann. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. In einer besonders bevorzugten Ausführungsform steht dieser Substituent R gleich oder verschieden bei jedem Auftreten für ein aromatisches oder heteroaromatisches Ringsystem mit 6 bis 24 aromatischen Ringatomen, welches keine kondensierten Arylgruppen aufweist und welches keine kondensierten Heteroarylgruppen, in welchen zwei oder mehr aromatische bzw. heteroaromatische 6-Ring-Gruppen direkt aneinander ankondensiert sind, aufweist und welches jeweils auch durch einen oder mehrere Reste $R^1$ substituiert sein kann. So ist es bevorzugt, wenn R beispielsweise keine Naphthylgruppen oder höhere kondensierte Arylgruppen aufweist und

ebenso keine Chinolingruppen, Acridingruppen, etc.. Dagegen ist es möglich, dass R beispielsweise Carbazolgruppen, Dibenzofurangruppen, Fluorengruppen, etc. aufweist, weil in diesen Strukturen keine 6-Ring-Aromaten bzw. -Heteroaromaten direkt aneinander ankondensiert sind. Bevorzugte Substituenten R sind ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzothiophen, 1-, 2- oder 3-Carbazol. 1-, 2- oder 3-Dibenzofuran. 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren oder Kombinationen aus zwei oder drei dieser Gruppen, welche jeweils mit einem oder mehreren Resten $R^1$ substituiert sein können. Bevorzugte Biphenyl-, Terphenvl- und Quaterphenvlaruppen sind die Strukturen der oben abgebildeten Formeln (Bi-1) bis (Bi-3), (Ter-1) bis (Ter-3) und (Quater-1) bis (Quater-4).

Wenn $Y^1$ bzw. $Y^2$ für $CR_2$ steht, steht R bevorzugt gleich oder verschieden bei iedem Auftreten für eine lineare Alkylgruppe mit 1 bis 10 C-Atomen oder für eine verzweigte oder cyclische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste $R^1$ substituiert sein kann. Dabei können die Reste R auch ein Ringsystem miteinander bilden und so ein Spirosystem aufspannen. Ganz besonders bevorzugt steht R für eine Methylgruppe oder für eine Phenylgruppe.

In einer Ausführungsform steht mindestens eine der Gruppen $Y^1$ und $Y^2$ für NR, und die entsprechende Gruppe R steht für ein aromatisches oder heteroaromatisches Ringsystem, wie oben beschrieben. In diesem Fall kann es auch bevorzugt sein, wenn alle Substituenten R, die am Grundgerüst der Verbindung gemäß Formel (76) bzw. den bevorzugten Ausführungsformen gebunden sind, für H stehen.

In einer weiteren Ausführungsform der Verbindung gemäß

Formel (76) oder den oben ausgeführten Ausführungsformen steht mindestens ein Substituent R, der am Grundgerüst der Verbindung gemäß Formel (76) gebunden ist, für einen Rest ungleich H oder D. Insbesondere ist mindestens einer der in den Formeln (78a) bis (84a) explizit eingezeichneten Reste R ungleich H oder D.

Dieser Substituent R ungleich H oder D steht bevorzugt für ein aromatisches oder heteroaromatisches Ringsystem mit 5 bis 24 aromatischen Ringatomen, welches auch durch einen oder mehrere Reste $R^1$ substituiert sein kann Dabei enthalten die aromatischen bzw heteroaromatischen Ringsysteme bevorzugt keine kondensierten Aryl- bzw. Heteroarylgruppen, in denen mehr als zwei aromatische Sechsringe direkt aneinander ankondensiert sind. In einer besonders bevorzugten Ausführungsform steht dieser Substituent R gleich oder verschieden bei jedem Auftreten für ein aromatisches oder heteroaromatisches Rinasystem mit 6 bis 24 aromatischen Ringatomen, welches keine kondensierten Arylgruppen aufweist und welches keine kondensierten Heteroarylgruppen, in welchen zwei oder mehr aromatische bzw. heteroaromatische 6-Ring-Gruppen direkt aneinander ankondensiert sind, aufweist und welches jeweils auch durch einen oder mehrere Reste $R^1$ substituiert sein kann. So ist es bevorzuat, wenn R beispielsweise keine Naphthylgruppen oder höhere kondensierte Arylgruppen aufweist und ebenso keine Chinolingruppen, Acridingruppen, etc.. Dagegen ist es möglich, dass R beispielsweise Carbazolgruppen, Dibenzofurangruppen, Fluorengruppen, etc. aufweist, weil in diesen Strukturen keine 6-Rino-Aromaten bzw. -Heteroaromaten direkt aneinander ankondensiert sind. Bevorzugte Substituenten R sind ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzothiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren oder Kombinationen aus zwei oder drei dieser Gruppen, welche jeweils mit einem oder mehreren Resten $R^1$ substituiert sein können. Bevorzugte Biphenyl-, Terphenyl- und Quaterphenvlqruppen sind die Strukturen der oben abgebildeten Formeln (Bi-1) bis (Bi-3), (Ter-1) bis (Ter-3) und (Quater-1) bis (Quater-4).

In einer Ausführungsform treten die oben genannten Bevorzugungen gleichzeitig auf. Bevorzugt sind also die Verbindungen der Formeln (78a) bis (84a), in denen $Y^1$ und $Y^2$ gleich oder verschieden bei jedem Auftreten ausgewählt sind aus $CR_2$, NR, O oder S, insbesondere in den oben genannten Kombinationen, und in denen für R die oben genannten Bevorzugungen gelten.

Beispiele für nicht erfindungsgemäße Verbindungen gemäß Formel (76) sind die in der folgenden Tabelle aufgeführten Verbindungen. Weitere geeignete Verbindungen sind die oben zu den Verbindungen der Formeln (1) und (2) aufgeführten Strukturen, die gleichzeitig auch Strukturen der Formel (76) enthalten.

| | | |
|---|---|---|
| 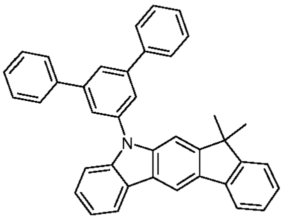 | 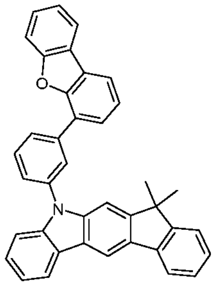 | 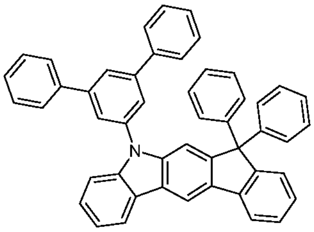 |
| 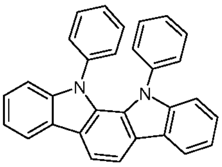 | 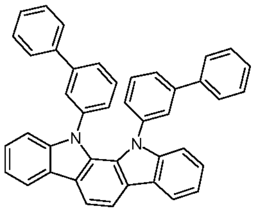 | 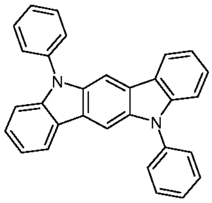 |

| | | |
|---|---|---|
| 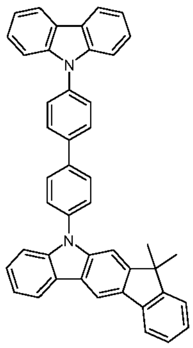 | 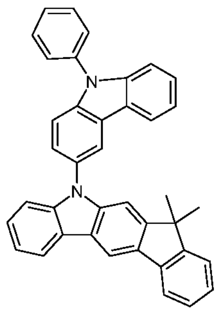 | 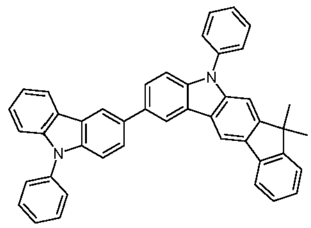 |
| 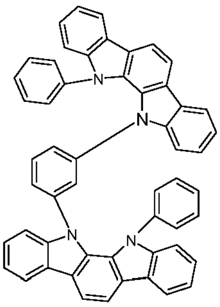 | 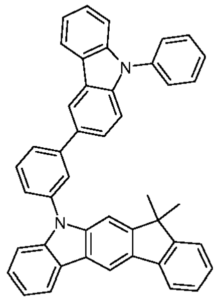 | 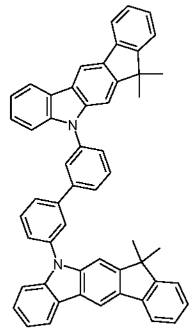 |
| 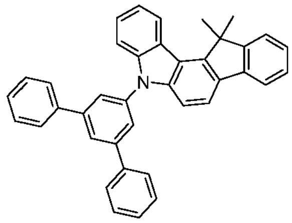 | 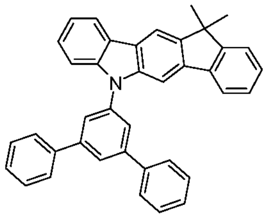 | 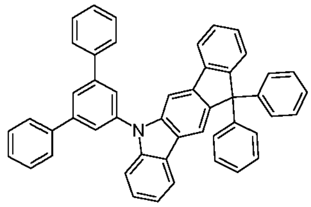 |
| 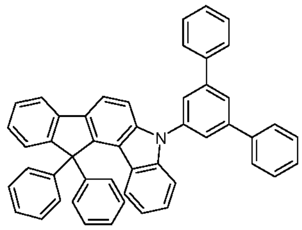 | 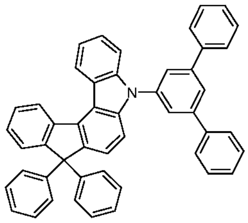 | 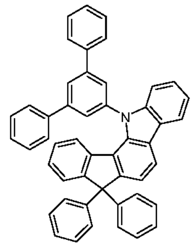 |
| 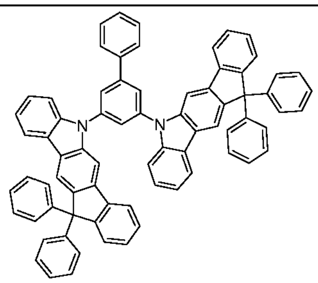 | 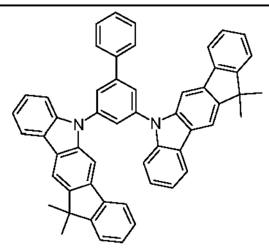 | 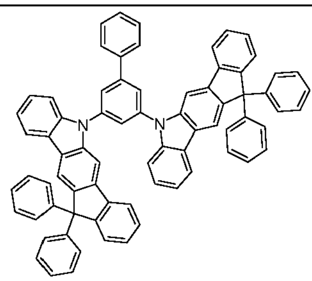 |

| | | |
|---|---|---|
| 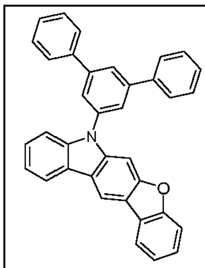 | 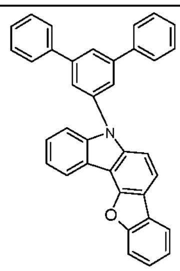 | 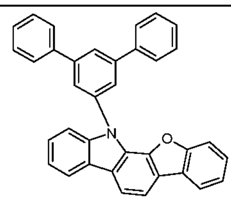 |
| 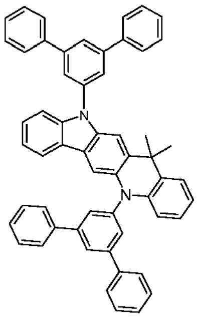 | 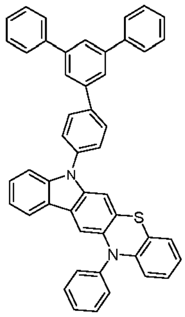 | 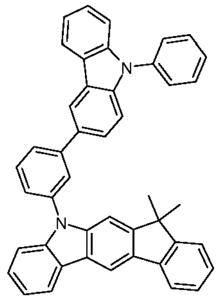 |
| 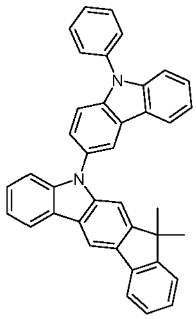 | 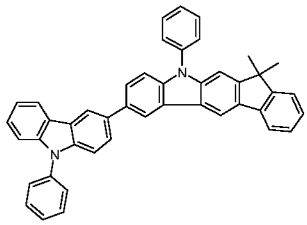 | |

Weitere nicht erfindungsgemäße Matrixverbindungen sind die Matrixverbindungen der folgenden Formeln (85) bis (91),

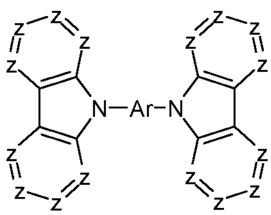

Formel (85)

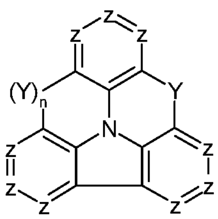

Formel (86)

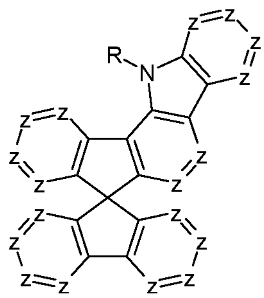

Formel (87)

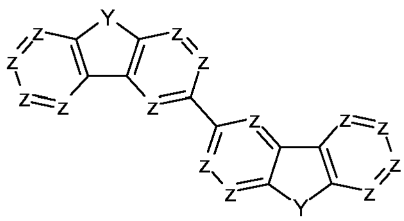

Formel (88)

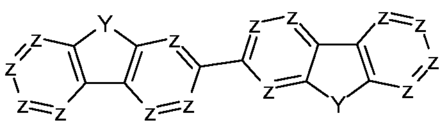

Formel (89)

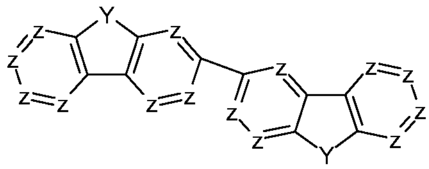

Formel (90)

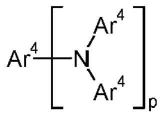

Formel (91)

wobei die verwendeten Symbole und Indizes dieselben Bedeutungen aufweisen, wie oben beschrieben, und p für 1, 2, 3, 4, 5 oder 6 steht, insbesondere für 1, 2 oder 3. Weiterhin können in der Struktur der Formel (91) zwei Gruppen $Ar^4$, die an dasselbe Stickstoffatom binden, durch eine Gruppe, ausgewählt aus NR, O, $CR_2$ oder S, miteinander verbrückt sein. Dabei sind insbesondere die Verbindungen der Formel (91) lochtransportierende Verbindungen.

Weiterhin sind bevorzugte Ausführungsformen der Verbindungen gemäß den Formeln (85) bis (91) solche Verbindungen, in denen die verwendeten Symbole und Indizes die oben aufgeführten bevorzugten Ausführungsformen aufweisen.

Nicht erfindungsgemäße Ausführungsformen der Verbindungen der Formel (85) sind die in der folgenden Tabelle aufgeführten Strukturen.

| | | |
|---|---|---|
| 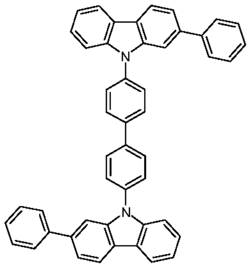 | 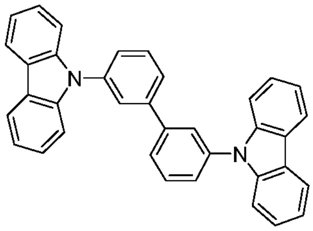 | 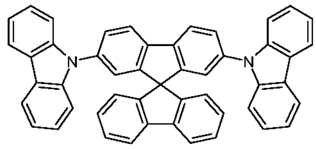 |

| | | |
|---|---|---|
| 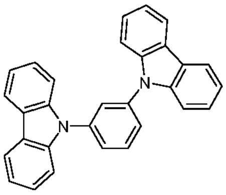 | 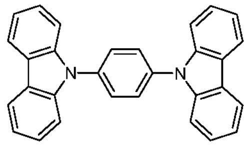 | 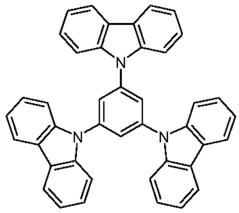 |
| 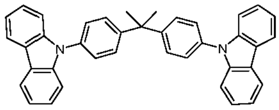 | 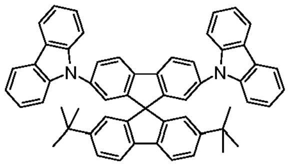 | 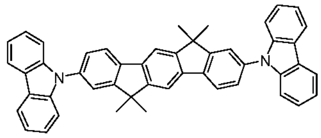 |
| 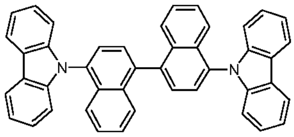 | 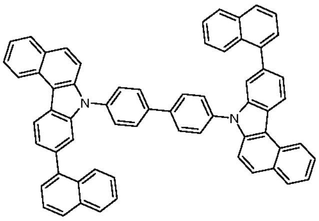 | 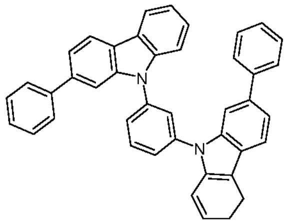 |
| 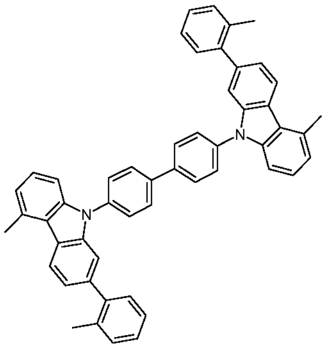 | | |

Weitere nicht erfindungsgemäße Ausführungsformen der Verbindungen der Formel (86) sind die in der folgenden Tabelle aufgeführten Strukturen.

| | | |
|---|---|---|
| 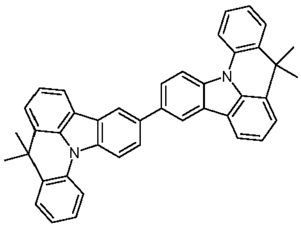 | 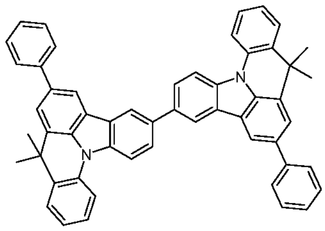 | 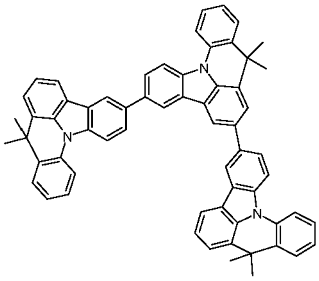 |
| 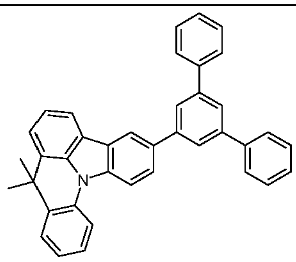 | 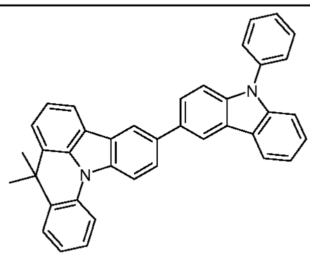 | 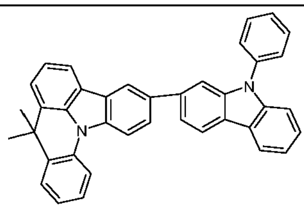 |

Nicht erfindungsgemäße Ausführungsformen der Verbindungen der Formel (87) sind die in der folgenden Tabelle aufgeführten Strukturen.

| | | |
|---|---|---|
| 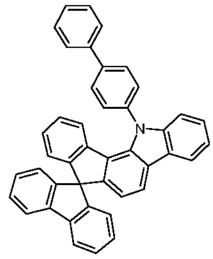 | 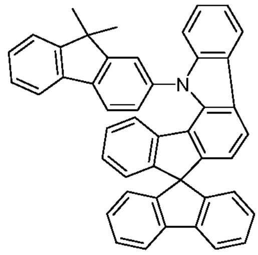 | 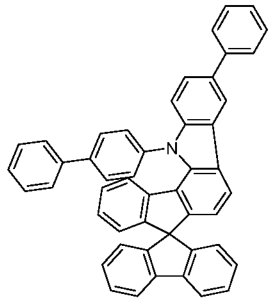 |
| 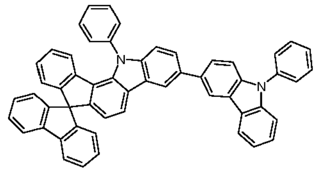 | 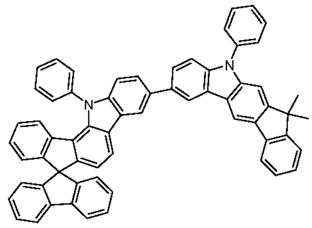 | |

Nicht erfindungsgemäße Ausführungsformen der Verbindungen der Formel (88) bis (90) sind die in der folgenden Tabelle aufgeführten Strukturen.

| | | |
|---|---|---|
| 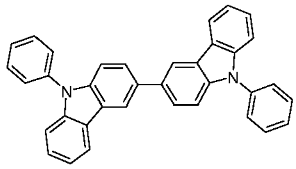 | 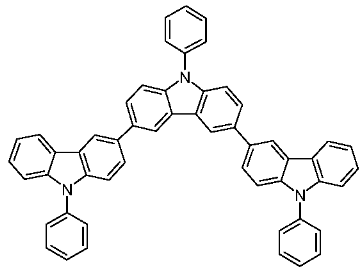 | 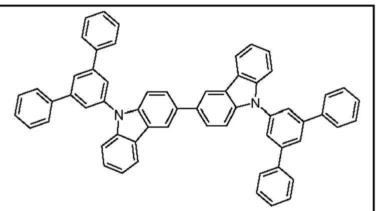 |
| 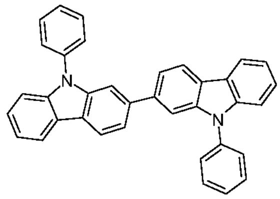 | 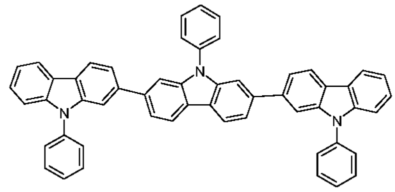 | 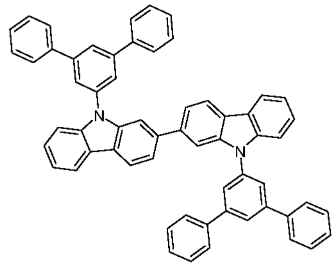 |

| | | |
|---|---|---|
| 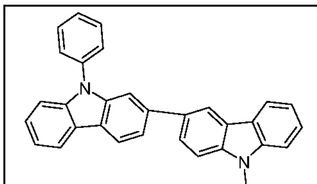 | 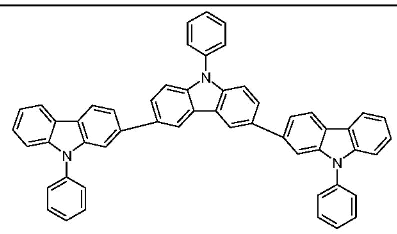 | 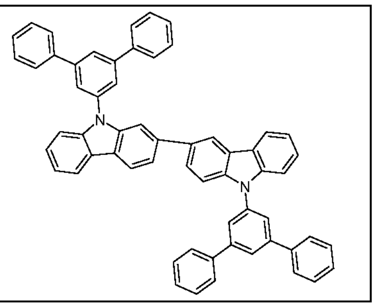 |

Im Folgenden wird die organische Elektrolumineszenzvorrichtung näher beschrieben.

Die organische Elektrolumineszenzvorrichtung enthält Kathode, Anode und emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Es sei aber darauf hingewiesen, dass nicht notwendigerweise jede dieser Schichten vorhanden sein muss.

In den weiteren Schichten der erfindungsgemäßen organischen Elektrolumineszenzvorrichtung, insbesondere in den Lochinjektions- und -transportschichten und in den Elektroneninjektions- und -transportschichten, können alle Materialien verwendet werden, wie sie üblicherweise gemäß dem Stand der Technik eingesetzt werden. Dabei können die Lochtransportschichten auch p-dotiert bzw. die Elektronentransportschichten auch n-dotiert sein. Dabei wird unter einer p-dotierten Schicht eine Schicht verstanden, in der freie Löcher erzeugt werden und deren Leitfähigkeit dadurch erhöht ist. Eine umfassende Diskussion von dotierten Transportschichten in OLEDs findet sich in Chem. Rev. 2007, 107, 1233. Besonders bevorzugt ist der p-Dotand in der Lage, das Lochtransportmaterial in der Lochtransportschicht zu oxidieren, hat also ein ausreichend hohes Redoxpotential, insbesondere ein höheres Redoxpotential als das Lochtransportmaterial. Als Dotanden sind prinzipiell alle Verbindungen geeignet, welche Elektronenakzeptorverbindungen darstellen und die Leitfähigkeit der organischen Schicht durch Oxidation des Hosts erhöhen können. Der Fachmann kann im Rahmen seines allgemeinen Fachwissens ohne größeren Aufwand geeignete Verbindungen identifizieren. Insbesondere geeignet als Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709 und US 2010/0096600 offenbarten Verbindungen.

Der Fachmann kann daher ohne erfinderisches Zutun alle für organische Elektrolumineszenzvorrichtungen bekannten Materialien in Kombination mit der erfindungsgemäßen emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/$NiO_x$, Al/$PtO_x$) bevorzugt sein. Dabei muss mindestens eine der Elektroden transparent oder teiltransparent sein, um die Auskopplung von Licht zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden. Diese Verfahren eignen sich insbesondere auch für Oligomere, Dendrimere und Polymere.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Ein weiterer Gegenstand der vorliegenden Erfindung ist daher ein Verfahren zur Herstellung einer erfindungsgemäßen organischen Elektrolumineszenzvorrichtung, dadurch gekennzeichnet, dass mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

Die erfindungsgemäßen organischen Elektrolumineszenzvorrichtungen zeichnen sich durch einen oder mehrere der folgenden überraschenden Vorteile gegenüber dem Stand der Technik aus:

1. Die erfindungsgemäßen organischen Elektrolumineszenzvorrichtungen weisen gegenüber Vorrichtungen gemäß dem Stand der Technik eine verbesserte Lebensdauer auf.

2. Die erfindungsgemäßen organischen Elektrolumineszenzvorrichtungen weisen eine höhere Effizienz auf.

3. Die erfindungsgemäßen organischen Elektrolumineszenzvorrichtungen weisen eine geringere Spannung auf.

4. Die erfindungsgemäßen organischen Elektrolumineszenzvorrichtungen weisen ein verbessertes Roll-off-Verhalten auf.

Diese oben genannten Vorteile ergeben sich im direkten Vergleich mit organischen Elektrolumineszenzvorrichtungen, welche ansonsten denselben Aufbau aufweisen und dieselben Materialien enthalten, welche aber dieselbe TADF-Verbindung in einer geringeren Dotierkonzentration enthalten.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

**Beispiele:**

**Bestimmung von HOMO, LUMO, Singulett- und Triplettniveau**

Die HOMO- und LUMO-Energieniveaus sowie die Energie des niedrigsten Triplettzustands $T_1$ bzw. des niedrigsten angeregten Singulettzustands $S_1$ der Materialien werden über quantenchemische Rechnungen bestimmt. Hierzu wird das Programmpaket "Gaussian09W" (Gaussian Inc.) verwendet. Zur Berechnung organischer Substanzen ohne Metalle (in Tabelle 4 mit Methode "org." bezeichnet) wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31 G(d)" verwendet (Charge 0, Spin Singlet). Für metallhaltige Verbindungen (in Tabelle 4 mit Methode "M-org." bezeichnet) wird die Geometrie über die Methode "Ground State/ Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31 G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$\text{HOMO(eV)} = ((\text{HEh}*27.212)-0.9899)/1.1206$$

$$\text{LUMO(eV)} = ((\text{LEh}*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

In Tabelle 4 sind die HOMO- und LUMO-Energieniveaus sowie $S_1$ und $T_1$ der verschiedenen Materialien angegeben.

**Bestimmung der PL-Quanteneffizienz (PLQE)**

Von den in den verschiedenen OLEDs verwendeten Emissionsschichten wird ein 50 nm dicker Film auf ein geeignetes transparentes Substrat, vorzugsweise Quarz, aufgebracht, d. h. die Schicht enthält dieselben Materialien in derselben Konzentration wie in der OLED. Hierbei werden die gleichen Herstellungsbedingungen wie bei der Herstellung

der Emissionsschicht für die OLEDs verwendet. Von diesem Film wird ein Absorptionsspektrum im Wellenlängenbereich von 350-500 nm gemessen. Hierzu wird das Reflexionsspektrum $R(\lambda)$ sowie das Transmissionsspektrum $T(\lambda)$ der Probe unter einem Einfallswinkel von 6° (also nahezu senkrechter Einfall) bestimmt. Als Absorptionsspektrum im Sinne dieser Anmeldung wird $A(\lambda)=1-P(\lambda)-T(\lambda)$ definiert.

Gilt $A(\lambda) \leq 0.3$ im Bereich 350-500 nm, so wird die zum Maximum des Absorptionsspektrums gehörige Wellenlänge im Bereich 350-500 nm als $\lambda_{exc}$ definiert. Gilt für irgendeine Wellenlänge $A(\lambda) > 0.3$, so wird als $\lambda_{exc}$ die größte Wellenlänge definiert, bei der $A(\lambda)$ von einem Wert kleiner 0.3 zu einem Wert größer 0.3 oder von einem Wert größer 0.3 zu einem Wert kleiner 0.3 wechselt.

Zur Bestimmung der PLQE wird ein Messplatz Hamamatsu C9920-02 verwendet. Das Prinzip beruht auf der Anregung der Probe mit Licht definierter Wellenlänge und der Messung der absorbierten und emittierten Strahlung. Die Probe befindet sich während der Messung in einer Ulbrichtkugel ("integrating sphere"). Das Spektrum des Anregungslichts ist in etwa gaußförmig mit einer Halbwertsbreite < 10 nm und Peakwellenlänge $\lambda_{exc}$ wie oben definiert.

Die PLQE wird nach dem für den genannten Messplatz üblichen Auswerteverfahren bestimmt. Es ist strengstens darauf zu achten, dass die Probe zu keinem Zeitpunkt mit Sauerstoff in Berührung kommt, da die PLQE von Materialien mit kleinem energetischen Abstand zwischen $S_1$ und $T_1$ durch Sauerstoff sehr stark reduziert wird (H. Uoyama et al., Nature 2012, Vol. 492, 234).

In Tabelle 2 ist die PLQE für die Emissionsschichten der OLEDs wie oben definiert zusammen mit der verwendeten Anregungswellenlänge angegeben.

### Bestimmung der Abklingzeit

Zur Bestimmung der Abklingzeit wird eine Probe verwendet, die wie oben unter "Bestimmung der PL-Quanteneffizienz (PLQE)" beschrieben hergestellt wird. Die Probe wird bei einer Temperatur von 295 K durch einen Laserpuls angeregt (Wellenlänge 266 nm, Pulsdauer 1.5 ns, Pulsenergie 200 µJ, Strahldurchmesser 4 mm). Die Probe befindet sich hierbei im Vakuum ($<10^{-5}$ mbar). Nach der Anregung (definiert als t = 0) wird der zeitliche Verlauf der Intensität der emittierten Photolumineszenz gemessen. Die Photolumineszenz zeigt am Anfang einen steilen Abfall, der auf die prompte Fluoreszenz der TADF-Verbindung zurückzuführen ist. Im weiteren zeitlichen Verlauf ist ein langsamerer Abfall zu beobachten, die verzögerte Fluoreszenz (siehe z.B. H. Uoyama et al., Nature, vol. 492, no. 7428, pp. 234-238, 2012 sowie K. Masui et al., Organic Electronics, vol. 14, no. 11, pp. 2721-2726, 2013). Die Abklingzeit $t_a$ im Sinne dieser Anmeldung ist die Abklingzeit der verzögerten Fluoreszenz und wird wie folgt bestimmt: Man wählt einen Zeitpunkt $t_d$, zu dem die prompte Fluoreszenz deutlich unter die Intensität der verzögerten Fluoreszenz abgeklungen ist (<1%), so dass die folgende Bestimmung der Abklingzeit davon nicht beeinflusst wird. Diese Wahl kann von einem Fachmann durchgeführt werden. Für die Messdaten ab dem Zeitpunkt $t_d$ wird die Abklingzeit $t_a = t_e - t_d$ bestimmt. Dabei ist $t_e$ derjenige Zeitpunkt nach $t = t_d$, bei dem die Intensität erstmals auf 1/e ihres Wertes bei $t = t_d$ abgefallen ist.

Tabelle 2 zeigt die Werte von $t_a$ und $t_d$, die für die Emissionsschichten der erfindungsgemäßen OLEDs ermittelt werden.

### Bestimmung von Aufdampfraten und Schichtdicken

Zur Herstellung eines Films aus zwei Materialien A und B, in dem das Material A zu X Vol% und Material B zu (100-X) Vol% vorliegt, werden die Aufdampfraten RA für Material A und RB für Material B so eingestellt, dass RA/RB=X/(100-X) gilt. Im Anschluss werden die beiden Materialien zusammen verdampft, bis eine Schicht der gewünschten Dicke erhalten wird. Die Kontrolle der Aufdampfraten erfolgt mit Hilfe von Schwingquarzen. Die Raten RA und RB sind hierbei kalibrierte Aufdampfraten. Um diese Aufdampfraten zu kalibrieren, wird jeweils wie folgt vorgegangen: Eine Schicht des reinen Materials wird durch eine Schattenmaske auf ein Glassubstrat aufgebracht, die hierzu benötigte Zeit wird mit $t_{test}$ bezeichnet, die vom Schwingquarz registrierte Rate mit $R_{test}$. Bei der Beschichtung durch die Schattenmaske bildet sich eine Stufe zwischen beschichtetem und nicht beschichtetem Bereich. Danach wird eine 100 nm dicke Aluminiumschicht aufgebracht, die so ausgebildet ist, dass die Stufe und ein ausreichend großer, daran anschließender Bereich für die anschließende Schichtdickenmessung davon überdeckt ist. Die Schichtdicke D entspricht der Höhe der Stufe zwischen beschichtetem und nicht beschichtetem Bereich, diese wird bestimmt mit Hilfe eines Dektak Profilometers (Auflagekraft 5 mg, Spitzenradius 25 µm). Aus der nun bekannten Schichtdicke D sowie der Aufdampfzeit wird die kalibrierte Rate $R=D/t_{test}$ bestimmt. Liegt die gemessene Schichtdicke unterhalb von 80 nm, so wird die Kalibrierung wiederholt, wobei die Aufdampfzeit nach der Formel $t_{test} = 100$ nm/R angepasst wird.

### Herstellung der OLEDs

In den folgenden Beispielen V1 bis E13 (siehe Tabellen 1 und 2) werden die Daten verschiedener OLEDs vorgestellt.

Glasplättchen, die mit strukturiertem ITO (Indium Zinn Oxid) der Dicke 50 nm beschichtet sind, bilden die Substrate für die OLEDs. Die Substrate werden nass gereinigt (Spülmaschine, Reiniger Merck Extran), anschließend 15 min lang bei 250 °C ausgeheizt und vor der Beschichtung 150s lang mit einem Argonplasma und danach 130s lang mit einem Sauerstoffplasma behandelt (für die Beispiele V1-V7 und E1-E9). Die Glasplättchen für die Beispiele V8-V11 und E10-E13 werden 130s mit einem Sauerstoffplasma behandelt. Diese mit Plasma behandelten Glasplättchen bilden die Substrate, auf welche die OLEDs aufgebracht werden. Die Substrate verbleiben vor der Beschichtung im Vakuum. Die Beschichtung beginnt spätestens 10min nach der Plasmabehandlung.

Die OLEDs haben prinzipiell folgenden Schichtaufbau: Substrat / optionale Lochinjektionsschicht (HIL) / optionale Lochtransportschicht (HTL) / optionale Zwischenschicht (IL) / Elektronenblockerschicht (EBL) / Emissionsschicht (EML) / Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 3 gezeigt.

Alle Materialien werden in einer Vakuumkammer thermisch aufgedampft. Dabei besteht die Emissionsschicht immer aus einem Matrixmaterial (Hostmaterial, Wirtsmaterial) und der TADF-Verbindung, also dem emittierenden Material, das einen kleinen energetischen Abstand zwischen $S_1$ und $T_1$ zeigt. Dieses wird dem Matrixmaterial durch Coverdampfung in einem bestimmten Volumenanteil beigemischt. Eine Angabe wie IC1:D1 (95%:5%) bedeutet hierbei, dass das Material IC1 in einem Volumenanteil von 95% und D1 in einem Anteil von 5% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 × und y Farbkoordinaten berechnet. Die Angabe U1000 in Tabelle 2 bezeichnet die Spannung, die für eine Leuchtdichte von 1000 cd/$m^2$ benötigt wird. SE1000 und LE1000 bezeichnen die Strom- bzw. Leistungseffizienz, die bei 1000 cd/$m^2$ erreicht werden. EQE1000 schließlich bezeichnet die externe Quanteneffizienz bei einer Betriebsleuchtdichte von 1000 cd/$m^2$.

Der Roll-off wird definiert als EQE bei 5000 cd/$m^2$ geteilt durch EQE bei 500 cd/$m^2$, d. h. ein hoher Wert entspricht einem geringen Abfall der Effizienz bei hohen Leuchtdichten, was vorteilhaft ist.

Als Lebensdauer LD wird die Zeit definiert, nach der die Leuchtdichte bei Betrieb mit konstantem Strom von der Startleuchtdichte auf einen gewissen Anteil L1 absinkt. Eine Angabe von j0 = 10mA/$cm^2$, L1 = 80% in Tabelle 2 bedeutet, dass die Leuchtdichte bei Betrieb mit 10 mA/$cm^2$ nach der Zeit LD auf 80% ihres Anfangswertes absinkt.

Als emittierender Dotand in der Emissionsschicht wird die Verbindung D1 eingesetzt, die einen energetischen Abstand zwischen $S_1$ und $T_1$ von 0.09 eV aufweist oder die Verbindung D2, für die Differenz zwischen $S_1$ und $T_1$ 0.06eV beträgt

Die Daten der verschiedenen OLEDs sind in Tabelle 2 zusammengefasst. Die Beispiele V1-V11 sind Vergleichsbeispiele gemäß dem Stand der Technik, die Beispiele E5 und E8 zeigen Daten von erfindungsgemäßen OLEDs. Im folgenden werden einige der Beispiele näher ausgeführt, wobei zu beachten ist, dass dies nur eine Auswahl der in der Tabelle gezeigten Daten darstellt.

Durch Einsatz der TADF-Verbindung in höheren Konzentrationen erhält man eine deutliche Verbesserung der Lebensdauer. Beispielsweise erhält man für Beispiel E4 (10 Vol.-%) eine fast doppelt so hohe Lebensdauer wie für Beispiel V4 (5 Vol.-%). Die sehr gute Effizienz von über 20% EQE bleibt auch bei der höheren Konzentration von 10 Vol.-% der TADF-Verbindung erhalten. Eine nochmalige Steigerung der Lebensdauer ist durch eine Erhöhung der Konzentration auf 15 Vol.-% der TADF-Verbindung möglich.

Durch eine Erhöhung der Konzentration ist es weiterhin möglich, die Effizienz zu verbessern, wie der Vergleich der nicht erfindungsgemäßen

Beispiele E6 mit V5 bzw. E7 mit V6 zeigt.

Das nicht erfindungsgemäße Beispiel E1 und das erfindungsgemässe Beispiel E8 zeigen, dass weiterhin eine Verbesserung der Betriebsspannung erreicht werden kann.

Weiterhin ist auch eine Verbesserung des Roll-Off Verhaltens durch Einsatz höherer Konzentrationen der TADF Verbindung zu beobachten.

Tabelle 1: Aufbau der OLEDs

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| V1 | HAT | --- | --- | SpA1 | IC3:D1 | IC1 | ST2:LiQ | --- |

(fortgesetzt)

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| | 5nm | --- | --- | 85nm | (95%:5%)<br>15μm | 10nm | (50%:50%)<br>40nm | |
| V2 | ---<br>--- | ---<br>--- | ---<br>--- | SpA1<br>90nm | IC4:D1<br>(95%:5%)<br>15μm | IC1<br>10nm | ST2:LiQ<br>(50%:50%)<br>40nm | ---<br>--- |
| V3 | SpMA1:F4T<br>(95%:5%)<br>10nm | ---<br>--- | --- | SpMA1<br>80nm | IC4:D1<br>(95%:5%)<br>15μm | IC1<br>10nm | ST2:LiQ<br>(50%:50%)<br>40nm | ---<br>--- |
| V4 | HAT<br>5nm | SpA1<br>70nm | HAT<br>5nm | SpMA1<br>20nm | IC1:D1<br>(95%:5%)<br>15μm | IC1<br>10nm | ST2:LiQ<br>(50%:50%)<br>40nm | ---<br>--- |
| V5 | SpMA1:F4T<br>(95%:5%)<br>10nm | SpMA1<br>80nm | ---<br>--- | SpMA2<br>10nm | IC1:D1<br>(95%:5%)<br>15μm | IC1<br>10nm | ST2:LiQ<br>(50%:50%)<br>40nm | ---<br>--- |
| V6 | SpMA1:F4T<br>(95%:5%)<br>10nm | SpMA1<br>65nm | IC2<br>10nm | CBP<br>5nm | IC1:D1<br>(95%:5%)<br>15μm | IC1<br>10nm | ST2<br>40nm | LiQ<br>3nm |
| V7 | SpMA1 :<br>F4T<br>(95%:5%)<br>10nm | SpMA1<br>65nm | SpMA2<br>10nm | IC2<br>5nm | BCP:D1<br>(95%:5%)<br>15nm | IC1<br>10nm | ST2<br>40nm | LiQ<br>3nm |
| V8 | ---<br>--- | --- | --- | SpMA1<br>90nm | CBP:D2<br>(95%:5%)<br>15μm | IC1<br>10nm | ST2<br>45nm | LiQ<br>3nm |
| V9 | --- | --- | --- | SpMA1<br>90nm | IC1:D2<br>(95%:5%)<br>15μm | IC1<br>10nm | ST2<br>45nm | LiQ<br>3nm |
| V10 | ---<br>--- | --- | ---<br>--- | SpMA1<br>90nm | IC6:D2<br>(95%:5%)<br>15μm | IC1<br>10nm | ST2<br>45nm | LiQ<br>3nm |
| V11 | --- | --- | --- | SpMA1<br>90nm | L1:D2<br>(95%:5%)<br>15μm | IC1<br>10nm | ST2<br>45nm | LiQ<br>3nm |
| E1* | HAT<br>5nm | --- | --- | SpA1<br>85nm | IC3:D1<br>(90%: 10%)<br>15μm | IC1<br>10nm | ST2:LiQ<br>(50%:50%)<br>40nm | --- |
| E2* | --- | --- | --- | SpA1<br>90nm | IC4:D1<br>(90%: 10%)<br>15μm | IC1<br>10nm | ST2:LiQ<br>(50%:50%)<br>40nm | --- |
| E3* | SpMA1:F4T<br>(95%:5%)<br>10nm | --- | --- | SpMA1<br>80nm | IC4:D1<br>(90%: 10%)<br>15μm | IC1<br>10nm | ST2:LiQ<br>(50%:50%)<br>40nm | --- |
| E4* | HAT<br>5nm | SpA1<br>70nm | HAT<br>5nm | SpMA1<br>20nm | IC1:D1<br>(90%: 10%) | IC1<br>10nm | ST2:LiQ<br>(50%:50%) | --- |

(fortgesetzt)

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| | | | | | 15μm | | 40nm | |
| E5 | HAT 5nm | SpA1 70nm | HAT 5nm | SpMA1 20nm | IC1:D1 (85%:15%) 15μm | IC1 10nm | ST2:LiQ (50%:50%) 40nm | --- |
| E6* | SpMA1 : F4T (95%:5%) 10nm | SpMA1 80nm | --- | SpMA2 10nm | IC1:D1 (90%: 10%) 15μm | IC1 10nm | ST2:LiQ (50%:50%) 40nm | --- |
| E7* | SpMA1:F4T (95%:5%) 10nm | SpMA1 65nm | IC2 10nm | CBP 5nm | IC1:D1 (90%: 10%) 15μm | IC1 10nm | ST2 40nm | LiQ 3nm |
| E8 | SpMA1:F4T (95%:5%) 10nm | SpMA1 65nm | IC2 10nm | CBP 5nm | IC1:D1 (85%:15%) 15μm | IC1 10nm | ST2 40nm | LiQ 3nm |
| E9* | SpMA1:F4T (95%:5%) 10nm | SpMA1 65nm | SpMA2 10nm | IC2 5nm | BCP:D1 (85%:15%) 15μm | IC1 10nm | ST2 40nm | LiQ 3nm |
| E10* | --- | --- | --- | SpMA1 90nm | CBP:D2 (90%: 10%) 15μm | IC1 10nm | ST2 45nm | LiQ 3nm |
| E11* | --- | --- | --- | SpMA1 90nm | IC1:D2 (90%:10%) 15μm | IC1 10nm | ST2 45nm | LiQ 3nm |
| E12* | --- | --- | --- | SpMA1 90nm | IC6:D2 (90%: 10%) 15μm | IC1 10nm | ST2 45nm | LiQ 3nm |
| E13* | --- | --- | --- | SpMA1 90nm | L1:D2 (90%: 10%) 15nm | IC1 10nm | ST2 45nm | LiQ 3nm |
| *Nicht erfindungsgemäß* | | | | | | | | |

Tabelle 2: Daten der OLEDs

| Bsp | U1000 (V) | SE1000 (cd/A) | LE1000 (lm/W) | EQE 1000 | CIE x/y bei 1000 $cd/m^2$ | Roll-Off | j0 | L1 % | LD (h) | PLQE % | $\lambda_{exc}$ nm | $t_d$ $\mu s$ | $t_a$ $\mu s$ |
|---|---|---|---|---|---|---|---|---|---|---|---|---|---|
| V1 | 4.0 | 42 | 33 | 12.5% | 0.32/0.60 | 0.72 | $10mA/cm^2$ | 80 | 82 | 77 | 350 | 7 | 7.0 |
| V2 | 5.7 | 21 | 12 | 6.5% | 0.29/0.59 | 0.61 | $10mA/cm^2$ | 80 | 33 | 84 | 359 | 6 | 4.3 |
| V3 | 4.0 | 46 | 36 | 14.0% | 0.28/0.60 | 0.61 | $10mA/cm^2$ | 80 | 38 | 84 | 359 | 6 | 4.3 |
| V4 | 36 | 65 | 56 | 20.8% | 0.25/0.58 | 0.72 | $10mA/cm^2$ | 80 | 44 | 92 | 350 | 7 | 5.4 |
| V5 | 3.3 | 67 | 64 | 21.1% | 0.26/0.59 | 0.70 | $10mA/cm^2$ | 80 | 52 | 92 | 350 | 7 | 5.4 |
| V6 | 3.2 | 68 | 66 | 21.3% | 0.26/0.58 | 0.73 | $10mA/cm^2$ | 80 | 38 | 92 | 350 | 7 | 5.4 |
| V7 | 6.6 | 5.3 | 2.5 | 1.7% | 0.25/0.56 | 0.58 | $10mA/cm^2$ | 80 | 1 | 59 | 350 | 6 | 5.9 |
| V8 | 8.1 | 20 | 7.6 | 6.7% | 0.49/0.49 | 0.64 | $10mA/cm^2$ | 80 | 14 | 43 | 350 | 6 | 5.1 |
| V9 | 53 | 27 | 16 | 9.6% | 0.51/0.48 | 0.80 | $10mA/cm^2$ | 80 | 69 | 41 | 350 | 7 | 4.6 |
| V10 | 8.1 | 14.4 | 5.6 | 5.8% | 0.52/0.46 | 0.77 | $10mA/cm^2$ | 80 | 68 | 37 | 350 | 6 | 5.3 |
| V11 | 5.8 | 20 | 10.8 | 7.8% | 0.52/0.47 | 0.76 | $10mA/cm^2$ | 80 | 165 | 46 | 368 | 7 | 4.3 |
| E1 | 3.9 | 51 | 42 | 15.7% | 0.29/0.59 | 0.70 | $10mA/cm^2$ | 80 | 68 | 74 | 350 | 6 | 6.2 |
| E2* | 5.4 | 22 | 13 | 6.6% | 0.30/0.60 | 0.79 | $10mA/cm^2$ | 80 | 83 | 77 | 360 | 6 | 4.5 |
| E3* | 3.9 | 53 | 43 | 15.8% | 0.29/0.60 | 0.66 | $10mA/cm^2$ | 80 | 69 | 77 | 360 | 6 | 4.5 |
| E4* | 36 | 67 | 58 | 20.2% | 0.29/0.60 | 0.73 | $10mA/cm^2$ | 80 | 83 | 87 | 350 | 7 | 4.9 |
| E5 | 36 | 59 | 51 | 17.5% | 0.31/0.60 | 0.76 | $10mA/cm^2$ | 80 | 102 | 81 | 350 | 7 | 4.8 |
| E6* | 3.3 | 74 | 70 | 22.0% | 0.30/0.60 | 0.72 | $10mA/cm^2$ | 80 | 63 | 87 | 350 | 7 | 4.9 |
| E7* | 3.2 | 74 | 73 | 22.4% | 0.29/0.60 | 0.74 | $10mA/cm^2$ | 80 | 44 | 87 | 350 | 7 | 4.9 |
| E8 | 3.1 | 72 | 72 | 21.1% | 0.32/0.60 | 0.75 | $10mA/cm^2$ | 80 | 49 | 81 | 350 | 7 | 4.8 |
| E9* | 4.9 | 9.8 | 6.3 | 2.9% | 0.31/0.60 | 0.72 | $10mA/cm^2$ | 80 | 1 | 90 | 350 | 7 | 6.3 |
| E10* | 8.1 | 14.6 | 5.7 | 6.3% | 0.54/0.45 | 0.71 | $10mA/cm^2$ | 80 | 25 | 35 | 350 | 5 | 4.9 |
| E11* | 5.9 | 16.2 | 8.6 | 7.3% | 0.55/0.44 | 0.80 | $10mA/cm^2$ | 80 | 95 | 33 | 350 | 6 | 6.2 |
| E12* | 80 | 12.7 | 5.0 | 5.7% | 0.54/0.44 | 0.80 | $10mA/cm^2$ | 80 | 76 | 29 | 350 | 6 | 5.0 |
| E13* | 6.4 | 14.5 | 7.2 | 6.5% | 0.55/0.44 | 0.78 | $10mA/cm^2$ | 80 | 210 | 37 | 370 | 7 | 4.6 |

**Nicht erfindungsgemäß*, E1 ist auch nicht erfindungsgemäß

Tabelle 3: Strukturformeln der Materialien für die OLEDs

| | |
|---|---|
| 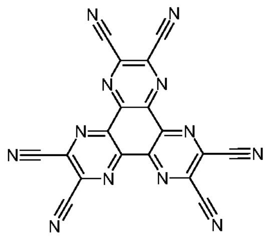 | 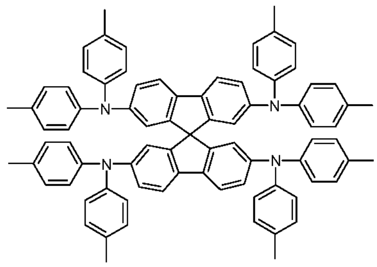 |
| HAT | SpA1 |
| 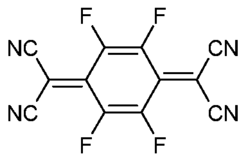 | 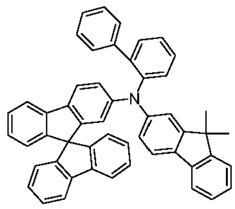 |
| F4T | SpMA1 |
| 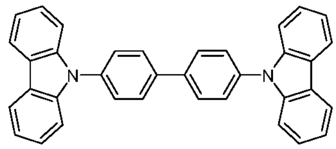 | 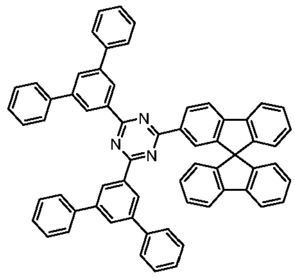 |
| CBP | ST2 |
| 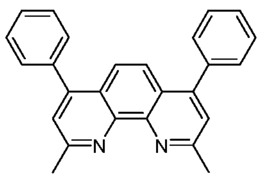 | 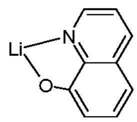 |
| BCP | LiQ |
| 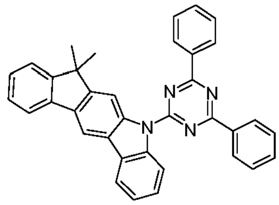 | 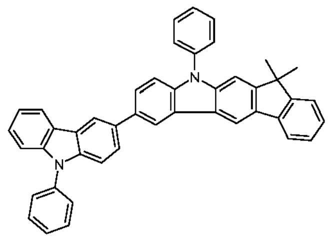 |
| IC1 | IC2 |

(fortgesetzt)

| | |
|---|---|
| 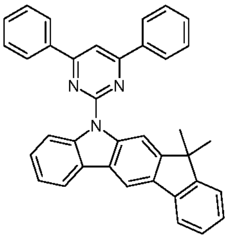 | 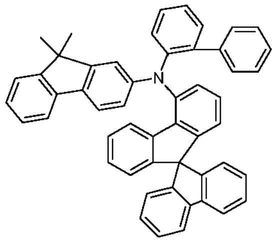 |
| IC3 | SpMA2 |
| 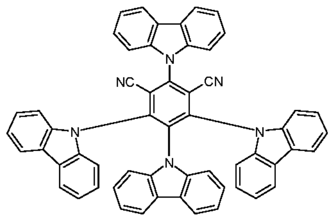 | 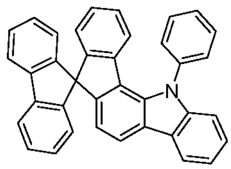 |
| D1 | IC4 |
| 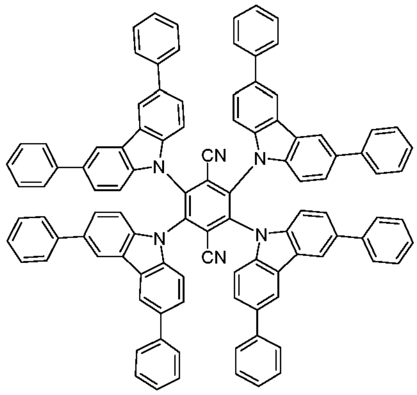 | 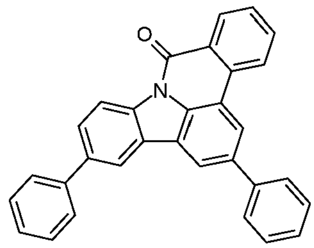 |
| D2 | L1 |
| 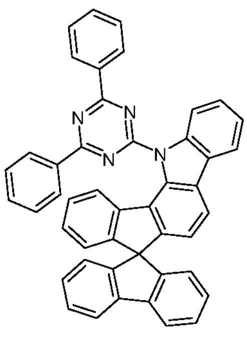 | |
| IC6 | |

Tabelle 4: HOMO, LUMO, $T_1$, $S_1$ der relevanten Materialien

| Material | Methode | HOMO (eV) | LUMO (eV) | $S_1$ (eV) | $T_1$(eV) |
|---|---|---|---|---|---|
| D1 | org. | -6.11 | -3.40 | 2.50 | 2.41 |
| D2 | orq. | -5.92 | -3.61 | 2.09 | 2.03 |
| CBP | org. | -5.67 | -2.38 | 3.59 | 3.11 |

(fortgesetzt)

| Material | Methode | HOMO (eV) | LUMO (eV) | $S_1$ (eV) | $T_1$(eV) |
|---|---|---|---|---|---|
| BCP | org. | -6.15 | -2.44 | 3.61 | 2.70 |
| IC1 | org. | -5.79 | -2.83 | 3.09 | 2.69 |
| IC3 | org. | -5.62 | -2.75 | 3.02 | 2.75 |
| IC4 | org. | -5.74 | -2.23 | 3.59 | 2.72 |
| SpA1 | org. | -4.87 | -2.14 | 2.94 | 2.34 |
| SpMA1 | org. | -5.25 | -2.18 | 3.34 | 2.58 |
| IC2 | org. | -5.40 | -2.11 | 3.24 | 2.80 |
| HAT | org. | -8.86 | -4.93 | | |
| F4T | org. | -7.91 | -5.21 | | |
| ST2 | org. | -6.03 | -2.82 | 3.32 | 2.68 |
| LiQ | M-orq. | -5.17 | -2.39 | 2.85 | 2.13 |
| L1 | org. | -6.09 | -2.80 | 2.70 | 3.46 |
| IC6 | org. | -5.87 | -2.85 | 2.72 | 3.14 |

## Patentansprüche

**1.** Organische Elektrolumineszenzvorrichtung, enthaltend Kathode, Anode und emittierende Schicht, die die folgenden Verbindungen enthält:

(A) eine Matrixverbindung; und
(B) eine lumineszente organische Verbindung, die keine Metalle enthält und die einen Abstand zwischen dem niedrigsten Triplettzustand $T_1$ und dem ersten angeregten Singulettzustand $S_1$ von $\leq$ 0.15 eV aufweist (TADF-Verbindung),

wobei die TADF-Verbindung in einer Dotierkonzentration von 10 bis 15 Vol.-% in der emittierenden Schicht vorliegt und wobei die Dotierkonzentration der TADF-Verbindung von 10 Vol.-% in der emittierenden Schicht ausgeschlossen ist, dadurch charakterisiert, dass die Matrixverbindung eine elektronentransportierende Verbindung ausgewählt aus den Stoffklassen der Triazine, der Pyrimidine, der Lactame, und der Chinoxaline

**2.** Organische Elektrolumineszenzvorrichtung nach Anspruch 1, **dadurch gekennzeichnet, dass** der Abstand zwischen $S_1$ und $T_1$ der TADF-Verbindung $\leq$ 0.10 eV, bevorzugt $\leq$ 0.08 eV und besonders bevorzugt $\leq$ 0 05 eV ist

**3.** Organische Elektrolumineszenzvorrichtung nach Anspruch 1 oder 2, **dadurch gekennzeichnet, dass** die TADF-Verbindung eine aromatische Verbindung ist. die sowohl Donor- wie auch Akzeptorsubstituenten aufweist

**4.** Organische Elektrolumineszenzvorrichtung nach einem oder mehreren der Ansprüche 1 bis 3, **dadurch gekennzeichnet, dass** für das LUMO der TADF-Verbindung LUMO(TADF) und das HOMO der Matrix HOMO(Matrix) gilt:

$$\text{LUMO(TADF)} - \text{HOMO(Matrix)} > S_1\text{(TADF)} - 0.4\ \text{eV},$$

wobei $S_1$(TADF) der erste angeregte Singulettzustand $S_1$ der TADF-Verbindung ist.

**5.** Organische Elektrolumineszenzvorrichtung nach einem oder mehreren der Ansprüche 1 bis 4, **dadurch gekennzeichnet, dass** die niedrigste Triplettenergie der Matrixverbindung maximal 0.1 eV niedriger ist als die Triplettenergie der TADF-Verbindung.

**6.** Verfahren zur Herstellung einer organischen Elektrolumineszenzvorrichtung nach einem oder mehreren der Ansprüche 1 bis 5, **dadurch gekennzeichnet, dass** mindestens eine Schicht mit einem Sublimationsverfahren aufgebracht wird und/oder dass mindestens eine Schicht mit einem Organic Vapour Phase Deposition Verfahren oder mit Hilfe einer Trägergassublimation aufgebracht wird und/oder dass mindestens eine Schicht aus Lösung, durch Spincoating oder mit einem Druckverfahren aufgebracht wird.

## Claims

**1.** Organic electroluminescent device comprising cathode, anode and emitting layer, which comprises the following compounds:

(A) a matrix compound; and
(B) a luminescent organic compound which contains no metals and which has a separation between the lowest triplet state $T_1$ and the first excited singlet state $S_1$ of $\leq 0.15$ eV (TADF compound),

where the TADF compound is present in the emitting layer in a doping concentration of 10 to 15% by vol. and where the doping concentration of the TADF compound of 10% by vol. in the emitting layer is excluded, **characterised in that** the matrix compound is an electron-transporting compound selected from the substance classes of the triazines, the pyrimidines, the lactams and the quinoxalines.

**2.** Organic electroluminescent device according to Claim 1, **characterised in that** the separation between $S_1$ and $T_1$ of the TADF compound is $\leq 0.10$ eV, preferably $\leq 0.08$ eV and particularly preferably $\leq 0.05$ eV.

**3.** Organic electroluminescent device according to Claim 1 or 2, **characterised in that** the TADF compound is an aromatic compound which has both donor and also acceptor substituents.

**4.** Organic electroluminescent device according to one or more of Claims 1 to 3, **characterised in that** the following applies to the LUMO of the TADF compound LUMO(TADF) and the HOMO of the matrix HOMO(matrix):

$$\text{LUMO(TADF)} - \text{HOMO(matrix)} > S_1\text{(TADF)} - 0.4\ \text{eV},$$

where $S_1$(TADF) is the first excited singlet state $S_1$ of the TADF compound.

**5.** Organic electroluminescent device according to one or more of Claims 1 to 4, **characterised in that** the lowest triplet energy of the matrix compound is a maximum of 0.1 eV lower than the triplet energy of the TADF compound.

**6.** Process for the production of an organic electroluminescent device according to one or more of Claims 1 to 5, **characterised in that** at least one layer is applied by means of a sublimation process and/or **in that** at least one layer is applied by means of an organic vapour phase deposition process or with the aid of carrier-gas sublimation and/or **in that** at least one layer is applied from solution, by spin coating or by means of a printing process.

## Revendications

**1.** Dispositif électroluminescent organique comprenant une cathode, une anode et une couche émettrice, qui comprend les composés suivants :

(A) un composé de matrice ; et
(B) un composé luminescent organique qui ne contient aucun métal et qui présente une séparation entre l'état de triplet le plus bas $T_1$ et le premier état de singulet excité $S_1$ de $\leq 0{,}15$ eV (composé TADF),

dans lequel le composé TADF est présent dans la couche émettrice selon une concentration de dopage allant de 10 à 15% en volume et où la concentration de dopage en composé TADF de 10% en volume dans la couche émettrice est exclue, **caractérisé en ce que** le composé de matrice est un composé de transport d'électrons choisi parmi les classes de substance formées par les triazines, les pyrimidines, les lactames et les quinoxalines.

**2.** Dispositif électroluminescent organique selon la revendication 1, **caractérisé en ce que** la séparation entre $S_1$ et

$T_1$ du composé TADF est ≤ 0,10 eV, préférablement ≤ 0,08 eV et particulièrement préférablement ≤ 0,05 eV.

**3.** Dispositif électroluminescent organique selon la revendication 1 ou 2, **caractérisé en ce que** le composé TADF est un composé aromatique qui possède des substituants donneurs mais aussi des substituants accepteurs.

**4.** Dispositif électroluminescent organique selon l'une ou plusieurs parmi les revendications 1 à 3, **caractérisé en ce que** ce qui suit s'applique à la LUMO du composé TADF LUMO(TADF) et à la HOMO de la matrice HOMO(matrice):

$$\text{LUMO(TADF)} - \text{HOMO(matrice)} > S_1\text{(TADF)} - 0{,}4\ \text{eV},$$

où $S_1$(TADF) est le premier état de singulet excité $S_1$ du composé TADF.

**5.** Dispositif électroluminescent organique selon l'une ou plusieurs parmi les revendications 1 à 4, **caractérisé en ce que** la plus basse énergie de triplet du composé de matrice est d'un maximum de 0,1 eV plus basse que l'énergie de triplet du composé TADF.

**6.** Procédé de production d'un dispositif électroluminescent organique selon l'une ou plusieurs parmi les revendications 1 à 5, **caractérisé en ce qu'**au moins une couche est appliquée au moyen d'un procédé de sublimation et/ou **en ce qu'**au moins une couche est appliquée au moyen d'un procédé de dépôt en phase vapeur organique ou à l'aide d'une sublimation dans un gaz porteur et/ou **en ce qu'**au moins une couche est appliquée à partir d'une solution, par dépôt par centrifugation ou au moyen d'un procédé d'impression.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- EP 2511360 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010054729 A
- WO 2010054730 A
- WO 2010015306 A
- EP 652273 A
- WO 2009062578 A
- US 20090136779 A
- WO 2010050778 A
- WO 2011042107 A
- WO 2011088877 A
- WO 2011116865 A
- WO 2011137951 A
- WO 2005003253 A
- EP 11010103
- WO 2011073149 A
- EP 1968131 A
- EP 2276085 A
- EP 2213662 A
- EP 1722602 A
- EP 2045848 A
- DE 102007031220
- US 8044390 B
- US 8057712 B
- WO 2009003455 A
- WO 2010094378 A
- WO 2011120709 A
- US 20100096600 A


### In der Beschreibung aufgeführte Nicht-Patentliteratur


- **M. A. BALDO et al.** *Appl. Phys. Lett.,* 1999, vol. 75, 4-6
- **B. H. UOYAMA et al.** *Nature,* 2012, vol. 492, 234
- **H. UOYAMA et al.** *Nature,* 2012, vol. 492, 234
- **ENDO et al.** *Appl. Phys. Lett.,* 2011, vol. 98, 083302
- **NAKAGAWA et al.** *Chem. Commun.,* 2012, vol. 48, 9580
- **LEE et al.** *Appl. Phys. Lett.,* 2012, vol. 101, 093306, , 1
- **MEHES et al.** *Angew. Chem. Int.,* 2012, vol. 51, 11311
- *Chem. Rev.,* 2007, vol. 107, 1233
- **B. M. S. ARNOLD et al.** *Appl. Phys. Lett.,* 2008, vol. 92, 053301
- **H. UOYAMA et al.** *Nature,* 2012, vol. 492 (7428), 234-238
- **K. MASUI et al.** *Organic Electronics,* 2013, vol. 14 (11), 2721-2726